# EUROPEAN PATENT APPLICATION

(11) **EP 0 898 311 A2**
(43) Date of publication of application: **24.02.1999**
(21) Application number: 98115611.0
(22) Date of filing: 19.08.1998
(51) Int. Cl.: H01L 23/48, H01L 23/498

(54) **Surface mounting type semiconductor package mounted on a multilayer mounting substrate**

(30) Priority: 20.08.1997 JP 223851/97
(71) Applicant: NEC CORPORATION, Tokyo (JP)
(72) Inventor: Imai, Yasuyuki, c/o NEC Corporation, Tokyo (JP)
(74) Representative: Patentanwälte Dipl.-Ing. R. Splanemann Dr. B. Reitzner Dipl.-Ing. K. Baronetzky

(57) **Abstract**

The present invention provides a semiconductor package including a semiconductor chip and having a mounting surface which is to be mounted onto a multilayer mounting substrate having multilevel interconnections, wherein the mounting surface has at least a level-varying region which varies in level so that the level-varying region decreases in level toward an interconnection leading-out edge of the semiconductor package, where at least a part of the multilevel interconnections of the mounting substrate extends from a mounting region of the multilayer mounting substrate to an outside region bounded from the mounting region through the interconnection leading-out edge of the semiconductor package, and wherein the level-varying region has a plurality of conductive pads to be connected to the at least a part of the multilevel interconnections so as to allow the at least a part of the multilevel interconnections to lead out of the mounting region to the outside region with keeping those individual levels respectively.

## Description

The present invention relates to a semiconductor device, and more particularly to a semiconductor package of a surface mounting type to be mounted on a multilayer mounting substrate.

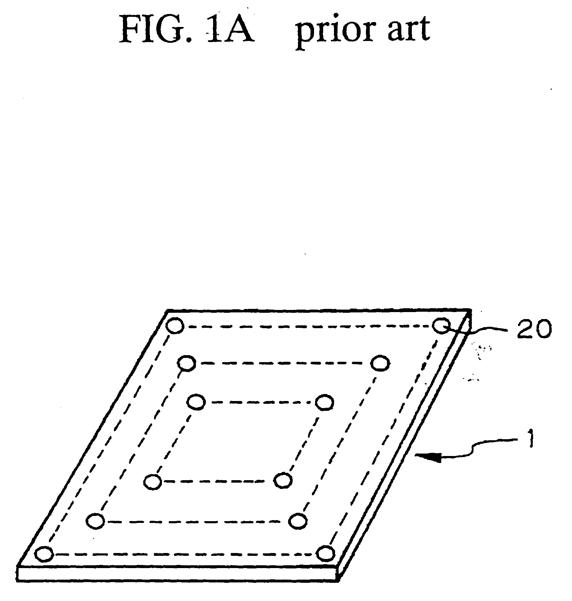

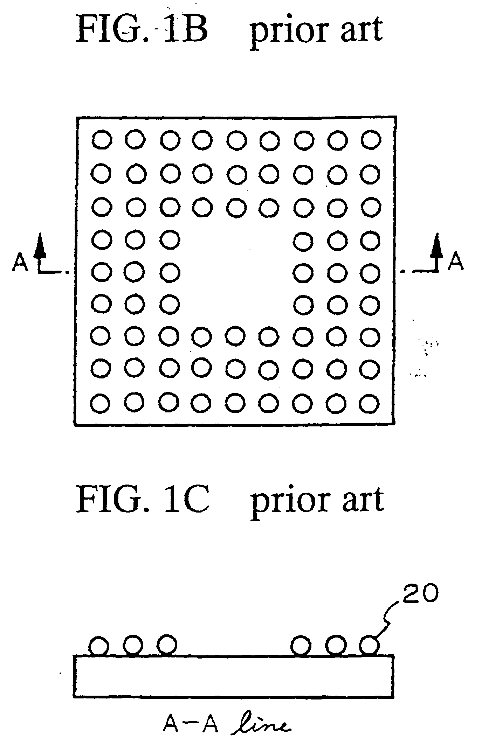

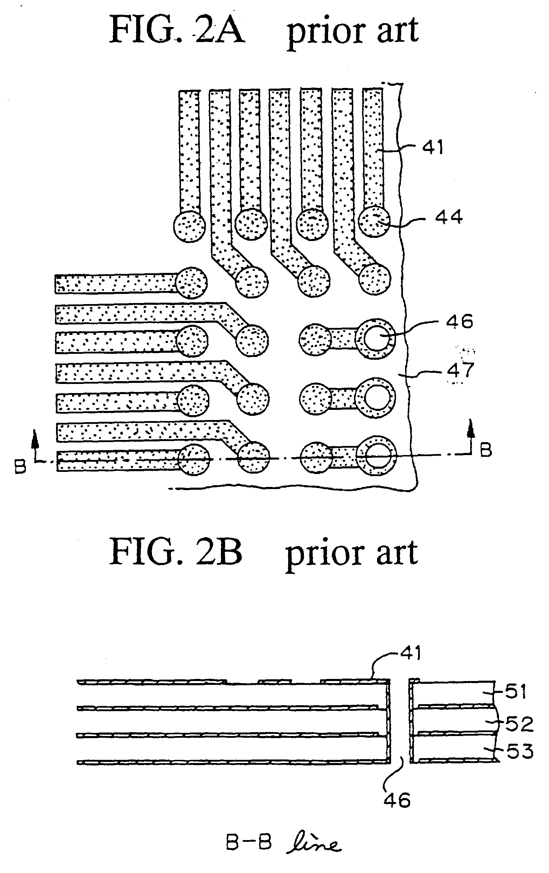

A surface mounting type semiconductor package so called as a ball grid array or a chip scale package has been known as one of the typical packaging types. FIG. 1A is a schematic perspective view illustrative of a conventional surface mounting type semiconductor package having a flat mounting surface on which solder balls or ball bumps are provided in a form of grid array. FIG. 1B is a plane view illustrative of a conventional surface mounting type semiconductor package having a flat mounting surface on which solder balls or ball bumps are provided in a form of grid array. FIG. 1C is a cross sectional elevation view illustrative of a conventional surface mounting type semiconductor package having a flat mounting surface on which solder balls are provided in a form of grid array taken along an A-A line of FIG. 1B. FIG. 2A is a fragmentary enlarged plane view illustrative of a conventional surface mounting type multilayer mounting substrate having a mounting surface on which electrically conductive pads and through holes are provided and interconnections extend from the electrically conductive pads. FIG. 2B is a fragmentary cross sectional elevation view illustrative of a multilayer structure of a conventional surface mounting type multilayer mounting substrate of FIG. 2A.

A conventional surface mounting type semiconductor package 1 has a flat mounting surface provided thereon with an array of solder balls or solder bumps 20. The conventional surface mounting type semiconductor package 1 is mounted on a surface mounting type multilayer mounting substrate 47 having a flat mounting surface on which conductive pads 44 are provided in a form of an array at corresponding positions to the solder balls 20 provided on the mounting surface of the conventional surface mounting type semiconductor device 1, so that the solder balls 20 are made into contact with the conductive pads 44. The mounting surface of the surface mounting type multilayer mounting substrate 47 is further provided thereon with interconnections 41 which extend from the conductive pads 44 and with through holes 46. The surface mounting type multilayer mounting substrate 47 comprises a three-layered structure, for example, laminations of a first layer 51 having the flat mounting surface, a second layer 52 underlying the first layer 51, and a third layer 53 underlying the second layer 52. Bach of the through holes 46 is formed to penetrate the first to third layers 51, 52 and 53. An inner wall of each of the through holes 46 is covered with an electrically conductive film which is not illustrated. The interconnections 41 have a multi-level interconnection structure, wherein the interconnections 41 extend on the flat mounting surface of the first layer 51 and a flat bottom surface of the third layer 53 as well as on a first interface between the first and second layers 51 and 52 and a second interface between the second and third layers 52 and 53.

The above interconnections 41 extend to outside of a semiconductor device mounting area on which the surface mounting type semiconductor package 1 is provided, whereby signals having appeared on terminals of the surface mounting type semiconductor package 1 are transmitted through the solder balls 11 ad the conductive pads 44 and further transmitted on the interconnections 41 to the outside regions which are positioned outside of the mounting area of the surface mounting type multilayer mounting substrate 47.

The most outer interconnections 41 are connected with the most outer conductive pads 44 which are connected through the solder balls 11 to the most outer terminals of the surface mounting type semiconductor package 1, wherein the most outer terminals are positioned adjacent to individual sides of the square-shaped surface mounting type semiconductor device 1. The most outer interconnections 41 may easily lead out of the mounting area of the surface mounting type multilayer mounting substrate 47.

In the meantime, the second and third outer interconnections 41 and the remaining inner interconnections 41 are connected with the second and third outer conductive pads 44 and the other inner conductive pads 44 respectively. The second and third outer conductive pads 44 and the other inner conductive pads 44 are further connected through the solder balls 11 to the second and third outer terminals and the other inner terminals of the surface mounting type semiconductor device 1, wherein the most outer terminals are positioned adjacent to individual sides of the square-shaped surface mounting type semiconductor package 1. The second and third outer interconnections 41 and the remaining inner interconnections 41 can not easily lead out of the mounting area of the surface mounting type multilayer mounting substrate 47, but could select any one or combinations of the following two possible ways.

The first possible way is to have the second and third outer interconnections 41 and the remaining inner interconnections 41 lead through between adjacent two of the most outside conductive pads 44 to the outside regions positioned outside of the mounting area on which the surface mounting type semiconductor package 1 is mounted.

The second way is to use the surface mounting type multilayer mounting substrate 47 as illustrated in FIGS. 2A and 2B so that the second and third outer interconnections 41 and the remaining inner interconnections 41 extending over the mounting surface of the first layer 51 as the top level interconnections are allowed to lead through the conductive film on the inner walls of the through holes 46 to the second top level interconnections between the first and second layers 51 and 52 or to the third top level interconnections between the second and third layers 52 and 53, otherwise to the lower level interconnections on the bottom surface of the third layer 53.

As the requirement for a substantive size down of the semiconductor package has been on the increase, it is required to narrow a distance between adjacent two of the solder balls provided in array on the mounting surface of the surface mounting type semiconductor package. It is also required to narrow a ball pitch or a distance between adjacent two of the conductive pads positioned in correspondence with the solder balls on the surface mounting type semiconductor package. The narrowing of the ball pitch or the distance between adjacent two of the conductive pads provides limitations on the possible number of and possible widths of the interconnections extending through between the adjacent two of the conductive pads.

If the top level interconnections are connected to the conductive films on the inner walls of the through holes to have the top level interconnections to lead to the second, third or bottom level interconnections, then since the number of the through holes is limited, the number of the top level interconnections which are allowed to lead to the second, third or bottom level interconnections through the holes are also limited. Namely, the other interconnections than the interconnection leading through the through hole are required to lead to avoid the formed through hole. Further, the second, third or remaining bottom level interconnections are also necessarily required to lead to avoid the through holes.

In addition, a size reduction of the semiconductor package is difficult for the above conventional surface mounting type semiconductor package in the light of keeping a minimum required freedom for allowing the interconnections to lead to the outside region positioned outside of the mounting area of the surface mounting type mounting substrate. A remarkable narrowing of the ball pitch or the distance between the adjacent two of the conductive pads makes it difficult to have the interconnections to lead through between the adjacent two of the conductive pads to the outside regions positioned outside of the mounting region of the surface mounting type mounting substrate. In order to increase the freedom of allowing the second or third top level or the remaining lower level interconnections to lead to avoid the through holes, it is, of course, effective to reduce the number of the through holes. In order to realize this reduction in the number of the through holes, it is also required to reduce the number of the inner terminals of the surface mounting type semiconductor package, wherein the inner terminals are positioned on inner regions of the surface mounting type semiconductor package and are surrounded by outer terminals positioned on a peripheral region of the surface mounting type semiconductor package. Namely, in accordance with the reduction in the number of the inner terminals of the surface mounting type semiconductor package, it is also required to reduce the number of the inner solder balls which are positioned on the inner region of the surface mounting type semiconductor package and are surrounded by the outer solder ball bumps positioned on the peripheral region of the surface mounting type semiconductor package. However, the reduction in the number of the inner terminals and the inner solder balls requires an addition of the outer solder balls and the outer terminals by the same number as the reduction number of the inner solder balls and the inter terminals. The addition of the outer solder balls and the outer terminals requires a substantive increase in area of the peripheral region of the surface mounting type semiconductor package. This means it necessary to increase an area of the surface mounting type semiconductor package. The increase in the area of the surface mounting type semiconductor package is opposed to the requirement for size down of the semiconductor package. The above full-grid array structure having an array distribution of the terminals over an entire region of the mounting surface of the surface mounting type semiconductor package seems necessary for satisfying the requirement for a possible reduction in size of the semiconductor package.

In the above circumstances, it had been required to develop a novel surface mounting type semiconductor package free from the above problem.

Accordingly, it is an object of the present invention to provide a novel surface mounting type semiconductor package free from the above problems.

It is a further object of the present invention to provide a novel surface mounting type semiconductor package allowing a substantive further reduction in size thereof.

It is a still further object of the present invention to provide a novel surface mounting type semiconductor package allowing a substantive reduction in weight thereof.

It is yet a further object of the present invention to provide a novel surface mounting type semiconductor package allowing a semiconductor device with a full-grid structure to be mounted on a mounting substrate.

It is a further more object of the present invention to provide a novel surface mounting type semiconductor package allowing a further reduction of a ball pitch or a distance between adjacent two of the solder bumps on the surface mounting type semiconductor device.

It is still more object of the present invention to provide a novel surface mounting type semiconductor package increasing a freedom of allowing multi-level interconnections to lead out of a mounting area of a mounting substrate to an outside region thereof positioned outside of the mounting area.

It is moreover object of the present invention to provide a novel surface mounting type semiconductor package free from a further limitation to multi-level interconnections to lead out of a mounting area of a mounting substrate to an outside region thereof positioned outside of the mounting area even a pitch between adjacent two of terminals of a surface mounting type semiconductor device is reduced to the minimum distance on design rule thereby to increase the number of the terminals and also thereby to reduce the area of the surface mounting type semiconductor device.

It is another object of the present invention to provide a novel surface mounting type semiconductor package allowing multi-level interconnections to lead out of a mounting area of a mounting substrate to an outside region thereof positioned outside of the mounting area without through holes which prevent lower level interconnections underlying top level interconnections from leading out of a mounting area of the surface mounting type multilayer mounting substrate.

The present invention provides a semiconductor package including a semiconductor chip and having a mounting surface which is to be mounted onto a multilayer mounting substrate having multilevel interconnections, wherein the mounting surface has at least a level-varying region which varies in level so that the level-varying region decreases in level toward an interconnection leading-out edge of the semiconductor package, where at least a part of the multilevel interconnections of the mounting substrate extends from a mounting region of the multilayer mounting substrate to an outside region bounded from the mounting region through the interconnection leading-out edge of the semiconductor package, and wherein the level-varying region has a plurality of conductive pads to be connected to the at least a part of the multilevel interconnections so as to allow the at least a part of the multilevel interconnections to lead out of the mounting region to the outside region with keeping those individual levels respectively.

The above and other objects, features and advantages of the present invention will be apparent from the following descriptions.

Preferred embodiments according to the present invention will be described in detail with reference to the accompanying drawings.
FIG. 1A is a schematic perspective view illustrative of a conventional surface mounting type semiconductor package having a flat mounting surface on which solder balls or ball bumps are provided in a form of grid array.
FIG. 1B is a plane view illustrative of a conventional surface mounting type semiconductor package having a flat mounting surface on which solder balls or ball bumps are provided in a form of grid array.
FIG. 1C is a cross sectional elevation view illustrative of a conventional surface mounting type semiconductor package having a flat mounting surface on which solder balls are provided in a form of grid array taken along an A-A line of FIG. 1B.
FIG. 2A is a fragmentary enlarged plane view illustrative of a conventional surface mounting type multilayer mounting substrate having a mounting surface on which electrically conductive pads and through holes are provided and interconnections extend from the electrically conductive pads.
FIG. 2B is a fragmentary cross sectional elevation view illustrative of a multilayer structure of a conventional surface mounting type multilayer mounting substrate of FIG. 2A.
FIG. 3A is a schematic perspective view illustrative of a novel surface mounting type semiconductor package with an improved mounting surface in a first embodiment in accordance with the present invention.
FIG. 3B is a schematic plane view illustrative of a novel surface mounting type semiconductor package with an improved mounting surface of FIG. 3A in a first embodiment in accordance with the present invention.
FIG. 3C is a schematic cross sectional elevation view illustrative of a novel surface mounting type semiconductor package with an improved mounting surface taken along an A-A line of FIG. 3B in a first embodiment in accordance with the present invention.
FIG. 4 is a cross sectional elevation view illustrative of a novel surface mounting type semiconductor package with an improved mounting surface taken along an A-A line of FIG. 3C in a first embodiment in accordance with the present invention.
FIG. 5A is a fragmentary enlarged plane view illustrative of a multilayer mounting substrate onto which a novel surface mounting type semiconductor package with an improved mounting surface is mounted in accordance with the present invention.
FIG. 5B is a fragmentary enlarged cross sectional elevation view illustrative of a multilayer mounting substrate of FIG. 5A.
FIG. 6 is a schematic perspective view illustrative of a novel surface mounting type semiconductor package with an improved mounting surface to be mounted onto a multilayer mounting substrate in a first embodiment in accordance with the present invention.
FIG. 7A is a schematic perspective view illustrative of a novel surface mounting type semiconductor package with an improved mounting surface in a second embodiment in accordance with the present invention.
FIG. 7B is a schematic plane view illustrative of a novel surface mounting type semiconductor package with an improved mounting surface of FIG. 7A in a second embodiment in accordance with the present invention.
FIG. 7C is a schematic cross sectional elevation view illustrative of a novel surface mounting type semiconductor package with an improved mounting surface taken along an A-A line of FIG. 7B in a second embodiment in accordance with the present invention.
FIG. 7D is a fragmentary enlarged plane view illustrative of dual alignments of conductive pads on each stage of an improved mounting surface of a novel surface mounting type semiconductor package of FIG. 7A in a second embodiment in accordance with the present invention.
FIG. 8A is a schematic perspective view illustrative of a novel surface mounting type semiconductor package with an improved mounting surface in a third embodiment in accordance with the present invention.
FIG. 8B is a schematic plane view illustrative of a novel surface mounting type semiconductor package with an improved mounting surface of FIG. 8A in a third embodiment in accordance with the present invention.
FIG. 8C is a schematic cross sectional elevation view illustrative of a novel surface mounting type semiconductor package with an improved mounting surface taken along an A-A line of FIG. 8B in a third embodiment in accordance with the present invention.
FIG. 9A is a schematic perspective view illustrative of a novel surface mounting type semiconductor package with an improved mounting surface in a fourth embodiment in accordance with the present invention.
FIG. 9B is a schematic plane view illustrative of a novel surface mounting type semiconductor package with an improved mounting surface of FIG. 9A in a fourth embodiment in accordance with the present invention.
FIG. 9C is a schematic cross sectional elevation view illustrative of a novel surface mounting type semiconductor package with an improved mounting surface taken along an A-A line of FIG. 9B in a fourth embodiment in accordance with the present invention.
FIG. 10A is a schematic perspective view illustrative of a novel surface mounting type semiconductor package with an improved mounting surface in a fifth embodiment in accordance with the present invention.
FIG. 10B is a schematic plane view illustrative of a novel surface mounting type semiconductor package with an improved mounting surface of FIG. 10A in a fifth embodiment in accordance with the present invention.
FIG. 10C is a schematic cross sectional elevation view illustrative of a novel surface mounting type semiconductor package with an improved mounting surface taken along an A-A line of FIG. 10B in a fifth embodiment in accordance with the present invention.
FIG. 10D is a schematic cross sectional elevation view illustrative of a novel surface mounting type semiconductor package with an improved mounting surface taken along a B-B line of FIG. 10B in a fifth embodiment in accordance with the present invention.
FIG. 11A is a schematic perspective view illustrative of a novel surface mounting type semiconductor package with an improved mounting surface in a sixth embodiment in accordance with the present invention.
FIG. 11B is a schematic plane view illustrative of a novel surface mounting type semiconductor package with an improved mounting surface of FIG. 11A in a sixth embodiment in accordance with the present invention.
FIG. 11C is a schematic cross sectional elevation view illustrative of a novel surface mounting type semiconductor package with an improved mounting surface taken along an A-A line of FIG. 11B in a sixth embodiment in accordance with the present invention.
FIG. 11D is a schematic cross sectional elevation view illustrative of a novel surface mounting type semiconductor package with an improved mounting surface taken along a B-B line of FIG. 11B in a sixth embodiment in accordance with the present invention.
FIG. 12A is a schematic perspective view illustrative of a novel surface mounting type semiconductor package with an improved mounting surface in a seventh embodiment in accordance with the present invention.
FIG. 12B is a schematic plane view illustrative of a novel surface mounting type semiconductor package with an improved mounting surface of FIG. 12A in a seventh embodiment in accordance with the present invention.
FIG. 12C is a schematic cross sectional elevation view illustrative of a novel surface mounting type semiconductor package with an improved mounting surface taken along an A-A line of FIG. 12B in a seventh embodiment in accordance with the present invention.
FIG. 12D is a schematic cross sectional elevation view illustrative of a novel surface mounting type semiconductor package with an improved mounting surface taken along a B-B line of FIG. 12B in a seventh embodiment in accordance with the present invention.
FIG. 13A is a schematic perspective view illustrative of a novel surface mounting type semiconductor package with an improved mounting surface in an eighth embodiment in accordance with the present invention.
FIG. 13B is a schematic plane view illustrative of a novel surface mounting type semiconductor package with an improved mounting surface of FIG. 13A in an eighth embodiment in accordance with the present invention.
FIG. 13C is a schematic cross sectional elevation view illustrative of a novel surface mounting type semiconductor package with an improved mounting surface taken along an A-A line of FIG. 13B in an eighth embodiment in accordance with the present invention.
FIG. 14A is a schematic perspective view illustrative of a novel surface mounting type semiconductor package with an improved mounting surface in a ninth embodiment in accordance with the present invention.
FIG. 14B is a schematic plane view illustrative of a novel surface mounting type semiconductor package with an improved mounting surface of FIG. 14A in a ninth embodiment in accordance with the present invention.
FIG. 14C is a schematic cross sectional elevation view illustrative of a novel surface mounting type semiconductor package with an improved mounting surface taken along an A-A line of FIG. 14B in a ninth embodiment in accordance with the present invention.
FIG. 14D is a schematic cross sectional elevation view illustrative of a novel surface mounting type semiconductor package with an improved mounting surface taken along a C-C line of FIG. 14B in a ninth embodiment in accordance with the present invention.
FIG. 14E is a schematic cross sectional elevation view illustrative of a novel surface mounting type semiconductor package with an improved mounting surface taken along a D-D line of FIG. 14B in a ninth embodiment in accordance with the present invention.
FIG. 15A is a schematic perspective view illustrative of a novel surface mounting type semiconductor package with an improved mounting surface in a tenth embodiment in accordance with the present invention.
FIG. 15B is a schematic plane view illustrative of a novel surface mounting type semiconductor package with an improved mounting surface of FIG. 15A in a tenth embodiment in accordance with the present invention.
FIG. 15C is a schematic cross sectional elevation view illustrative of a novel surface mounting type semiconductor package with an improved mounting surface taken along an A-A line of FIG. 15B in a tenth embodiment in accordance with the present invention.
FIG. 15D is a schematic cross sectional elevation view illustrative of a novel surface mounting type semiconductor package with an improved mounting surface taken along a C-C line of FIG. 15B in a tenth embodiment in accordance with the present invention.

The present invention provides a semiconductor package including a semiconductor chip and having a mounting surface which is to be mounted onto a multilayer mounting substrate having multilevel interconnections, wherein the mounting surface has at least a level-varying region which varies in level so that the level-varying region decreases in level toward an interconnection leading-out edge of the semiconductor package, where at least a part of the multilevel interconnections of the mounting substrate extends from a mounting region of the multilayer mounting substrate to an outside region bounded from the mounting region through the interconnection leading-out edge of the semiconductor package, and wherein the level-varying region has a plurality of conductive pads to be connected to the at least a part of the multilevel interconnections so as to allow the at least a part of the multilevel interconnections to lead out of the mounting region to the outside region with keeping those individual levels respectively.

The above first present invention provides the following three effects. The above improved mounting surface increases a freedom of allowing the multi-level interconnections to lead out of the mounting area of the multilayer mounting substrate to the outside region thereof positioned outside of the mounting area. Namely, the above novel surface mounting type semiconductor package is free from a substantive limitation to the multi-level interconnections to lead out of the mounting area of the multilayer mounting substrate to the outside region thereof positioned outside of the mounting area even a pitch between adjacent two of terminals of the surface mounting type semiconductor package is reduced to the minimum distance on design rule thereby to increase the number of the terminals and also thereby to reduce the area of the surface mounting type semiconductor package. The novel surface mounting type semiconductor package allows the multi-level interconnections to lead out of the mounting area of the multilayer mounting substrate to the outside region thereof positioned outside of the mounting area without through-holes which may prevent lower level interconnections underlying top level interconnections from leading out of the mounting area of the surface mounting type multilayer mounting substrate.

Further, the above novel surface mounting type semiconductor package allows a substantive further reduction in size thereof. As described above, there is no need to have the multilevel interconnections to lead through between adjacent two of the conductive pads, thereby allowing a further reduction of a pitch or a distance between adjacent two of the conductive pads on the mounting surface of the surface mounting type semiconductor package. This further reduction of the pitch or the distance between adjacent two of the conductive pads results in a further reduction in area of the surface mounting type semiconductor package.

Furthermore, the above novel surface mounting type semiconductor package allows a substantive increase in the number of the conductive pads or the terminals of the semiconductor package because there is reduced the limitation to have the multilevel interconnections to lead out of the mounting region to the outside region as well as the pitch or the distance of the adjacent two of the conductive pads is narrowed. It is possible to form the full-grid structure of the conductive pads.

The conductive pads may be provided with or without solder balls.

The steps as the above difference in level of the semiconductor package may be formed by laminations of plural plastic layers having different sizes from each other, wherein the top plastic layer has a smallest size in plane view and the bottom plastic layer has a largest size in plane view.

The steps as the above difference in level of the semiconductor package may also be formed by laminations of plural plastic layers having the same size in plane view and subsequent selective etching to form the steps.

The steps as the above difference in level of the semiconductor package may also be formed by molding a ceramic package with use of dies which have the same shapes as the steps.

The steps as the above difference in level of the semiconductor package may also be formed by molding a ceramic package with use of dies to form a step-free ceramic substrate for subsequent selective mechanical-cutting or mechanical-polishing of the step-free ceramic substrate to form the steps.

The slopes as the above difference in level of the semiconductor package may also be formed by molding a ceramic package with use of dies which have the same shapes as the slopes.

The slopes as the above difference in level of the semiconductor package may also be formed by molding a ceramic package with use of dies to form a slope-free ceramic substrate for subsequent selective mechanical-cutting or mechanical-polishing of the slope-free ceramic substrate to form the slopes.

It is also preferable that the level-varying region discontinuously varies in level so that the mounting surface includes at least a higher level region and at least a lower level region, and so that the at least a lower level region is positioned closer to an interconnection leading-out side of the semiconductor package than the higher level region, where the at least a part of the multilevel interconnections of the mounting substrate extends from the mounting region of the multilayer mounting substrate to the outside region through the interconnection leading-out-side of the semiconductor package, and wherein the higher level region has a plurality of first conductive pads to be connected to first level interconnections of the multilevel interconnections and the lower region has a plurality of second conductive pads to be connected to second level interconnections of the multilevel interconnections so as to allow the first level and second level interconnections to lead out of the mounting region to the outside region with keeping those first and second levels respectively.

It is also preferable that the level-varying region has at least a step which provides a boundary line bounding the higher level region and the lower level region, and the step has substantially vertical walls which face toward the interconnection leading-out-side of the semiconductor package.

It is also preferable that the at least a step provides a boundary line surrounding an inner region so that the higher level region is positioned on an inner region of the semiconductor package whilst the lower level region is positioned on a peripheral region whereby the lower level region surrounds the higher level region.

It is also preferable that each of the higher level and lower level regions has at least a single alignment of the conductive pads to surround the inner region.

It is also preferable that each of the higher level and lower level regions has a set of inner and outer alignments of the conductive pads to surround the inner region, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that a plurality of the steps extend to provide multiple boundary lines co-surrounding the inner region so that a highest level region is positioned on the inner region of the semiconductor package whilst at least an intermediate level region is positioned to surround the highest level region and a lowest level region is positioned on a peripheral region to surround the at least an intermediate level region, and wherein each of the highest level, intermediate level and lowest level regions has at least a single alignment of the conductive pads to surround the inner region.

It is also preferable that each of the higher level, intermediate level and lower level regions has a set of inner and outer alignments of the conductive pads to surround the inner region, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that the inner region surrounded by the boundary line provided by the at least a step is centrically positioned to a center of the semiconductor package.

It is also preferable that the inner region surrounded by the boundary line provided by the at least a step is eccentrically positioned from a center of the semiconductor package.

It is also preferable that the inner region surrounded by the boundary line provided by the at least a step is square-shaped.

It is also preferable that the boundary line provided by the at least a step surrounds the inner region omnidirectionally so that the higher level region is positioned on the inner region of the semiconductor package whilst the lower level region is positioned on a peripheral region whereby the lower level region surrounds the higher level region omnidirectionally.

It is also preferable that the boundary line provided by the at least a step surrounds the inner region three-directionally so that the higher level region is positioned on the inner region of the semiconductor package whilst the lower level region is positioned on a peripheral region except along one side of the semiconductor package whereby the lower level region surrounds the higher level region three-directionally.

It is also preferable that the mounting surface has at least two steps which provide at least two straight boundary lines bounding at least one of the higher level region and at least two of the lower level region, and each of the two step has a substantially vertical wall which faces toward opposite two sides of the semiconductor package, so that the at least two of the lower level region are respectively adjacent to the opposite two sides of the semiconductor package and the at least one of the higher level region is sandwiched between the at least two of the lower level region.

It is also preferable that the mounting surface has at least a slope which provides a boundary region between the higher level region and the lower level region, and the slope has a substantially vertical wall which face toward the interconnection leading-out-side of the semiconductor package.

It is also preferable that the at least a slope provides a boundary region surrounding an inner region so that the higher level region is positioned on an inner region of the semiconductor package whilst the lower level region is positioned on a peripheral region whereby the lower level region surrounds the higher level region.

It is also preferable that each of the higher level and lower level regions has at least a single alignment of the conductive pads to surround the inner region.

It is also preferable that each of the higher level and lower level regions has a set of inner and outer alignments of the conductive pads to surround the inner region, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that a plurality of the slopes extend to provide multiple boundary regions co-surrounding the inner region so that a highest level region is positioned on the inner region of the semiconductor package whilst at least an intermediate level region is positioned to surround the highest level region and a lowest level region is positioned on a peripheral region to surround the at least an intermediate level region, and wherein each of the highest level, intermediate level and lowest level regions has at least a single alignment of the conductive pads to surround the inner region.

It is also preferable that each of the higher level, intermediate level and lower level regions has a set of inner and outer alignments of the conductive pads to surround the inner region, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that the inner region surrounded by the boundary region provided by the at least a slope is centrically positioned to a center of the semiconductor package.

It is also preferable that the inner region surrounded by the boundary region provided by the at least a slope is eccentrically positioned from a center of the semiconductor package.

It is also preferable that the inner region surrounded by the boundary region provided by the at least a slope is square-shaped.

It is also preferable that the boundary region provided by the at least a slope surrounds the inner region omnidirectionally so that the higher level region is positioned on the inner region of the semiconductor package whilst the lower level region is positioned on a peripheral region whereby the lower level region surrounds the higher level region omnidirectionally.

It is also preferable that the boundary region provided by the at least a slope surrounds the inner region three-directionally so that the higher level region is positioned on the inner region of the semiconductor package whilst the lower level region is positioned on a peripheral region except along one side of the semiconductor package whereby the lower level region surrounds the higher level region three-directionally.

It is also preferable that the mounting surface has at least two slopes which provide at least two straight boundary regions bounding at least one of the higher level region and at least two of the lower level region, and each of the two slope has a substantially vertical wall which faces toward opposite two sides of the semiconductor package, so that the at least two of the lower level region are respectively adjacent to the opposite two sides of the semiconductor package and the at least one of the higher level region is sandwiched between the at least two of the lower level region.

It is also preferable that the level-varying region discontinuously varies in level so that the mounting surface includes at least a higher level region and at least a lower level region, and so that the at least a lower level region is positioned closer to a corner of the semiconductor package than the higher level region, where the at least a part of the multilevel interconnections of the mounting substrate extends from the mounting region of the multilayer mounting substrate to the outside region through a region in the vicinity of the corner of the semiconductor package, and wherein the higher level region has a plurality of first conductive pads to be connected to first level interconnections of the multilevel interconnections and the lower region has a plurality of second conductive pads to be connected to second level interconnections of the multilevel interconnections so as to allow the first level and second level interconnections to lead out of the mounting region to the outside region with keeping those first and second levels respectively.

It is also preferable that the level-varying region has at least a step which provides a L-shaped boundary line bounding the higher level region and the lower level region, and wherein the L-shaped boundary line surrounds a corner region adjacent to the corner so that the lower level region is positioned on the corner region, and the step has substantially vertical walls which face toward adjacent two sides sandwiching the corner of the semiconductor package.

It is also preferable that the level-varying region has four sets of at least a step which provide four sets of at least a L-shaped boundary line bounding the higher level region and four lower level regions, and wherein the four L-shaped boundary lines surround four corner regions adjacent to four corners respectively so that the four lower level regions are positioned on the four corner regions respectively, and each of the four steps has substantially vertical walls which face toward adjacent two sides sandwiching corresponding one of the four corners of the semiconductor package.

It is also preferable that the level-varying region has four sets of plural steps which provide four sets of multiple L-shaped boundary lines bounding a highest level region, four sets of at least an intermediate level region and four sets of a lowest level region respectively, and wherein each set of the multiple L-shaped boundary lines co-surround each of the four corner regions so that the four lowest level regions are positioned on the four corner regions respectively, and each of the at least an intermediate level region surrounds corresponding one of the four lowest level regions in two directions perpendicular to each other, and the highest level region surround each of the four sets of the at least an intermediate level region in the two directions, and wherein each of the steps has substantially vertical walls which face toward adjacent two sides sandwiching corresponding one of the four corners of the semiconductor package.

It is also preferable that each of the at least an intermediate level region has at least a single alignment of the conductive pads to surround the lowest level region in the two directions perpendicular to each other.

It is also preferable that each of the at least an intermediate level region has a set of inner and outer alignments of the conductive pads to co-surround the lowest level region in the two directions perpendicular to each other, where the outer alignment is positioned closer to the lowest level region than the inner alignment, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that the level-varying region has at least a step which provides a straight boundary line bounding the higher level region and the lower level region, and wherein the straight boundary line extends between two sides sandwiching the corner, and the straight boundary line bounds a corner region adjacent to the corner in a diagonal direction of the semiconductor package so that the lower level region is positioned on the corner region, and the step has a substantially vertical wall which faces toward the corner of the semiconductor package.

It is also preferable that the level-varying region has four sets of at least a step which provide four sets of at least a straight boundary line bounding the higher level region and four lower level regions, and wherein the four straight boundary lines bound in the diagonal directions four corner regions adjacent to four corners respectively, so that the four lower level regions are positioned on the four corner regions respectively, and each of the four steps has a substantially vertical wall which faces toward corresponding one of the four corners of the semiconductor package.

It is also preferable that the level-varying region has four sets of plural steps which provide four sets of multiple straight boundary lines bounding a highest level region, four sets of at least an intermediate level region and four sets of a lowest level region respectively, and wherein each set of the multiple straight boundary lines multiple-bound each of the four corner regions, so that the four lowest level regions are positioned on the four corner regions respectively, and each of the at least an intermediate level region bounds the highest level region and each of the four lowest level regions in the diagonal directions of the semiconductor package, and wherein each of the steps has a substantially vertical wall which faces toward corresponding one of the four corners of the semiconductor package.

It is also preferable that each of the at least an intermediate level region has at least a single alignment of the conductive pads to bound the lowest level region in the diagonal direction.

It is also preferable that each of the at least an intermediate level region has a set of inner and outer alignments of the conductive pads to co-bound the lowest level region in the diagonal direction, where the outer alignment is positioned closer to the lowest level region than the inner alignment, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that the level-varying region has at least a slope which provides a L-shaped boundary region bounding the higher level region and the lower level region, and wherein the L-shaped boundary region surrounds a corner region adjacent to the corner so that the lower level region is positioned on the corner region, and the slope faces toward adjacent two sides sandwiching the corner of the semiconductor package.

It is also preferable that the level-varying region has four sets of at least a slope which provide four sets of at least a L-shaped boundary region bounding the higher level region and four lower level regions, and wherein the four L-shaped boundary regions surround four corner regions adjacent to four corners respectively so that the four lower level regions are positioned on the four corner regions respectively, and each of the four slopes has substantially vertical walls which face toward adjacent two sides sandwiching corresponding one of the four corners of the semiconductor package.

It is also preferable that the level-varying region has four sets of plural slopes which provide four sets of multiple L-shaped boundary regions bounding a highest level region, four sets of at least an intermediate level region and four sets of a lowest level region respectively, and wherein each set of the multiple L-shaped boundary regions co-surround each of the four corner regions so that the four lowest level regions are positioned on the four corner regions respectively, and each of the at least an intermediate level region surrounds corresponding one of the four lowest level regions in two directions perpendicular to each other, and the highest level region surround each of the four sets of the at least an intermediate level region in the two directions, and wherein the slopes has substantially vertical walls which face toward adjacent two sides sandwiching corresponding one of the four corners of the semiconductor package.

It is also preferable that each of the at least an intermediate level region has at least a single alignment of the conductive pads to surround the lowest level region in the two directions perpendicular to each other.

It is also preferable that each of the at least an intermediate level region has a set of inner and outer alignments of the conductive pads to co-surround the lowest level region in the two directions perpendicular to each other, where the outer alignment is positioned closer to the lowest level region than the inner alignment, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that the level-varying region has at least a slope which provides a straight boundary region bounding the higher level region and the lower level region, and wherein the straight boundary region extends between two sides sandwiching the corner, and the straight boundary region bounds a corner region adjacent to the corner in a diagonal direction of the semiconductor package so that the lower level region is positioned on the corner region, and the slope faces toward the corner of the semiconductor package.

It is also preferable that the level-varying region has four sets of at least a slope which provide four sets of at least a straight boundary region bounding the higher level region and four lower level regions, and wherein the four straight boundary regions bound in the diagonal directions four corner regions adjacent to four corners respectively, so that the four lower level regions are positioned on the four corner regions respectively, and each of the four slopes has a substantially vertical wall which faces toward corresponding one of the four corners of the semiconductor package.

It is also preferable that the level-varying region has four sets of plural slopes which provide four sets of multiple straight boundary regions bounding a highest level region, four sets of at least an intermediate level region and four sets of a lowest level region respectively, and wherein each set of the multiple straight boundary regions multiple-bound each of the four corner regions, so that the four lowest level regions are positioned on the four corner regions respectively, and each of the at least an intermediate level region bounds the highest level region and each of the four lowest level regions in the diagonal directions of the semiconductor package, and wherein each of the slopes has a substantially vertical wall which faces toward corresponding one of the four corners of the semiconductor package.

It is also preferable that each of the at least an intermediate level region has at least a single alignment of the conductive pads to bound the lowest level region in the diagonal direction.

It is also preferable that each of the at least an intermediate level region has a set of inner and outer alignments of the conductive pads to co-bound the lowest level region in the diagonal direction, where the outer alignment is positioned closer to the lowest level region than the inner alignment, provided that the conductive pads on the inner alignment are positioned to be displaced from the conductive pads on the outer alignment so that each of the interconnections connected to the conductive pads on the inner alignment is permitted to lead through between adjacent two of the conductive pads on the outer alignment.

It is also preferable that the level-varying region continuously varies in level so that the level-varying region comprises a sloped region decreasing in level toward an interconnection leading-out side of the semiconductor package, where at least a part of the multilevel interconnections of the mounting substrate extends from a mounting region of the multilayer mounting substrate to an outside region bounded from the mounting region through the interconnection leading-out side of the semiconductor package, and wherein the sloped region has a plurality of conductive pads at plural different levels on the sloped region, and the conductive pads are to be connected to the at least a part of the multilevel interconnections, so as to allow the at least a part of the multilevel interconnections to lead out of the mounting region to the outside region with keeping those individual levels respectively.

It is also preferable that the level-varying region comprises four sloped regions decreasing in level toward four sides of the semiconductor package, where the multilevel interconnections of the mounting substrate extend from the mounting region of the multilayer mounting substrate to the outside region surrounding the mounting region through the four sides of the semiconductor package.

It is also preferable that each of the four sloped regions has a plurality of alignments of the conductive pads which extend in parallel to each of the four sides of the semiconductor package so that the plurality of alignments are different in level from each other, as to allow the at least a part of the multilevel interconnections to lead out of the mounting region to the outside region with keeping those individual levels respectively.

It is also preferable that the level-varying region continuously varies in level so that the level-varying region comprises a sloped region decreasing in level toward an interconnection leading-out corner of the semiconductor package, where at least a part of the multilevel interconnections of the mounting substrate extends from a mounting region of the multilayer mounting substrate to an outside region bounded from the mounting region through a region in the vicinity of the interconnection leading-out corner of the semiconductor package, and wherein the sloped region has a plurality of conductive pads at plural different levels on the sloped region, and the conductive pads are to be connected to the at least a part of the multilevel interconnections, so as to allow the at least a part of the multilevel interconnections to lead out of the mounting region to the outside region with keeping those individual levels respectively.

It is also preferable that the level-varying region comprises four sloped regions decreasing in level toward four corners of the semiconductor package, where the multilevel interconnections of the mounting substrate extend from the mounting region of the multilayer mounting substrate to the outside region surrounding the mounting region through the four corners of the semiconductor package.

It is also preferable that each of the four sloped regions has a plurality of alignments of the conductive pads which extend in parallel to diagonal directions of the semiconductor package so that the plurality of alignments are different in level from each other, as to allow the multilevel interconnections to lead out of the mounting region to the outside region with keeping those individual levels respectively.

### FIRST EMBODIMENT:

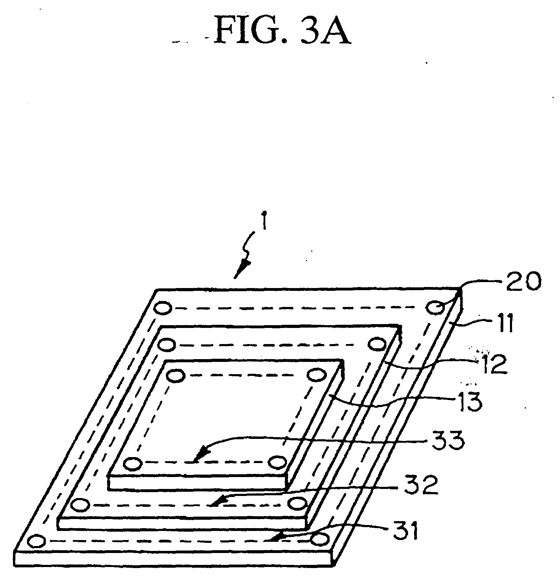

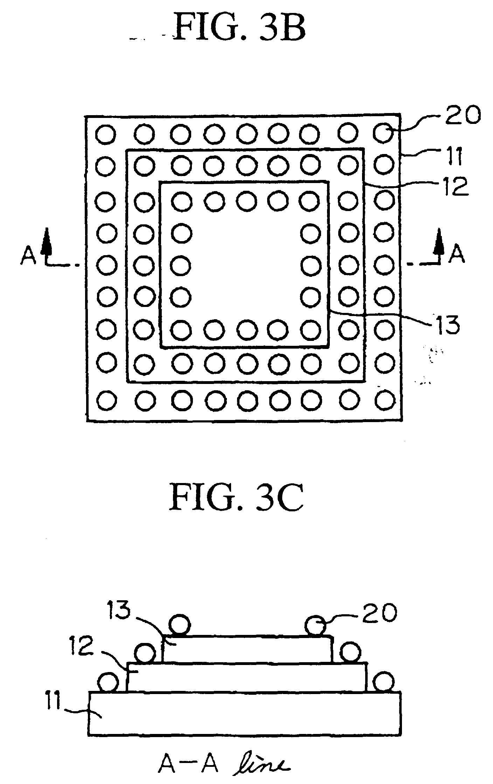

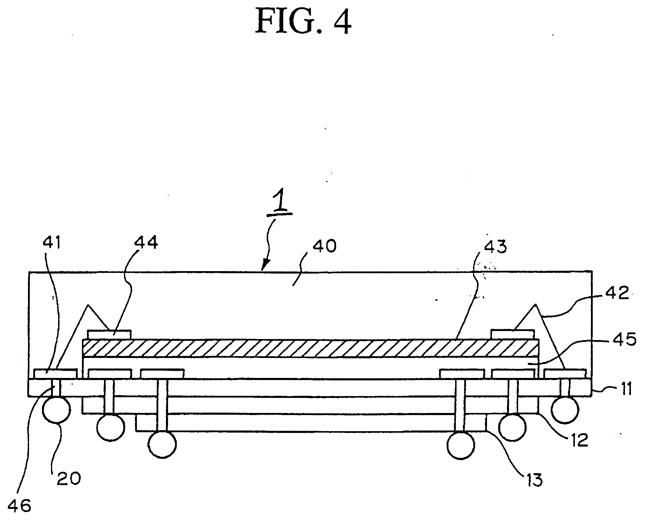

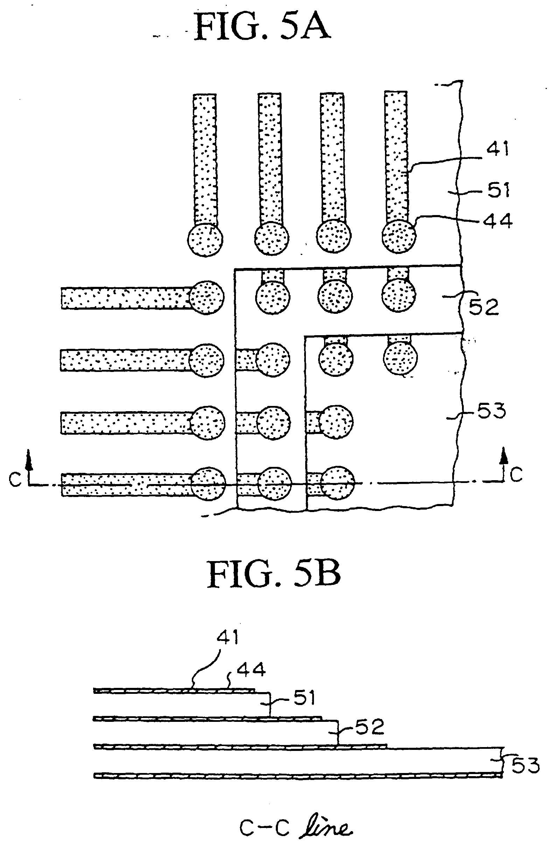

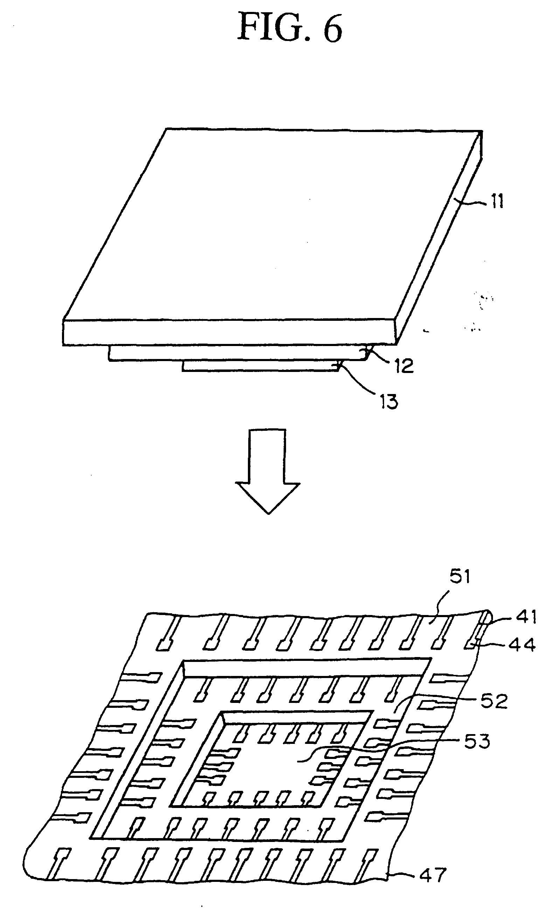

A first embodiment according to the present invention will be described in detail with reference to FIGS. 3A, 3B, 3C, 4, 5A, 5B, 6A and 6B, wherein a novel surface mounting type semiconductor package with an improved mounting surface is provided. FIG. 3A is a schematic perspective view illustrative of a novel surface mounting type semiconductor package with an improved mounting surface in a first embodiment in accordance with the present invention. FIG. 3B is a schematic plane view illustrative of a novel surface mounting type semiconductor package with an improved mounting surface of FIG. 3A in a first embodiment in accordance with the present invention. FIG. 3C is a schematic cross sectional elevation view illustrative of a novel surface mounting type semiconductor package with an improved mounting surface taken along an A-A line of FIG. 3B in a first embodiment in accordance with the present invention. FIG. 4 is a cross sectional elevation view illustrative of a novel surface mounting type semiconductor package with an improved mounting surface of FIG. 3C in a first embodiment in accordance with the present invention. FIG. 5A is a fragmentary enlarged plane view illustrative of a multilayer mounting substrate onto which a novel surface mounting type semiconductor package with an improved mounting surface is mounted in accordance with the present invention. FIG. 5B is a fragmentary enlarged cross sectional elevation view illustrative of a multilayer mounting substrate of FIG. 5A. FIG. 6 is a schematic perspective view illustrative of a novel surface mounting type semiconductor package with an improved mounting surface to be mounted onto a multilayer mounting substrate in a first embodiment in accordance with the present invention.

As illustrated in FIGS. 3A, 3B and 3C, a novel surface mounting type semiconductor package 1 has an improved mounting surface with steps. The novel surface mounting type semiconductor package 1 comprises laminations of first, second and third layers 11, 12 and 13, wherein the first, second and third layers 11, 12 and 13 are square-shaped but are different in size in plane view. The first layer 11 has a largest size in plane view. The second layer 12 has a middle size in plane view. The third layer 13 has a smallest size in plane view. The size differences among the first, second and third layers 11, 12 and 13 result in formation of a first step between a first level stage of the first layer 11 and a second level stage of the second layer 12, and a second step between the second level stage of the second layer 12 and a third level stage of the third layer 13. The first level stage of the first layer 11 is defined by a peripheral region of a top surface of the first layer 11, wherein the peripheral region of the first layer 11 is not overlaid by the second layer 12. The second level stage of the second layer 12 is defined by a peripheral region of a top surface of the second layer 12, wherein the peripheral region of the second layer 12 is not overlaid by the third layer 13. The third level stage of the third layer 13 is defined by a top surface of the third layer 13. The mounting surface of the surface mounting type semiconductor package 1 has a multi-stage structure which comprises the first level stage, the second level stage and the third level stage, wherein the second level stage is surrounded by the first level stage and also is bounded by the first step from the first level stage, whilst the third level stage is surrounded by the second level stage and also is bounded by the second step from the second level stage.

The first level stage of the first layer 11 is in the form of four straight bands extending along four sides of the squared semiconductor package 1. Bach of the four straight bands of the first level stage of the first layer 11 has a single alignment of conductive pads which extends along the straight band, so that the conductive pads are aligned on the first level stage of the first layer 11 to form a square. The second level stage of the second layer 12 is also in the form of four straight bands extending in parallel to the four sides of the square-shaped semiconductor package 1. Each of the four straight bands of the second level stage of the second layer 12 has a single alignment of conductive pads which extends along the straight band, so that the conductive pads are aligned on the second level stage of the second layer 12 to form a square. The third level stage of the third layer 13 is in the form of a square. The third level stage of the third layer 13 has four alignments of conductive pads which extend along four sides of the square-shaped third layer 13 respectively so that the conductive pads are aligned on the peripheral region of the square-shaped third layer 13. As a result, the conductive pads are aligned on the mounting surface of the semiconductor package 1 to form triple squares which are, however, different in level. The outer square of the four straight alignments of the conductive pads has a bottom level of the mounting surface of the semiconductor package 1. The intermediate square of the four straight alignments of the conductive pads has an intermediate level of the mounting surface of the semiconductor package 1. The inner square of the four straight alignments of the conductive pads has a top level of the mounting surface of the semiconductor package 1. Solder balls 20 as ball bumps are provided on the individual conductive pads, whereby the alignments of the solder balls 20 form triple squares which are, however, different in level. The outer square of the four straight alignments of the solder balls 20 has a bottom level of the mounting surface of the semiconductor package 1. The intermediate square of the four straight alignments of the solder balls 20 has an intermediate level of the mounting surface of the semiconductor package 1. The inner square of the four straight alignments of the solder balls 20 has a top level of the mounting surface of the semiconductor package 1. The difference in level of the triple squares of the conductive pads or the solder balls 20 results in that individuals of the conductive pads and the solder balls 20 have outside free spaces which are positioned outside thereof and free of any obstacle to allow interconnections to lead out of the solder balls 20 outwardly or toward the individual sides of the square shaped semiconductor package 1 with keeping those individual levels.

With reference to FIG. 4, the structure of the semiconductor package will subsequently be described. The square shaped semiconductor package 1 has a silicon chip 43, an insulation layer 45 and a multilayer substrate further comprising laminations of the first, second and third layers 11, 12 and 13. The laminations of the first, second and third layers 11, 12 and 13 are separated by the insulation layer 45 from the silicon chip 43. Interconnections 41 are provided which extend on an opposite surface of the first layer 11 to the mounting surface of the semiconductor package 1. As already described above, the solder balls 20 are provided on the individual conductive pads which are provided on the first, second and third level stages of the first, second and third layers 11, 12 and 13 so as to form triple squares of alignments of the solder balls 20. The outer square of the four alignments of the solder balls 20 is formed on the first level stage of the first layer 11. The intermediate square of the four alignments of the solder balls 20 is formed on the second level stage of the second layer 12. The inner square of the four alignments of the solder balls 20 is formed on the peripheral region of the third level stage of the third layer 13. The laminations of the first, second and third layers 11, 12 and 13 have through holes 46, each of which has a conductive film providing an electrical connection between the interconnection 41 and the solder ball 20. The surface of the silicon chip 43 has conductive pads 44 which are electrically connected through bonding wires 42 to the interconnections 41. The silicon chip 43 is sealed with a sealing material 40. The mounting surface of the semiconductor chip 1 comprises a stepped multistage structure with the triple squares of the solder ball alignments different in level from each other.

The above described semiconductor package 1 is mounted onto a multilayer mounting substrate illustrated in FIGS. 5A, 5B and 6. The multilayer mounting substrate comprises laminations of first, second and third mounting substrates 51, 52 and 53, wherein the second mounting substrate 52 is laminated on the third mounting substrate 53, whilst the first mounting substrate 51 is laminated on the second mounting substrate 52. The second mounting substrate 52 has a small square-shaped opening positioned at a center of the multilayer mounting substrate so that a square-shaped part of the surface of the third mounting substrate 53 is shown through the small square-shaped opening of the second mounting substrate 52. The first mounting substrate 51 has a large square-shaped opening positioned at the center of the multilayer mounting substrate so that a peripheral region of the small square-shaped opening of the second mounting substrate 52 as well as the square-shaped part of the surface of the third mounting substrate 53 are shown through the large square-shaped opening of the first mounting substrate 51.

As a result, the mounting surface of the multilayer mounting substrate has a multistage structure comprising first, second and third level stages. The first level stage of the first mounting substrate 51 is defined by the large square-shaped opening. The second level stage of the second mounting substrate 52 is defined by the large and small square-shaped openings. The third level stage of the third mounting substrate 53 is square-shaped and defined by the smaller square-shaped opening. The edges of the larger square-shaped opening also provide a first step which bounds the first level stage of the first mounting substrate 51 and the second level stage of the second mounting substrate 52. The edges of the smaller square-shaped opening also provide a second step which bounds the second level stage of the second mounting substrate 52 and the third level stage of the third mounting substrate 53. The third level stage of the third mounting substrate 53 is surrounded by the second level stage of the second mounting substrate 52, whilst the second level stage of the second mounting substrate 52 is surrounded by the first level stage of the first mounting substrate 51.

First level interconnections 41 and first level conductive pads 44 are provided on the first mounting substrate 51. Each of four alignments of the first level conductive pads 44 extends along each side of the larger square-shaped opening so that an outer square of four alignments of the first level conductive pads 44 is formed around the larger square-shaped opening. The first level interconnections 41 extend from the first level conductive pads 44 outwardly in directions perpendicular to the sides of the large square-shaped opening. Second level interconnections 41 and second level conductive pads 44 are provided on the second mounting substrate 52. Each of four alignments of the second level conductive pads 44 extends along each side of the smaller square-shaped opening so that an intermediate square of four alignments of the second level conductive pads 44 is formed around the smaller square-shaped opening and surrounded by the outer square of four alignments of the first level conductive pads 44. The second level interconnections 41 extend from the second level conductive pads 44 outwardly in directions perpendicular to the sides of the smaller square-shaped opening. The second level interconnections 41 extend on an interface between the first and second mounting substrates 51 and 52 and also extend under the first level interconnections 41. Third level interconnections 41 and third level conductive pads 44 are also provided on the third mounting substrate 53. Each of four alignments of the third level conductive pads 44 extends along each side of the smaller square-shaped opening so that an inner square of four alignments of the third level conductive pads 44 is formed inside of the smaller square-shaped opening and surrounded by the intermediate square of four alignments of the second level conductive pads 44. The third level interconnections 41 extend from the third level conductive pads 44 outwardly in directions perpendicular to the sides of the smaller square-shaped opening. The third level interconnections 41 extend on an interface between the second and third mounting substrates 51 and 52 and also extend under the second level interconnections 41 underlying the first level interconnections 41. Fourth level interconnections 41 may also be provided which extend over an opposite surface of the third mounting substrate 53 to the mounting surface of the multilayer mounting substrate 47.

With reference to FIG. 6, the above described semiconductor package 1 is mounted onto the multilayer mounting substrate 47. The first level stage of the first layer 11 of the semiconductor package 1 corresponds in size in plane view, shape and position to the first level stage of the first mounting substrate 51 of the multilayer mounting substrate 47. The first step of the semiconductor package 1 also corresponds in size in plane view, shape and position to the first step of the multilayer mounting substrate 47. The second level stage of the second layer 12 of the semiconductor package 1 also corresponds in size in plane view, shape and position to the second level stage of the second mounting substrate 52 of the multilayer mounting substrate 47. The second step of the semiconductor package 1 also corresponds in size in plane view, shape and position to the second step of the multilayer mounting substrate 47. The third level stage of the third layer 13 of the semiconductor package 1 also corresponds in size in plane view, shape and position to the third level stage of the third mounting substrate 53 of the multilayer mounting substrate 47.

Further, the first level conductive pads on the larger square-formed alignments on the first level stage of the first layer 11 of the semiconductor package 1 further correspond in position to the first level conductive pads 44 on the larger square-formed alignments on the rust level stage of the first mounting substrate 51 of the multilayer mounting substrate 47. Namely, the first level solder balls 20 on the larger square-formed alignments on the first level stage of the first layer 11 of the semiconductor package 1 further correspond in position to the first level conductive pads 44 on the larger square-formed alignments on the first level stage of the first mounting substrate 51 of the multilayer mounting substrate 47. Further, the second level conductive pads on the intermediate square-formed alignments on the second level stage of the second layer 12 of the semiconductor package 1 further correspond in position to the second level conductive pads 44 on the intermediate square-formed alignments on the second level stage of the second mounting substrate 52 of the multilayer mounting substrate 47. Namely, the second level solder balls 20 on the intermediate square-formed alignments on the second level stage of the second layer 12 of the semiconductor package 1 further correspond in position to the second level conductive pads 44 on the intermediate square-formed alignments on the second level stage of the second mounting substrate 52 of the multilayer mounting substrate 47. Further, the third level conductive pads on the smaller square-formed alignments on the third level stage of the third layer 13 of the semiconductor package 1 further correspond in position to the third level conductive pads 44 on the smaller square-formed alignments on the third level stage of the third mounting substrate 53 of the multilayer mounting substrate 47. Namely, the third level solder balls 20 on the smaller square-formed alignments on the third level stage of the third layer 13 of the semiconductor package 1 further correspond in position to the third level conductive pads 44 on the smaller square-formed alignments on the third level stage of the third mounting substrate 53 of the multilayer mounting substrate 47.

Consequently, if the semiconductor package 1 is mounted onto the multilayer mounting substrate 47, then the first level solder balls 20 of the semiconductor package 1 correspond in level and position to the first level conductive pads 44 of the multilayer mounting substrate 47, whereby the first level solder balls 20 of the semiconductor package 1 are made into contact with the first level conductive pads 44 of the multilayer mounting substrate 47. Simultaneously, the second level solder balls 20 of the semiconductor package 1 correspond in level and position to the second level conductive pads 44 of the multilayer mounting substrate 47, whereby the second level solder balls 20 of the semiconductor package 1 are made into contact with the second level conductive pads 44 of the multilayer mounting substrate 47. Further simultaneously, the third level solder balls 20 of the semiconductor package 1 correspond in level and position to the third level conductive pads 44 of the multilayer mounting substrate 47, whereby the third level solder balls 20 of the semiconductor package 1 are made into contact with the third level conductive pads 44 of the multilayer mounting substrate 47.

As a result, the first level conductive pads of the semiconductor package 1 are electrically connected through the first level solder bumps 20 and the first level conductive pads 44 of the multilayer mounting substrate 47 to the first level interconnections 41 which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads 44 of the multilayer mounting substrate 47 to the second level interconnections 41 which extend outwardly with keeping the second level and in straight lines without, however, leading through between adjacent two of the first level conductive pads 44 which are positioned outside of the second level conductive pads 44 and without making any detour to avoid any obstacle such as the first level conductive pads 44, for example, by use of any through hole. Furthermore, the third level conductive pads of the semiconductor package 1 are electrically connected through the third level solder bumps 20 and the third level conductive pads 44 of the multilayer mounting substrate 47 to the third level interconnections 41 which extend outwardly with keeping the third level and in straight lines without, however, leading through between adjacent two of the first level or second level conductive pads 44 which are positioned outside of the third level conductive pads 44 and without making any detour to avoid any obstacle such as the first level or second level conductive pads 44, for example, by use of any through hole.

The above improved level-varying mounting surface of the semiconductor package 1 allows the multi-level interconnections to lead of the mounting area of the multilayer mounting substrate 47 in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase in the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size of the semiconductor package.

### SECOND EMBODIMENT:

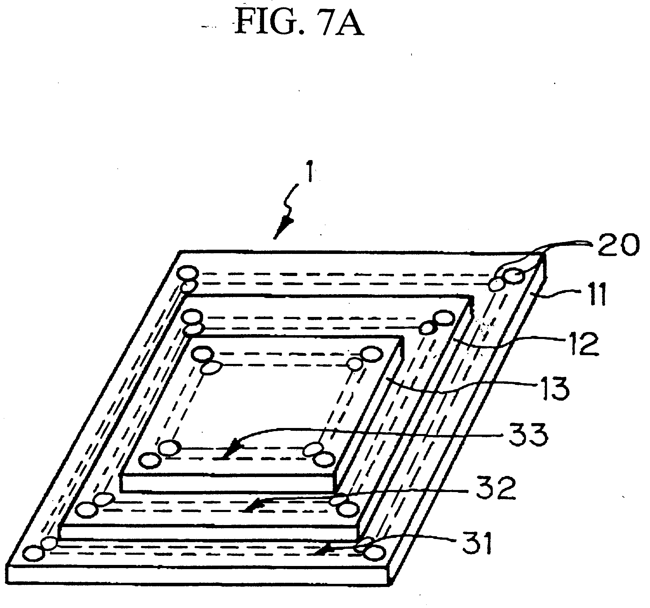

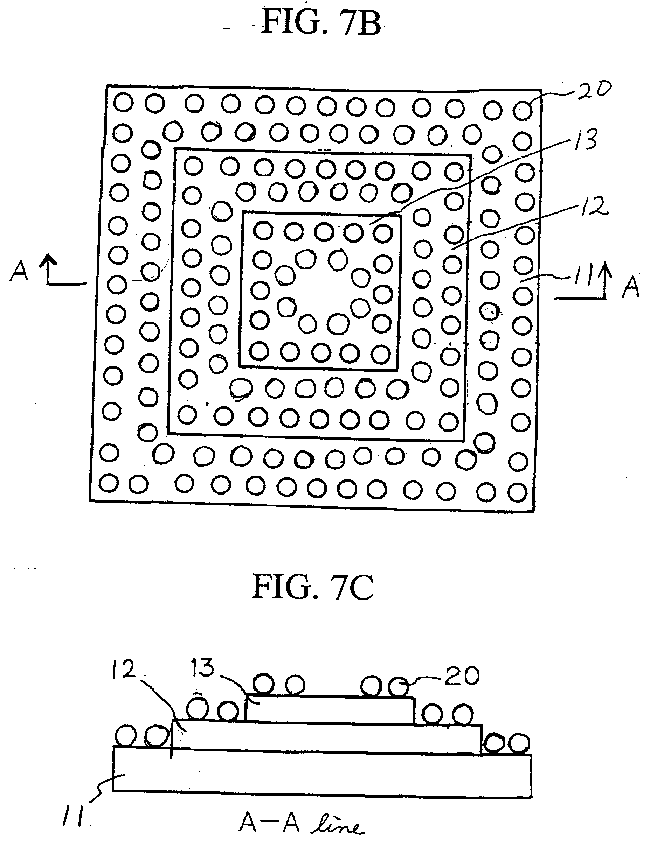

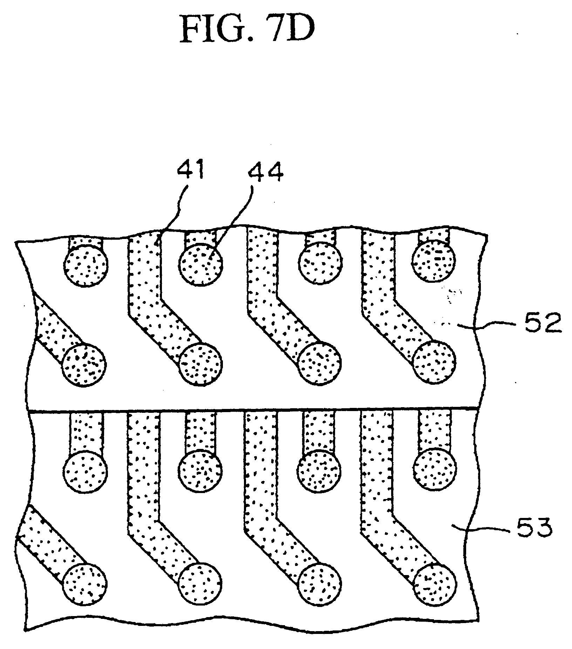

A second embodiment according to the present invention will be described in detail with reference to FIGS. 7A, 7B, 7C and 7D, wherein a novel surface mounting type semiconductor package with an improved mounting surface is provided. FIG. 7A is a schematic perspective view illustrative of a novel surface mounting type semiconductor package with an improved mounting surface in a second embodiment in accordance with the present invention. FIG. 7B is a schematic plane view illustrative of a novel surface mounting type semiconductor package with an improved mounting surface of FIG. 7A in a second embodiment in accordance with the present invention. FIG. 7C is a schematic cross sectional elevation view illustrative of a novel surface mounting type semiconductor package with an improved mounting surface taken along an A-A line of FIG. 7B in a second embodiment in accordance with the present invention. FIG. 7D is a fragmentary enlarged plane view illustrative of dual alignments of conductive pads on each stage of an improved mounting surface of a novel surface mounting type semiconductor package of FIG. 7A in a second embodiment in accordance with the present invention.

In this second embodiment, the improved mounting surface of the semiconductor package has three stages different in level from each other and two steps bounding the three stages, wherein each of the stages has dual squares of conductive pad alignments comprising four sides, each of which further comprises dual alignments of the conductive pads on which the solder balls are provided. Other structures of the semiconductor package are substantially the same as in the first embodiment. On each side of the each square-shaped stage of the semiconductor package, the conductive pads on the inner one of the dual alignments are positioned to be displaced from the conductive pads on the outer one of the dual alignments by a half of a pitch of the conductive pads, so that the solder ball on each of the conductive pads on the inner one of the dual alignments is connected to an interconnection which extends in a straight through an intermediate point between adjacent two of the conductive pads on the outer one of the dual alignments. In correspondence with the dual alignment structure, the mounting surface of the multilayer mounting substrate is structurally changed to form dual alignments of the conductive pads. This second embodiment will be described in detail with reference to FIGS. 7A, 7B and 7C.

A novel surface mounting type semiconductor package 1 has an improved mounting surface with steps. The novel surface mounting type semiconductor package 1 comprises laminations of first, second and third layers 11, 12 and 13, wherein the first, second and third layers 11, 12and 13 are square-shaped but are different in size in plane view. The first layer 11 has a largest size in plane view. The second layer 12 has a middle size in plane view. The third layer 13 has a smallest size in plane view. The size differences among the first, second and third layers 11, 12 and 13 result in formation of a first step between a first level stage of the first layer 11 and a second level stage of the second layer 12, and a second step between the second level stage of the second layer 12 and a third level stage of the third layer 13. The first level stage of the first layer 11 is defined by a peripheral region of a top surface of the first layer 11, wherein the peripheral region of the first layer 11 is not overlaid by the second layer 12. The second level stage of the second layer 12 is defined by a peripheral region of a top surface of the second layer 12, wherein the peripheral region of the second layer 12 is not overlaid by the third layer 13. The third level stage of the third layer 13 is defined by a top surface of the third layer 13. The mounting surface of the surface mounting type semiconductor package 1 has a multi-stage structure which comprises the first level stage, the second level stage and the third level stage, wherein the second level stage is surrounded by the first level stage and also is bounded by the first step from the first level stage, whilst the third level stage is surrounded by the second level stage and also is bounded by the second step from the second level stage.

The first level stage of the first layer 11 is in the form of four straight bands extending along four sides of the squared semiconductor package 1. Each of the four straight bands of the first level stage of the first layer 11 has dual alignments of conductive pads which extend along the straight band, so that the conductive pads are aligned on the first level stage of the first layer 11 to form a square. The second level stage of the second layer 12 is also in the form of four straight bands extending in parallel to the four sides of the square-shaped semiconductor package 1. Each of the four straight bands of the second level stage of the second layer 12 has dual alignments of conductive pads which extend along the straight band, so that the conductive pads are aligned on the second level stage of the second layer 12 to form a square. The third level stage of the third layer 13 is in the form of a square. The third level stage of the third layer 13 has four of dual alignments of conductive pads which extend along four sides of the square-shaped third layer 13 respectively so that the conductive pads are aligned on the peripheral region of the square-shaped third layer 13. Each of the dual alignments extends along the each side of the square-shaped third level stage. The conductive pads on the inner one of the dual alignments are positioned to be displaced from the conductive pads on the outer one of the dual alignments by a half of a pitch of the conductive pads, so that the solder ball on each of the conductive pads on the inner one of the dual alignments is connected to an interconnection which extends in a straight through an intermediate point between adjacent two of the conductive pads on the outer one of the dual alignments. As a result, the conductive pads are aligned on the mounting surface of the semiconductor package 1 to form three sets of dual squares which are, however, different in level. The dual square alignments of the conductive pads on the first level stage have a bottom level of the mounting surface of the semiconductor package 1. The dual square alignments of the conductive pads on the first level stage have an intermediate level of the mounting surface of the semiconductor package 1. The dual square alignments of the conductive pads on the first level stage have a top level of the mounting surface of the semiconductor package 1. Solder balls 20 as ball bumps are provided on the individual conductive pads, whereby the alignments of the solder balls 20 form triple sets of dual squares which are, however, different in level. The outer dual squares of the alignments of the solder balls 20 have a bottom level of the mounting surface of the semiconductor package 1. The intermediate dual squares of the alignments of the solder balls 20 have an intermediate level of the mounting surface of the semiconductor package 1. The inner dual squares of the alignments of the solder balls 20 have a top level of the mounting surface of the semiconductor package 1. The difference in level of the triple sets of the dual squares of the conductive pads or the solder balls 20 results in that individuals of the conductive pads and the solder balls 20 have outside free spaces which are positioned outside thereof and free of any obstacle to allow interconnections to lead out of the solder balls 20 outwardly or toward the individual sides of the square shaped semiconductor package 1 with keeping those individual levels.

The above described semiconductor package 1 is mounted onto a multilayer mounting substrate which has a multistage structure comprising first, second and third level stages. The multilayer mounting substrate used in this embodiment has the dual alignment structure in correspondence with the semiconductor package 1. Each of the first, second and third level stages has dual squares of conductive pad alignments. Each side of the each square-shaped stage has dual alignments of the conductive pads along each side of the steps, wherein the dual alignments comprise outer and inner alignments of the conductive pads. The conductive pads on the inner alignment are positioned to be displaced from the conductive pads on the outer alignment by a half pitch of the conductive pads, so that each of the interconnections connected to the conductive pads on the inner alignment extend through an intermediate between the adjacent two of the conductive pads on the outer alignment.

The above described semiconductor package 1 is mounted onto the multilayer mounting substrate. The first level stage of the first layer 11 of the semiconductor package 1 corresponds in size in plane view, shape and position to the first level stage of the first mounting substrate of the multilayer mounting substrate. The first step of the semiconductor package 1 also corresponds in size in plane view, shape and position to the first step of the multilayer mounting substrate. The second level stage of the second layer 12 of the semiconductor package 1 also corresponds in size in plane view, shape and position to the second level stage of the second mounting substrate of the multilayer mounting substrate. The second step of the semiconductor package 1 also corresponds in size in plane view, shape and position to the second step of the multilayer mounting substrate. The third level stage of the third layer 13 of the semiconductor package 1 also corresponds in size in plane view, shape and position to the third level stage of the third mounting substrate of the multilayer mounting substrate.

Further, the first level conductive pads on the larger square-formed dual alignments on the first level stage of the first layer 11 of the semiconductor package 1 further correspond in position to the first level conductive pads on the larger square-formed dual alignments on the first level stage of the first mounting substrate of the multilayer mounting substrate. Namely, the first level solder balls 20 on the larger square-formed dual alignments on the first level stage of the first layer 11 of the semiconductor package 1 further correspond in position to the first level conductive pads on the larger square-formed alignments on the first level stage of the first mounting substrate of the multilayer mounting substrate. Further, the second level conductive pads on the intermediate square-formed dual alignments on the second level stage of the second layer 12 of the semiconductor package 1 further correspond in position to the second level conductive pads on the intermediate square-formed alignments on the second level stage of the second mounting substrate of the multilayer mounting substrate. Namely, the second level solder balls 20 on the intermediate square-formed dual alignments on the second level stage of the second layer 12 of the semiconductor package 1 further correspond in position to the second level conductive pads on the intermediate square-formed alignments on the second level stage of the second mounting substrate of the multilayer mounting substrate. Further, the third level conductive pads on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate. Namely, the third level solder balls 20 on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate.

Consequently, if the semiconductor package 1 is mounted onto the multilayer mounting substrate, then the first level solder balls 20 of the semiconductor package 1 correspond in level and position to the first level conductive pads of the multilayer mounting substrate, whereby the first level solder balls 20 of the semiconductor package 1 are made into contact with the first level conductive pads of the multilayer mounting substrate, wherein the inner first level solder balls 20 on the inner one of the dual alignments of the semiconductor package 1 are made into contact with the inner first level conductive pads on the inner one of the dual alignments of the multilayer mounting substrate, whilst the outer first level solder balls 20 on the outer one of the dual alignments of the semiconductor package 1 are made into contact with the outer first level conductive pads on the outer one of the dual alignments of the multilayer mounting substrate. Simultaneously, the second level solder balls 20 of the semiconductor package 1 correspond in level and position to the second level conductive pads of the multilayer mounting substrate, whereby the second level solder balls 20 of the semiconductor package 1 are made into contact with the second level conductive pads of the multilayer mounting substrate, wherein the inner second level solder balls 20 on the inner one of the dual alignments of the semiconductor package 1 are made into contact with the inner second level conductive pads on the inner one of the dual alignments of the multilayer mounting substrate, whilst the outer second level solder balls 20 on the outer one of the dual alignments of the semiconductor package 1 are made into contact with the outer second level conductive pads on the outer one of the dual alignments of the multilayer mounting substrate. Further simultaneously, the third level solder balls 20 of the semiconductor package 1 correspond in level and position to the third level conductive pads of the multilayer mounting substrate, whereby the third level solder balls 20 of the semiconductor package 1 are made into contact with the third level conductive pads of the multilayer mounting substrate, wherein the inner third level solder balls 20 on the inner one of the dual alignments of the semiconductor package 1 are made into contact with the inner third level conductive pads on the inner one of the dual alignments of the multilayer mounting substrate, whilst the outer third level solder balls 20 on the outer one of the dual alignments of the semiconductor package 1 are made into contact with the outer third level conductive pads on the outer one of the dual alignments of the multilayer mounting substrate.

As a result, the first level conductive pads of the semiconductor package 1 are electrically connected through the first level solder bumps 20 and the first level conductive pads of the multilayer mounting substrate to the first level interconnections which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads of the multilayer mounting substrate to the second level interconnections which extend outwardly with keeping the second level and in straight lines without, however, leading through between adjacent two of the first level conductive pads which are positioned outside of the second level conductive pads and without making any detour to avoid any obstacle such as the first level conductive pads, for example, by use of any through hole. Furthermore, the third level conductive pads of the semiconductor package 1 are electrically connected through the third level solder bumps 20 and the third level conductive pads of the multilayer mounting substrate to the third level interconnections which extend outwardly with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size in plane view of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase in the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size of the semiconductor package.

### THIRD EMBODIMENT :

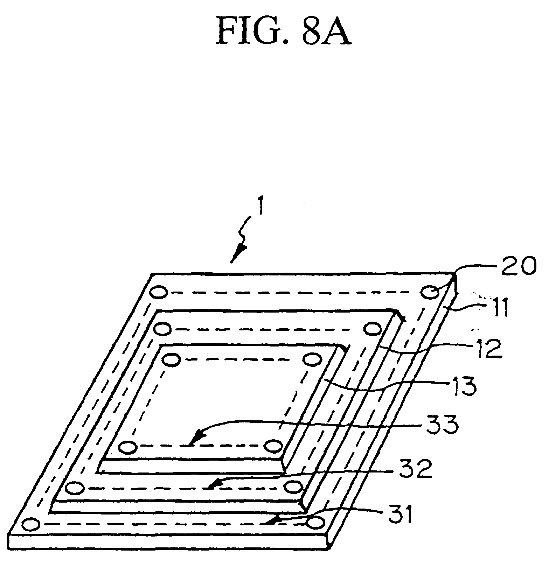

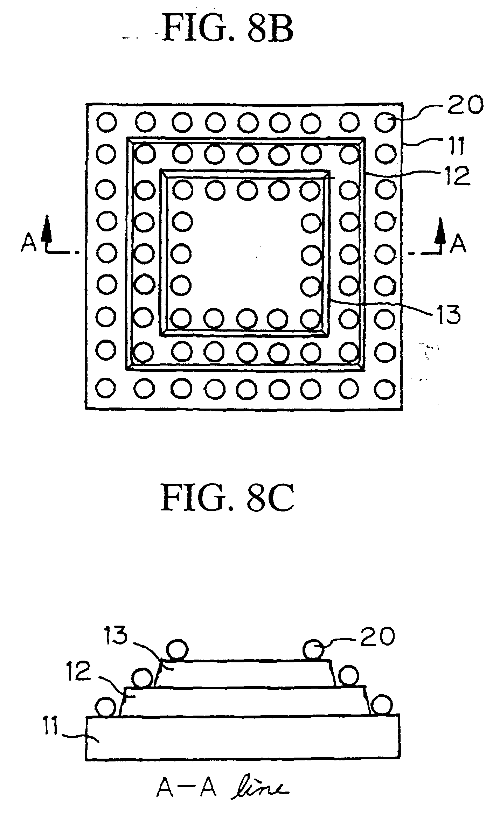

A third embodiment according to the present invention will be described in detail with reference to FIGS. 8A, 8B and 8C, wherein a novel surface mounting type semiconductor package with an improved mounting surface is provided. FIG. 8A is a schematic perspective view illustrative of a novel surface mounting type semiconductor package with an improved mounting surface in a third embodiment in accordance with the present invention. FIG. 8B is a schematic plane view illustrative of a novel surface mounting type semiconductor package with an improved mounting surface of FIG. 8A in a third embodiment in accordance with the present invention. FIG. 8C is a schematic cross sectional elevation view illustrative of a novel surface mounting type semiconductor package with an improved mounting surface taken along an A-A line of FIG. 8B in a third embodiment in accordance with the present invention.

In the third embodiment, the novel surface mounting type semiconductor package 1 has a structural difference from the first embodiment in first and second slopes which bound the first, second ad third level stages. In place of the step having a vertical wall, the slope may be formed to bound the first, second and third level stages different in level from each other.

As illustrated in FIGS. 8A, 8B and 8C, the novel surface mounting type semiconductor package 1 has an improved mounting surface with slopes. The novel surface mounting type semiconductor package 1 comprises laminations of first, second and third layers 11, 12 and 13, wherein the first, second and third layers 11, 12 and 13 are square-shaped but are different in size in plane view. The first layer 11 has a largest size in plane view. The second layer 12 has a middle size in plane view. The third layer 13 has a smallest size in plane view. The size in plane view differences among the first, second and third layers 11, 12 and 13 result in formation of a first slope between a first level stage of the first layer 11 and a second level stage of the second layer 12, and a second slope between the second level stage of the second layer 12 and a third level stage of the third layer 13. The first level stage of the first layer 11 is defined by a peripheral region of a top surface of the first layer 11, wherein the peripheral region of the first layer 11 is not overlaid by the second layer 12. The second level stage of the second layer 12 is defined by a peripheral region of a top surface of the second layer 12, wherein the peripheral region of the second layer 12 is not overlaid by the third layer 13. The third level stage of the third layer 13 is defined by a top surface of the third layer 13. The mounting surface of the surface mounting type semiconductor package 1 has a multi-stage structure which comprises the first level stage, the second level stage and the third level stage, wherein the second level stage is surrounded by the first level stage and also is bounded by the first slope from the first level stage, whilst the third level stage is surrounded by the second level stage and also is bounded by the second slope from the second level stage.

The first level stage of the first layer 11 is in the form of four straight bands extending along four sides of the squared semiconductor package 1. Each of the four straight bands of the first level stage of the first layer 11 has a single alignment of conductive pads which extends along the straight band, so that the conductive pads are aligned on the first level stage of the first layer 11 to form a square. The second level stage of the second layer 12 is also in the form of four straight bands extending in parallel to the four sides of the square-shaped semiconductor package 1. Each of the four straight bands of the second level stage of the second layer 12 has a single alignment of conductive pads which extends along the straight band, so that the conductive pads are aligned on the second level stage of the second layer 12 to form a square. The third level stage of the third layer 13 is in the form of a square. The third level stage of the third layer 13 has four alignments of conductive pads which extend along four sides of the square-shaped third layer 13 respectively so that the conductive pads are aligned on the peripheral region of the square-shaped third layer 13. As a result, the conductive pads are aligned on the mounting surface of the semiconductor package 1 to form triple squares which are, however, different in level. The outer square of the four straight alignments of the conductive pads has a bottom level of the mounting surface of the semiconductor package 1. The intermediate square of the four straight alignments of the conductive pads has an intermediate level of the mounting surface of the semiconductor package 1. The inner square of the four straight alignments of the conductive pads has a top level of the mounting surface of the semiconductor package 1. Solder balls 20 as ball bumps are provided on the individual conductive pads, whereby the alignments of the solder balls 20 form triple squares which are, however, different in level. The outer square of the four straight alignments of the solder balls 20 has a bottom level of the mounting surface of the semiconductor package 1. The intermediate square of the four straight alignments of the solder balls 20 has an intermediate level of the mounting surface of the semiconductor package 1. The inner square of the four straight alignments of the solder balls 20 has a top level of the mounting surface of the semiconductor package 1. The difference in level of the triple squares of the conductive pads or the solder balls 20 results in that individuals of the conductive pads and the solder balls 20 have outside free spaces which are positioned outside thereof and free of any obstacle to allow interconnections to lead out of the solder balls 20 outwardly or toward the individual sides of the square shaped semiconductor package 1 with keeping those individual levels.

The above described semiconductor package 1 is mounted onto a multilayer mounting substrate as illustrated in FIGS. 5A, 5B and 6. The multilayer mounting substrate comprises laminations of first, second and third mounting substrates 51, 52 and 53, wherein the second mounting substrate 52 is laminated on the third mounting substrate 53, whilst the first mounting substrate 51 is laminated on the second mounting substrate 52. The second mounting substrate 52 has a small square-shaped opening positioned at a center of the multilayer mounting substrate so that a square-shaped part of the surface of the third mounting substrate 53 is shown through the small square-shaped opening of the second mounting substrate 52. The first mounting substrate 51 has a large square-shaped opening positioned at the center of the multilayer mounting substrate so that a peripheral region of the small square-shaped opening of the second mounting substrate 52 as well as the square-shaped part of the surface of the third mounting substrate 53 are shown through the large square-shaped opening of the first mounting substrate 51.

As a result, the mounting surface of the multilayer mounting substrate has a multistage structure comprising first, second and third level stages. The first level stage of the first mounting substrate 51 is defined by the large square-shaped opening. The second level stage of the second mounting substrate 52 is defined by the large and small square-shaped openings. The third level stage of the third mounting substrate 53 is square-shaped and defined by the smaller square-shaped opening. The edges of the larger square-shaped opening also provide a first step which bounds the first level stage of the first mounting substrate 51 and the second level stage of the second mounting substrate 52. The edges of the smaller square-shaped opening also provide a second step which bounds the second level stage of the second mounting substrate 52 and the third level stage of the third mounting substrate 53. The third level stage of the third mounting substrate 53 is surrounded by the second level stage of the second mounting substrate 52, whilst the second level stage of the second mounting substrate 52 is surrounded by the first level stage of the first mounting substrate 51.

First level interconnections 41 and first level conductive pads 44 are provided on the first mounting substrate 51. Each of four alignments of the first level conductive pads 44 extends along each side of the larger square-shaped opening so that an outer square of four alignments of the first level conductive pads 44 is formed around the larger square-shaped opening. The first level interconnections 41 extend from the first level conductive pads 44 outwardly in directions perpendicular to the sides of the large square-shaped opening. Second level interconnections 41 and second level conductive pads 44 are provided on the second mounting substrate 52. Each of four alignments of the second level conductive pads 44 extends along each side of the smaller square-shaped opening so that an intermediate square of four alignments of the second level conductive pads 44 is formed around the smaller square-shaped opening and surrounded by the outer square of four alignments of the first level conductive pads 44. The second level interconnections 41 extend from the second level conductive pads 44 outwardly in directions perpendicular to the sides of the smaller square-shaped opening. The second level interconnections 41 extend on an interface between the first and second mounting substrates 51 and 52 and also extend under the first level interconnections 41. Third level interconnections 41 and third level conductive pads 44 are also provided on the third mounting substrate 53. Each of four alignments of the third level conductive pads 44 extends along each side of the smaller square-shaped opening so that an inner square of four alignments of the third level conductive pads 44 is formed inside of the smaller square-shaped opening and surrounded by the intermediate square of four alignments of the second level conductive pads 44. The third level interconnections 41 extend from the third level conductive pads 44 outwardly in directions perpendicular to the sides of the smaller square-shaped opening. The third level interconnections 41 extend on an interface between the second and third mounting substrates 51 and 52 and also extend under the second level interconnections 41 underlying the first level interconnections 41. Fourth level interconnections 41 may also be provided which extend over an opposite surface of the third mounting substrate 53 to the mounting surface of the multilayer mounting substrate 47.

With reference to FIG. 6, the above described semiconductor package 1 is mounted onto the multilayer mounting substrate 47. The first level stage of the first layer 11 of the semiconductor package 1 corresponds in size in plane view, shape and position to the first level stage of the first mounting substrate 51 of the multilayer mounting substrate 47. The first slope of the semiconductor package 1 also corresponds in size in plane view, shape and position to the first step of the multilayer mounting substrate 47. The second level stage of the second layer 12 of the semiconductor package 1 also corresponds in size in plane view, shape and position to the second level stage of the second mounting substrate 52 of the multilayer mounting substrate 47. The second slope of the semiconductor package 1 also corresponds in size in plane view, shape and position to the second step of the multilayer mounting substrate 47. The third level stage of the third layer 13 of the semiconductor package 1 also corresponds in size in plane view, shape and position to the third level stage of the third mounting substrate 53 of the multilayer mounting substrate 47.

Further, the first level conductive pads on the larger square-formed alignments on the first level stage of the first layer 11 of the semiconductor package 1 further correspond in position to the first level conductive pads 44 on the larger square-formed alignments on the first level stage of the first mounting substrate 51 of the multilayer mounting substrate 47. Namely, the first level solder balls 20 on the larger square-formed alignments on the first level stage of the first layer 11 of the semiconductor package 1 further correspond in position to the first level conductive pads 44 on the larger square-formed alignments on the first level stage of the first mounting substrate 51 of the multilayer mounting substrate 47. Further, the second level conductive pads on the intermediate square-formed alignments on the second level stage of the second layer 12 of the semiconductor package 1 further correspond in position to the second level conductive pads 44 on the intermediate square-formed alignments on the second level stage of the second mounting substrate 52 of the multilayer mounting substrate 47. Namely, the second level solder balls 20 on the intermediate square-formed alignments on the second level stage of the second layer 12 of the semiconductor package 1 further correspond in position to the second level conductive pads 44 on the intermediate square-formed alignments on the second level stage of the second mounting substrate 52 of the multilayer mounting substrate 47. Further, the third level conductive pads on the smaller square-formed alignments on the third level stage of the third layer 13 of the semiconductor package 1 further correspond in position to the third level conductive pads 44 on the smaller square-formed alignments on the third level stage of the third mounting substrate 53 of the multilayer mounting substrate 47. Namely, the third level solder balls 20 on the smaller square-formed alignments on the third level stage of the third layer 13 of the semiconductor package 1 further correspond in position to the third level conductive pads 44 on the smaller square-formed alignments on the third level stage of the third mounting substrate 53 of the multilayer mounting substrate 47.

Consequently, if the semiconductor package 1 is mounted onto the multilayer mounting substrate 47, then the first level solder balls 20 of the semiconductor package 1 correspond in level and position to the first level conductive pads 44 of the multilayer mounting substrate 47, whereby the first level solder bails 20 of the semiconductor package 1 are made into contact with the first level conductive pads 44 of the multilayer mounting substrate 47. Simultaneously, the second level solder balls 20 of the semiconductor package 1 correspond in level and position to the second level conductive pads 44 of the multilayer mounting substrate 47, whereby the second level solder balls 20 of the semiconductor package 1 are made into contact with the second level conductive pads 44 of the multilayer mounting substrate 47. Further simultaneously, the third level solder balls 20 of the semiconductor package 1 correspond in level and position to the third level conductive pads 44 of the multilayer mounting substrate 47, whereby the third level solder balls 20 of the semiconductor package 1 are made into contact with the third level conductive pads 44 of the multilayer mounting substrate 47.

As a result, the first level conductive pads of the semiconductor package 1 are electrically connected through the first level solder bumps 20 and the first level conductive pads 44 of the multilayer mounting substrate 47 to the first level interconnections 41 which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads 44 of the multilayer mounting substrate 47 to the second level interconnections 41 which extend outwardly with keeping the second level and in straight lines without, however, leading through between adjacent two of the first level conductive pads 44 which are positioned outside of the second level conductive pads 44 and without making any detour to avoid any obstacle such as the first level conductive pads 44, for example, by use of any through hole. Furthermore, the third level conductive pads of the semiconductor package 1 are electrically connected through the third level solder bumps 20 and the third level conductive pads 44 of the multilayer mounting substrate 47 to the third level interconnections 41 which extend outwardly with keeping the third level and in straight lines without, however, leading through between adjacent two of the first level or second level conductive pads 44 which are positioned outside of the third level conductive pads 44 and without making any detour to avoid any obstacle such as the first level or second level conductive pads 44, for example, by use of any through hole.

The above improved level-varying mounting surface of the semiconductor package 1 allows the multi-level interconnections to lead of the mounting area of the multilayer mounting substrate 47 in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase in the numbers of the slopes and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size of the semiconductor package.

### FOURTH EMBODIMENT :

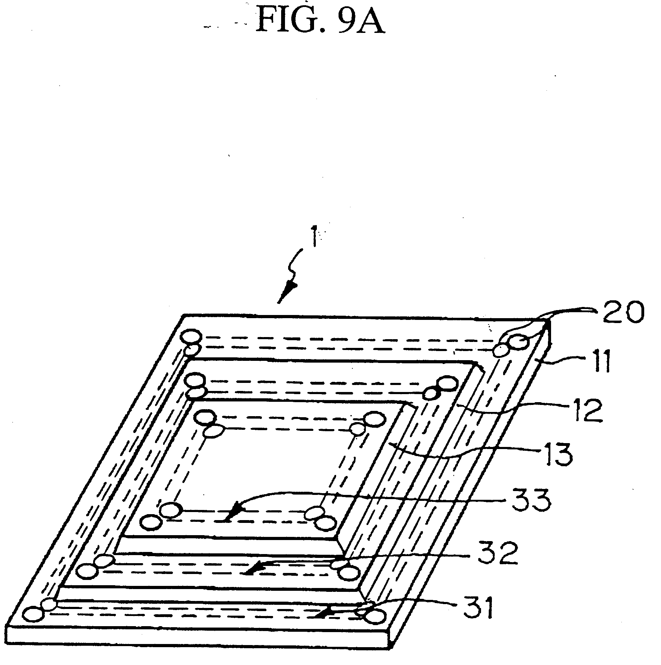

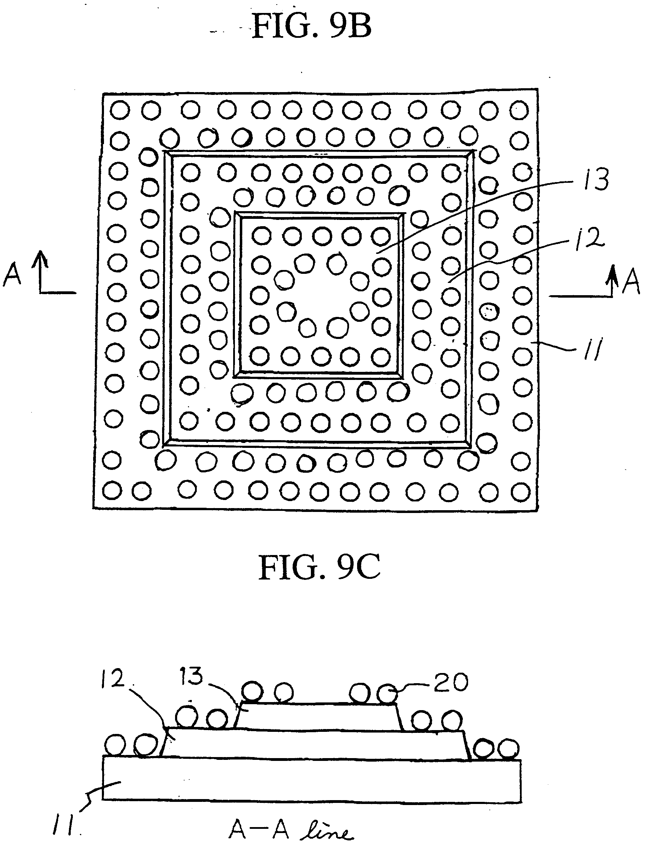

A fourth embodiment according to the present invention will be described in detail with reference to FIGS. 9A, 9B and 9C, wherein a novel surface mounting type semiconductor package with an improved mounting surface is provided. FIG. 9A is a schematic perspective view illustrative of a novel surface mounting type semiconductor package with an improved mounting surface in a fourth embodiment in accordance with the present invention. FIG. 9B is a schematic plane view illustrative of a novel surface mounting type semiconductor package with an improved mounting surface of FIG. 9A in a fourth embodiment in accordance with the present invention. FIG. 9C is a schematic cross sectional elevation view illustrative of a novel surface mounting type semiconductor package with an improved mounting surface taken along an A-A line of FIG. 9B in a fourth embodiment in accordance with the present invention.

In this fourth embodiment, the improved mounting surface of the semiconductor package has three stages different in level from each other and two slopes bounding the three stages, wherein each of the stages has dual squares of conductive pad alignments comprising four sides, each of which further comprises dual alignments of the conductive pads on which the solder balls are provided. Other structures of the semiconductor package are substantially the same as in the second embodiment. On each side of the each square-shaped stage of the semiconductor package, the conductive pads on the inner one of the dual alignments are positioned to be displaced from the conductive pads on the outer one of the dual alignments by a half of a pitch of the conductive pads, so that the solder ball on each of the conductive pads on the inner one of the dual alignments is connected to an interconnection which extends in a straight through an intermediate point between adjacent two of the conductive pads on the outer one of the dual alignments. In correspondence with the dual alignment structure, the mounting surface of the multilayer mounting substrate is structurally changed to form dual alignments of the conductive pads. This fourth embodiment will be described in detail with reference to FIGS. 9A, 9B and 9C.

A novel surface mounting type semiconductor package 1 has an improved mounting surface with slopes. The novel surface mounting type semiconductor package 1 comprises laminations of first, second and third layers 11, 12 and 13, wherein the first, second and third layers 11, 12and 13 are square-shaped but are different in size in plane view. The first layer 11 has a largest size in plane view. The second layer 12 has a middle size in plane view. The third layer 13 has a smallest size in plane view. The size differences among the first, second and third layers 11, 12 and 13 result in formation of a first slope between a first level stage of the first layer 11 and a second level stage of the second layer 12, and a second slope between the second level stage of the second layer 12 and a third level stage of the third layer 13. The first level stage of the first layer 11 is defined by a peripheral region of a top surface of the first layer 11, wherein the peripheral region of the first layer 11 is not overlaid by the second layer 12. The second level stage of the second layer 12 is defined by a peripheral region of a top surface of the second layer 12, wherein the peripheral region of the second layer 12 is not overlaid by the third layer 13. The third level stage of the third layer 13 is defined by a top surface of the third layer 13. The mounting surface of the surface mounting type semiconductor package 1 has a multi-stage structure which comprises the first level stage, the second level stage and the third level stage, wherein the second level stage is surrounded by the first level stage and also is bounded by the first slope from the first level stage, whilst the third level stage is surrounded by the second level stage and also is bounded by the second slope from the second level stage.

The first level stage of the first layer 11 is in the form of four straight bands extending along four sides of the squared semiconductor package 1. Each of the four straight bands of the first level stage of the first layer 11 has dual alignments of conductive pads which extend along the straight band, so that the conductive pads are aligned on the first level stage of the first layer 11 to form a square. The second level stage of the second layer 12 is also in the form of four straight bands extending in parallel to the four sides of the square-shaped semiconductor package 1. Each of the four straight bands of the second level stage of the second layer 12 has dual alignments of conductive pads which extend along the straight band, so that the conductive pads are aligned on the second level stage of the second layer 12 to form a square. The third level stage of the third layer 13 is in the form of a square. The third level stage of the third layer 13 has four of dual alignments of conductive pads which extend along four sides of the square-shaped third layer 13 respectively so that the conductive pads are aligned on the peripheral region of the square-shaped third layer 13. Each of the dual alignments extends along the each side of the square-shaped third level stage. The conductive pads on the inner one of the dual alignments are positioned to be displaced from the conductive pads on the outer one of the dual alignments by a half of a pitch of the conductive pads, so that the solder ball on each of the conductive pads on the inner one of the dual alignments is connected to an interconnection which extends in a straight through an intermediate point between adjacent two of the conductive pads on the outer one of the dual alignments. As a result, the conductive pads are aligned on the mounting surface of the semiconductor package 1 to form three sets of dual squares which are, however, different in level. The dual square alignments of the conductive pads on the first level stage have a bottom level of the mounting surface of the semiconductor package 1. The dual square alignments of the conductive pads on the first level stage have an intermediate level of the mounting surface of the semiconductor package 1. The dual square alignments of the conductive pads on the first level stage have a top level of the mounting surface of the semiconductor package 1. Solder balls 20 as ball bumps are provided on the individual conductive pads, whereby the alignments of the solder balls 20 form triple sets of dual squares which are, however, different in level. The outer dual squares of the alignments of the solder balls 20 have a bottom level of the mounting surface of the semiconductor package 1. The intermediate dual squares of the alignments of the solder balls 20 have an intermediate level of the mounting surface of the semiconductor package 1. The inner dual squares of the alignments of the solder balls 20 have a top level of the mounting surface of the semiconductor package 1. The difference in level of the triple sets of the dual squares of the conductive pads or the solder balls 20 results in that individuals of the conductive pads and the solder balls 20 have outside free spaces which are positioned outside thereof and free of any obstacle to allow interconnections to lead out of the solder balls 20 outwardly or toward the individual sides of the square shaped semiconductor package 1 with keeping those individual levels.

The above described semiconductor package 1 is mounted onto a multilayer mounting substrate which has a multistage structure comprising first, second and third level stages. The multilayer mounting substrate used in this embodiment has the dual alignment structure in correspondence with the semiconductor package 1. Each of the first, second and third level stages has dual squares of conductive pad alignments. Each side of the each square-shaped stage has dual alignments of the conductive pads along each side of the slopes, wherein the dual alignments comprise outer and inner alignments of the conductive pads. The conductive pads on the inner alignment are positioned to be displaced from the conductive pads on the outer alignment by a half pitch of the conductive pads, so that each of the interconnections connected to the conductive pads on the inner alignment extend through an intermediate between the adjacent two of the conductive pads on the outer alignment.

The above described semiconductor package 1 is mounted onto the multilayer mounting substrate. The first level stage of the first layer 11 of the semiconductor package 1 corresponds in size in plane view, shape and position to the first level stage of the first mounting substrate of the multilayer mounting substrate. The first slope of the semiconductor package 1 also corresponds in size in plane view, shape and position to the first step of the multilayer mounting substrate. The second level stage of the second layer 12 of the semiconductor package 1 also corresponds in size in plane view, shape and position to the second level stage of the second mounting substrate of the multilayer mounting substrate. The second slope of the semiconductor package 1 also corresponds in size in plane view, shape and position to the second step of the multilayer mounting substrate. The third level stage of the third layer 13 of the semiconductor package 1 also corresponds in size in plane view, shape and position to the third level stage of the third mounting substrate of the multilayer mounting substrate.

Further, the first level conductive pads on the larger square-formed dual alignments on the first level stage of the first layer 11 of the semiconductor package 1 further correspond in position to the first level conductive pads on the larger square-formed dual alignments on the first level stage of the first mounting substrate of the multilayer mounting substrate. Namely, the first level solder balls 20 on the larger square-formed dual alignments on the first level stage of the first layer 11 of the semiconductor package 1 further correspond in position to the first level conductive pads on the larger square-formed alignments on the first level stage of the first mounting substrate of the multilayer mounting substrate. Further, the second level conductive pads on the intermediate square-formed dual alignments on the second level stage of the second layer 12 of the semiconductor package 1 further correspond in position to the second level conductive pads on the intermediate square-formed alignments on the second level stage of the second mounting substrate of the multilayer mounting substrate. Namely, the second level solder balls 20 on the intermediate square-formed dual alignments on the second level stage of the second layer 12 of the semiconductor package 1 further correspond in position to the second level conductive pads on the intermediate square-formed alignments on the second level stage of the second mounting substrate of the multilayer mounting substrate. Further, the third level conductive pads on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate. Namely, the third level solder balls 20 on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate.

Consequently, if the semiconductor package 1 is mounted onto the multilayer mounting substrate, then the first level solder balls 20 of the semiconductor package 1 correspond in level and position to the first level conductive pads of the multilayer mounting substrate, whereby the first level solder balls 20 of the semiconductor package 1 are made into contact with the first level conductive pads of the multilayer mounting substrate, wherein the inner first level solder balls 20 on the inner one of the dual alignments of the semiconductor package 1 are made into contact with the inner first level conductive pads on the inner one of the dual alignments of the multilayer mounting substrate, whilst the outer first level solder balls 20 on the outer one of the dual alignments of the semiconductor package 1 are made into contact with the outer first level conductive pads on the outer one of the dual alignments of the multilayer mounting substrate. Simultaneously, the second level solder balls 20 of the semiconductor package 1 correspond in level and position to the second level conductive pads of the multilayer mounting substrate, whereby the second level solder balls 20 of the semiconductor package 1 are made into contact with the second level conductive pads of the multilayer mounting substrate, wherein the inner second level solder balls 20 on the inner one of the dual alignments of the semiconductor package 1 are made into contact with the inner second level conductive pads on the inner one of the dual alignments of the multilayer mounting substrate, whilst the outer second level solder balls 20 on the outer one of the dual alignments of the semiconductor package 1 are made into contact with the outer second level conductive pads on the outer one of the dual alignments of the multilayer mounting substrate. Further simultaneously, the third level solder balls 20 of the semiconductor package 1 correspond in level and position to the third level conductive pads of the multilayer mounting substrate, whereby the third level solder balls 20 of the semiconductor package 1 are made into contact with the third level conductive pads of the multilayer mounting substrate, wherein the inner third level solder balls 20 on the inner one of the dual alignments of the semiconductor package 1 are made into contact with the inner third level conductive pads on the inner one of the dual alignments of the multilayer mounting substrate, whilst the outer third level solder balls 20 on the outer one of the dual alignments of the semiconductor package 1 are made into contact with the outer third level conductive pads on the outer one of the dual alignments of the multilayer mounting substrate.

As a result, the first level conductive pads of the semiconductor package 1 are electrically connected through the first level solder bumps 20 and the first level conductive pads of the multilayer mounting substrate to the first level interconnections which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads of the multilayer mounting substrate to the second level interconnections which extend outwardly with keeping the second level and in straight lines without, however, leading through between adjacent two of the first level conductive pads which are positioned outside of the second level conductive pads and without making any detour to avoid any obstacle such as the first level conductive pads, for example, by use of any through hole. Furthermore, the third level conductive pads of the semiconductor package 1 are electrically connected through the third level solder bumps 20 and the third level conductive pads of the multilayer mounting substrate to the third level interconnections which extend outwardly with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase in the numbers of the slopes and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size of the semiconductor package.

### FIFTH EMBODIMENT :

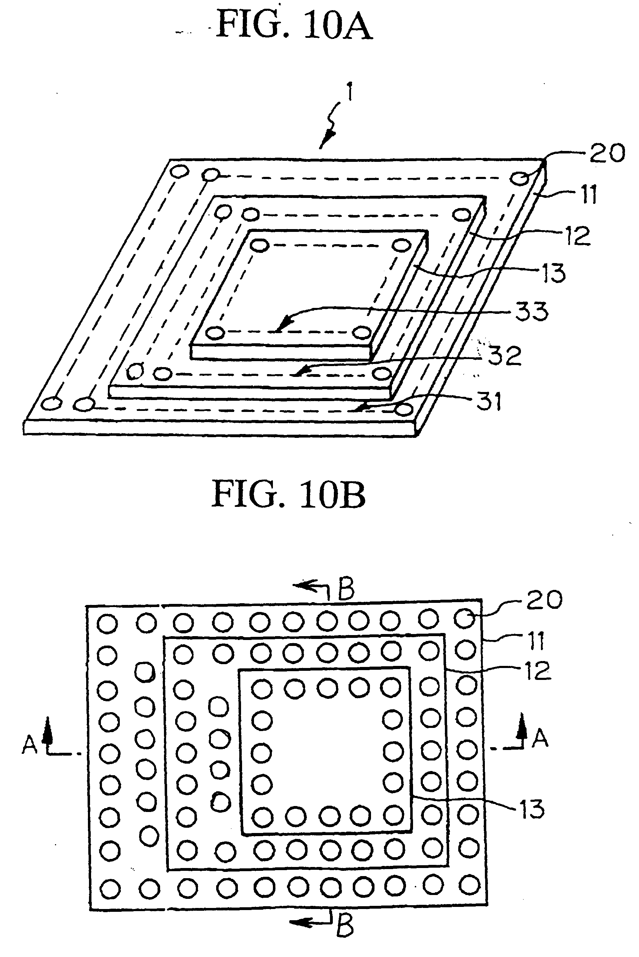

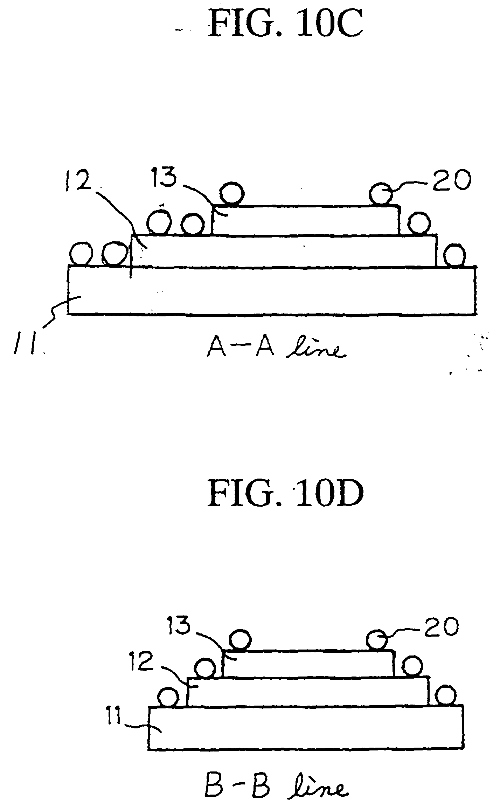

A fifth embodiment according to the present invention will be described in detail with reference to FIGS. 10A, 10B, 10C and 10D, wherein a novel surface mounting type semiconductor package with an improved mounting surface is provided. FIG. 10A is a schematic perspective view illustrative of a novel surface mounting type semiconductor package with an improved mounting surface in a fifth embodiment in accordance with the present invention. FIG. 10B is a schematic plane view illustrative of a novel surface mounting type semiconductor package with an improved mounting surface of FIG. 10A in a fifth embodiment in accordance with the present invention. FIG. 10C is a schematic cross sectional elevation view illustrative of a novel surface mounting type semiconductor package with an improved mounting surface taken along an A-A line of FIG. 10B in a fifth embodiment in accordance with the present invention. FIG. 10D is a schematic cross sectional elevation view illustrative of a novel surface mounting type semiconductor package with an improved mounting surface taken along a B-B line of FIG. 10B in a fifth embodiment in accordance with the present invention.

In this fifth embodiment, the novel surface mounting type semiconductor package 1 has an improved mounting surface which comprises first, second third level stages bounded by first and second steps which are eccentric and symmetrical in a first direction but asymmetrical in a second direction perpendicular to the first direction. One side of the square-shaped semiconductor package 1 has the dual alignment structure as in the second embodiment, whilst the remaining three sides of the square-shaped semiconductor package 1 has the single alignment structure as in the first embodiment. On the one side of each of the first and second square-shaped stages of the semiconductor package, the dual alignment structure comprises outer and inner alignments of the conductive pads. The conductive pads on the inner one of the dual alignments are positioned to be displaced from the conductive pads on the outer one of the dual alignments by a half of a pitch of the conductive pads, so that the solder ball on each of the conductive pads on the inner one of the dual alignments is connected to an interconnection which extends in a straight through an intermediate point between adjacent two of the conductive pads on the outer one of the dual alignments. In correspondence with the dual alignment structure, the mounting surface of the multilayer mounting substrate is structurally changed to form dual alignments of the conductive pads on the corresponding one side. This fifth embodiment will be described in detail with reference to FIGS. 10A, 10B, 10C and 10D.

The novel surface mounting type semiconductor package 1 has an improved mounting surface with steps. The novel surface mounting type semiconductor package 1 comprises laminations of first, second and third layers 11, 12 and 13, wherein the first, second and third layers 11, 12and 13 are square-shaped but are different in size in plane view. The first layer 11 has a largest size in plane view. The second layer 12 has a middle size in plane view. The third layer 13 has a smallest size in plane view. The size in plane view differences among the first, second and third layers 11, 12 and 13 result in formation of a first step between a first level stage of the first layer 11 and a second level stage of the second layer 12, and a second step between the second level stage of the second layer 12 and a third level stage of the third layer 13. The first level stage of the first layer 11 is defined by a peripheral region of a top surface of the first layer 11, wherein the peripheral region of the first layer 11 is not overlaid by the second layer 12. The second level stage of the second layer 12 is defined by a peripheral region of a top surface of the second layer 12, wherein the peripheral region of the second layer 12 is not overlaid by the third layer 13. The third level stage of the third layer 13 is defined by a top surface of the third layer 13. The mounting surface of the surface mounting type semiconductor package 1 has a multi-stage structure which comprises the first level stage, the second level stage and the third level stage, wherein the second level stage is surrounded by the rust level stage and also is bounded by the first step from the first level stage, whilst the third level stage is surrounded by the second level stage and also is bounded by the second step from the second level stage.

The first level stage of the first layer 11 is in the form of four straight bands extending along four sides of the squared semiconductor package 1, wherein one of the four sides has a wider straight band than those of the remaining three sides. One side of the four straight bands of the first level stage of the first layer 11 has the dual alignment structure which comprises dual alignments of the conductive pads, for example, an outer alignment and an inner alignment. The conductive pads on the inner alignment are positioned to be displaced from the conductive pads on the outer alignment by a half pitch of the conductive pads. The conductive pads on the inner alignment may be connected through solder balls to interconnections which extend in a straight form through intermediate points between individual pairs of two adjacent of the conductive pads on the outer alignment. Each of the remaining three straight bands of the first level stage of the first layer 11 has a single alignment of conductive pads which extends along the straight band, so that the conductive pads are aligned on the first level stage of the first layer 11 to form a square. The second level stage of the second layer 12 is also in the form of four straight bands extending in parallel to the four sides of the square-shaped semiconductor package 1, wherein one of the four sides has a wider straight band than those of the remaining three sides. One side of the four straight bands of the first level stage of the first layer 11 has the dual alignment structure which comprises dual alignments of the conductive pads, for example, an outer alignment and an inner alignment. The conductive pads on the inner alignment are positioned to be displaced from the conductive pads on the outer alignment by a half pitch of the conductive pads. The conductive pads on the inner alignment may be connected through solder balls to interconnections which extend in a straight form through intermediate points between individual pairs of two adjacent of the conductive pads on the outer alignment. Each of the remaining three straight bands of the second level stage of the second layer 12 has a single alignment of conductive pads which extends along the straight band, so that the conductive pads are aligned on the second level stage of the second layer 12 to form a square. The third level stage of the third layer 13 is in the form of a square. The third level stage of the third layer 13 has four alignments of conductive pads which extend along four sides of the square-shaped third layer 13 respectively so that the conductive pads are aligned on the peripheral region of the square-shaped third layer 13. As a result, the conductive pads are aligned on the mounting surface of the semiconductor package 1 to form triple modified-squares which are, however, different in level. The outer modified-square of the three single alignments and one dual alignment of the conductive pads has a bottom level of the mounting surface of the semiconductor package 1. The intermediate modified-square of the three single alignments and one dual alignment of the conductive pads has an intermediate level of the mounting surface of the semiconductor package 1. The inner modified-square of the three single alignments and one dual alignment of the conductive pads has a top level of the mounting surface of the semiconductor package 1. Solder balls 20 as ball bumps are provided on the individual conductive pads, whereby the alignments of the solder balls 20 form triple modified-squares which are, however, different in level. The outer modified-square of the three single alignments and one dual alignments of the solder balls 20 has a bottom level of the mounting surface of the semiconductor package 1. The intermediate modified-square of the three single alignments and one dual alignments of the solder balls 20 has an intermediate level of the mounting surface of the semiconductor package 1. The inner modified-square of the three single alignments and one dual alignments of the solder balls 20 has a top level of the mounting surface of the semiconductor package 1. The difference in level of the triple modified-squares of the conductive pads or the solder balls 20 results in that individuals of the conductive pads and the solder balls 20 have outside free spaces which are positioned outside thereof and free of any obstacle to allow interconnections to lead out of the solder balls 20 outwardly or toward the individual sides of the square shaped semiconductor package 1 with keeping those individual levels.

The above described semiconductor package 1 is mounted onto a multilayer mounting substrate which has a mounting surface which is modified to correspond to the above modified mounting surface of the semiconductor package 1. The other structures of the mounting substrate are the same as the first embodiment.

The above described semiconductor package 1 is mounted onto the multilayer mounting substrate. The first level stage of the first layer 11 of the semiconductor package 1 corresponds in size in plane view, shape and position to the first level stage of the first mounting substrate of the multilayer mounting substrate. The first step of the semiconductor package 1 also corresponds in size in plane view, shape and position to the first step of the multilayer mounting substrate. The second level stage of the second layer 12 of the semiconductor package 1 also corresponds in size in plane view, shape and position to the second level stage of the second mounting substrate of the multilayer mounting substrate. The second step of the semiconductor package 1 also corresponds in size in plane view, shape and position to the second step of the multilayer mounting substrate. The third level stage of the third layer 13 of the semiconductor package 1 also corresponds in size in plane view, shape and position to the third level stage of the third mounting substrate of the multilayer mounting substrate.

Further, the first level conductive pads on the larger square-formed alignments on the first level stage of the first layer 11 of the semiconductor package 1 further correspond in position to the first level conductive pads on the larger modified-square-formed alignments on the first level stage of the first mounting substrate of the multilayer mounting substrate. Namely, the first level solder balls 20 on the larger modified-square-formed alignments on the first level stage of the first layer 11 of the semiconductor package 1 further correspond in position to the first level conductive pads on the larger modified-square-formed alignments on the first level stage of the first mounting substrate of the multilayer mounting substrate. Further, the second level conductive pads on the intermediate square-formed alignments on the second level stage of the second layer 12 of the semiconductor package 1 further correspond in position to the second level conductive pads on the intermediate modified-square-formed alignments on the second level stage of the second mounting substrate 52 of the multilayer mounting substrate. Namely, the second level solder balls 20 on the intermediate modified-square-formed alignments on the second level stage of the second layer 12 of the semiconductor package 1 further correspond in position to the second level conductive pads on the intermediate modified-square-formed alignments on the second level stage of the second mounting substrate of the multilayer mounting substrate.

Further, the third level conductive pads on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate. Namely, the third level solder balls 20 on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate.

Consequently, if the semiconductor package 1 is mounted onto the multilayer mounting substrate, then the first level solder balls 20 of the semiconductor package 1 correspond in level and position to the first level conductive pads of the multilayer mounting substrate, whereby the first level solder balls 20 of the semiconductor package 1 are made into contact with the first level conductive pads of the multilayer mounting substrate. Simultaneously, the second level solder balls 20 of the semiconductor package 1 correspond in level and position to the second level conductive pads of the multilayer mounting substrate, whereby the second level solder balls 20 of the semiconductor package 1 are made into contact with the second level conductive pads of the multilayer mounting substrate. Further simultaneously, the third level solder balls 20 of the semiconductor package 1 correspond in level and position to the third level conductive pads of the multilayer mounting substrate, whereby the third level solder balls 20 of the semiconductor package 1 are made into contact with the third level conductive pads of the multilayer mounting substrate.

As a result, the first level conductive pads of the semiconductor package 1 are electrically connected through the first level solder bumps 20 and the first level conductive pads of the multilayer mounting substrate to the first level interconnections which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads of the multilayer mounting substrate to the second level interconnections which extend outwardly with keeping the second level and in straight lines without, however, leading through between adjacent two of the first level conductive pads which are positioned outside of the second level conductive pads and without making any detour to avoid any obstacle such as the first level conductive pads, for example, by use of any through hole. Furthermore, the third level conductive pads of the semiconductor package 1 are electrically connected through the third level solder bumps 20 and the third level conductive pads of the multilayer mounting substrate to the third level interconnections which extend outwardly with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase in the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size of the semiconductor package.

### SIXTH EMBODIMENT :

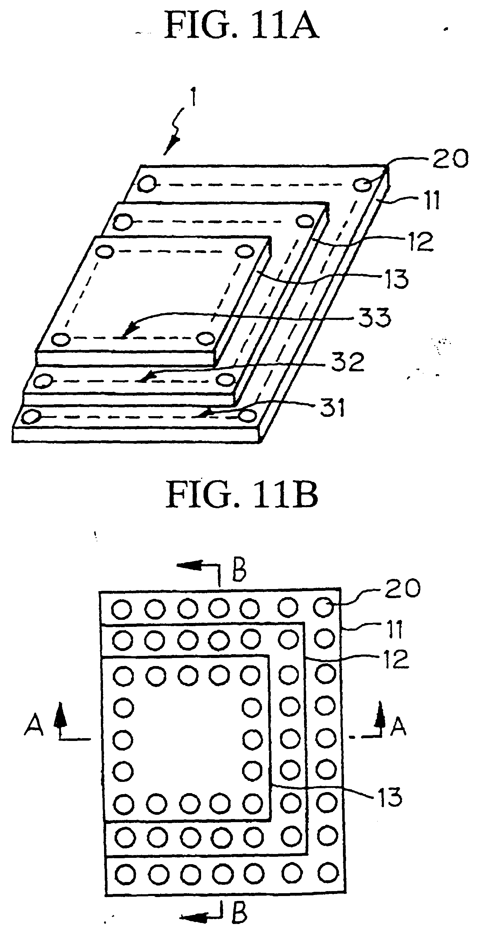

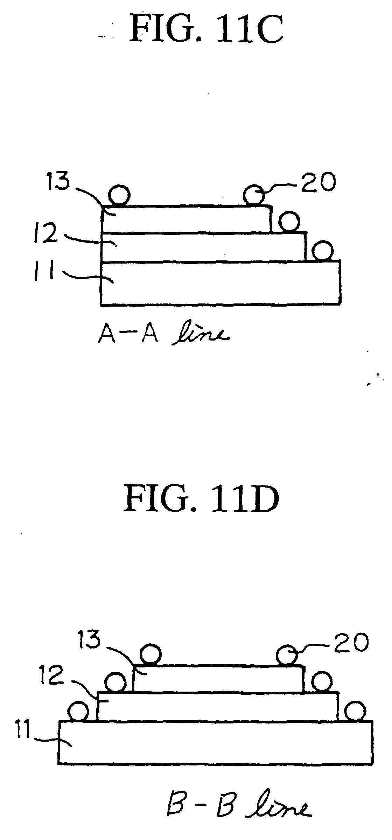

A sixth embodiment according to the present invention will be described in detail with reference to FIGS. 11A, 11B, 11C and 11D, wherein a novel surface mounting type semiconductor package with an improved mounting surface is provided. FIG. 11A is a schematic perspective view illustrative of a novel surface mounting type semiconductor package with an improved mounting surface in a sixth embodiment in accordance with the present invention. FIG. 11B is a schematic plane view illustrative of a novel surface mounting type semiconductor package with an improved mounting surface of FIG. 11A in a sixth embodiment in accordance with the present invention. FIG. 11C is a schematic cross sectional elevation view illustrative of a novel surface mounting type semiconductor package with an improved mounting surface taken along an A-A line of FIG. 11B in a sixth embodiment in accordance with the present invention. FIG. 11D is a schematic cross sectional elevation view illustrative of a novel surface mounting type semiconductor package with an improved mounting surface taken along a B-B line of FIG. 11B in a sixth embodiment in accordance with the present invention.

In this sixth embodiment, the novel surface mounting type semiconductor package 1 has an improved mounting surface which comprises first, second third level stages bounded by first and second steps which are eccentric and symmetrical in a first direction but asymmetrical in a second direction perpendicular to the first direction. The first and second level stages does not extend onto one side of the rectangular-shaped semiconductor package 1, whilst the third level stage has a square-shape. Namely, one side of the rectangular-shaped semiconductor package 1 has no first level conductive pad nor second level conductive pad, but a single alignment of third level conductive pad on the third level stage. The remaining three sides of the rectangular-shaped semiconductor package 1 has the single alignment structure as in the first embodiment, so that the first and second level stages have U-shaped bands, wherein the first and second level stages does not extend on the one side of the rectangular-shaped semiconductor package 1. In correspondence with the dual alignment structure, the mounting surface of the multilayer mounting substrate is structurally changed to form dual alignments of the conductive pads on the corresponding one side. This fifth embodiment will be described in detail with reference to FIGS. 11A, 11B, 11C and 11D.

The novel surface mounting type semiconductor package 1 has an improved mounting surface with steps. The novel surface mounting type semiconductor package 1 comprises laminations of first, second and third layers 11, 12 and 13, wherein the first and second layers 11 and 12 are rectangular-shaped whilst the third layer 13 is square-shaped. The first, second and third layers 11, 12 and 13 are different in size in plane view. The first layer 11 has a largest size in plane view. The second layer 12 has a middle size in plane view. The third layer 13 has a smallest size in plane view. The size in plane view differences among the first, second and third layers 11, 12 and 13 result in formation of a first U-shaped step between a first U-shaped stage of the first layer 11 and a second U-shaped stage of the second layer 12, and a second U-shaped step between the U-shaped second level stage of the second layer 12 and a third square-shaped stage of the third layer 13. The first U-shaped stage of the first layer 11 is defined by a U-shaped peripheral region of a top surface of the first layer 11, wherein the peripheral region of the first layer 11 is not overlaid by the second layer 12. The second U-shaped stage of the second layer 12 is defined by a U-shaped peripheral region of a top surface of the second layer 12, wherein the U-shaped peripheral region of the second layer 12 is not overlaid by the third layer 13. The third square-shaped stage of the third layer 13 is defined by a top surface of the third layer 13. The mounting surface of the surface mounting type semiconductor package 1 has a multi-stage structure which comprises the first U-shaped stage, the second U-shaped stage and the third square-shaped stage, wherein the second U-shaped stage is surrounded by the first U-shaped stage and also is bounded by the first U-shaped step from the first level stage, whilst the third square-shaped stage is surrounded by the second U-shaped stage and also is bounded by the second U-shaped step from the second U-shaped stage.

The first U-shaped stage of the first layer 11 is in the form of three straight bands extending along three sides of the rectangular-shaped semiconductor package 1. One side of the semiconductor package 1 has no existence of the first U-shaped stage nor existence of the second level stage, for which reason the one side of the semiconductor package 1 has a single alignment on the third level stage. Each of the three straight bands of the first U-shaped stage of the first layer 11 has a single alignment of conductive pads which extends along the straight band, so that the conductive pads are aligned on the first level stage of the first layer 11 to form a U-shape. The second U-shaped stage of the second layer 12 is also in the form of three straight bands extending in parallel to the three sides of the rectangular-shaped semiconductor package 1. Each of the three straight bands of the second U-shaped stage of the second layer 12 has a single alignment of conductive pads which extends along the straight band, so that the conductive pads are aligned on the second U-shaped stage of the second layer 12 to form a U-shape. The third level stage of the third layer 13 is in the form of a square. The third level stage of the third layer 13 has four alignments of conductive pads which extend along four sides of the square-shaped third layer 13 respectively so that the conductive pads are aligned on the peripheral region of the square-shaped third layer 13. As a result, the conductive pads are aligned on the mounting surface of the semiconductor package 1 to form a single square and two U-shapes surrounding the single square which are, however, different in level. The outer U-shape of the three single alignments of the conductive pads has a bottom level of the mounting surface of the semiconductor package 1. The intermediate U-shape of the three single alignments of the conductive pads has an intermediate level of the mounting surface of the semiconductor package 1. The inner square of the four single alignments of the conductive pads has a top level of the mounting surface of the semiconductor package 1. Solder balls 20 as ball bumps are provided on the individual conductive pads, whereby the alignments of the solder balls 20 form the single square and two U-shapes which are, however, different in level. The outer U-shape of the three single alignments of the solder balls 20 has a bottom level of the mounting surface of the semiconductor package 1. The intermediate U-shape of the three single alignments of the solder balls 20 has an intermediate level of the mounting surface of the semiconductor package 1. The inner square of the four single alignments of the solder balls 20 has a top level of the mounting surface of the semiconductor package 1. The difference in level of the single square and two U-shapes of the conductive pads or of the solder balls 20 results in that individuals of the conductive pads and the solder balls 20 have outside free spaces which are positioned outside thereof and free of any obstacle to allow interconnections to lead out of the solder balls 20 outwardly or toward the individual sides of the rectangular shaped semiconductor package 1 with keeping those individual levels.

The above described semiconductor package 1 is mounted onto a multilayer mounting substrate which has a mounting surface which is modified to correspond to the above modified mounting surface of the semiconductor package 1. The other structures of the mounting substrate are the same as the first embodiment.

The above described semiconductor package 1 is mounted onto the multilayer mounting substrate. The first level stage of the first layer 11 of the semiconductor package 1 corresponds in size in plane view, shape and position to the first level stage of the first mounting substrate of the multilayer mounting substrate. The first step of the semiconductor package 1 also corresponds in size in plane view, shape and position to the first step of the multilayer mounting substrate. The second level stage of the second layer 12 of the semiconductor package 1 also corresponds in size in plane view, shape and position to the second level stage of the second mounting substrate of the multilayer mounting substrate. The second step of the semiconductor package 1 also corresponds in size in plane view, shape and position to the second step of the multilayer mounting substrate. The third level stage of the third layer 13 of the semiconductor package 1 also corresponds in size in plane view, shape and position to the third level stage of the third mounting substrate of the multilayer mounting substrate.

Further, the first level conductive pads on the larger U-shaped alignments on the first level stage of the first layer 11 of the semiconductor package 1 further correspond in position to the first level conductive pads on the larger U-shaped alignments on the first level stage of the first mounting substrate of the multilayer mounting substrate. Namely, the first level solder balls 20 on the larger U-shaped alignments on the first level stage of the first layer 11 of the semiconductor package 1 further correspond in position to the first level conductive pads on the larger U-shaped alignments on the first level stage of the first mounting substrate of the multilayer mounting substrate. Further, the second level conductive pads on the intermediate U-shaped alignments on the second level stage of the second layer 12 of the semiconductor package 1 further correspond in position to the second level conductive pads on the intermediate U-shaped alignments on the second level stage of the second mounting substrate of the multilayer mounting substrate. Namely, the second level solder balls 20 on the intermediate U-shaped alignments on the second level stage of the second layer 12 of the semiconductor package 1 further correspond in position to the second level conductive pads on the intermediate U-shaped alignments on the second level stage of the second mounting substrate of the multilayer mounting substrate. Further, the third level conductive pads on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate. Namely, the third level solder balls 20 on the smaller square-formed alignments on the third level stage of the third layer 13 of the semiconductor package 1 further correspond in position to the third level conductive pads on the smaller square-formed alignments on the third level stage of the third mounting substrate of the multilayer mounting substrate.

Consequently, if the semiconductor package 1 is mounted onto the multilayer mounting substrate, then the first level solder balls 20 of the semiconductor package 1 correspond in level and position to the first level conductive pads of the multilayer mounting substrate, whereby the first level solder balls 20 of the semiconductor package 1 are made into contact with the first level conductive pads of the multilayer mounting substrate. Simultaneously, the second level solder balls 20 of the semiconductor package 1 correspond in level and position to the second level conductive pads of the multilayer mounting substrate, whereby the second level solder balls 20 of the semiconductor package 1 are made into contact with the second level conductive pads of the multilayer mounting substrate. Further simultaneously, the third level solder balls 20 of the semiconductor package 1 correspond in level and position to the third level conductive pads of the multilayer mounting substrate, whereby the third level solder balls 20 of the semiconductor package 1 are made into contact with the third level conductive pads of the multilayer mounting substrate.

As a result, the first level conductive pads of the semiconductor package 1 are electrically connected through the first level solder bumps 20 and the first level conductive pads of the multilayer mounting substrate to the first level interconnections which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads of the multilayer mounting substrate to the second level interconnections which extend outwardly with keeping the second level and in straight lines without, however, leading through between adjacent two of the first level conductive pads which are positioned outside of the second level conductive pads and without making any detour to avoid any obstacle such as the first level conductive pads, for example, by use of any through hole. Furthermore, the third level conductive pads of the semiconductor package 1 are electrically connected through the third level solder bumps 20 and the third level conductive pads of the multilayer mounting substrate to the third level interconnections which extend outwardly with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple U-shapes of the alignments of the solder balls or the terminals of the semiconductor package by merely increase in the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size of the semiconductor package.

### SEVENTH EMBODIMENT :

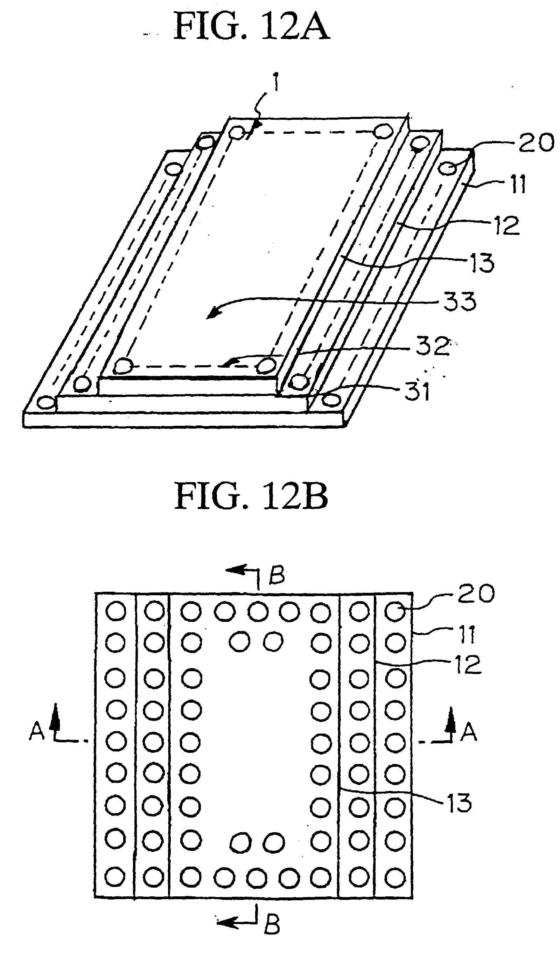

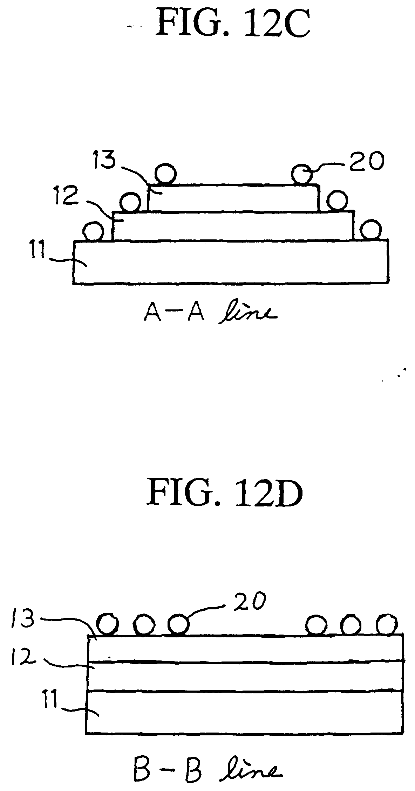

A seventh embodiment according to the present invention will be described in detail with reference to FIGS. 12A, 12B, 12C and 12D, wherein a novel surface mounting type semiconductor package with an improved mounting surface is provided. FIG. 12A is a schematic perspective view illustrative of a novel surface mounting type semiconductor package with an improved mounting surface in a seventh embodiment in accordance with the present invention. FIG. 12B is a schematic plane view illustrative of a novel surface mounting type semiconductor package with an improved mounting surface of FIG. 12A in a seventh embodiment in accordance with the present invention. FIG. 12C is a schematic cross sectional elevation view illustrative of a novel surface mounting type semiconductor package with an improved mounting surface taken along an A-A line of FIG. 12B in a seventh embodiment in accordance with the present invention. FIG. 12D is a schematic cross sectional elevation view illustrative of a novel surface mounting type semiconductor package with an improved mounting surface taken along a B-B line of FIG. 12B in a seventh embodiment in accordance with the present invention.

In this seventh embodiment, the novel surface mounting type semiconductor package 1 has an improved mounting surface which comprises first, second third level stages bounded by first and second steps which are symmetrical in first and second directions perpendicular to the first direction. The first and second level stages extend onto first opposite sides of the square-shaped semiconductor package 1 but does not extend onto second opposite sides, whilst the third level stage has a rectangular-shape. The first opposite sides of the square-shaped semiconductor package 1 are in parallel to the B-B line of FIG. 12B. The second opposite sides of the square-shaped semiconductor package 1 are in parallel to the A-A line of FIG. 12B. Namely, the first level stage of the first layer comprises first level double straight bands which respectively extend along the first opposite sides of the square-shaped semiconductor package 1. One of the first level double straight bands of the first level stage extends along one of the first opposite sides of the square-shaped semiconductor package 1. Another of the first level double straight bands of the first level stage extends along another of the first opposite sides of the square-shaped semiconductor package 1. The second level stage of the second layer also comprises second level double straight bands which respectively extend in parallel to the first opposite sides of the square-shaped semiconductor package 1 and extend inside of the first level double bands of the first level stage. One of the second level double straight bands of the second level stage extends along the inside of the one of the first level double straight bands of the first level stage. Another of the second level double straight bands of the second level stage extends along the inside of the remaining one of the first level double straight bands of the first level stage. The third level stage has a rectangular-shape which is sandwiched by the second level double straight bands of the second level stage. Namely, the second level double straight bands of the second level stage of the second layer extend along outsides of the longitudinal opposite sides of the rectangular-shaped third level stage of the third layer, so that the rectangular-shaped third level stage is sandwiched between the second level double straight bands of the second level stage of the second layer. Each of the first level double straight bands of the first level stage of the first layer has a single alignment of conductive pads extending along the first level straight bands. Each of the second level double straight bands of the second level stage of the second layer has a single alignment of conductive pads extending along the second level straight bands. The rectangular-shaped third level stage of the third layer has two single alignments of the conductive pads which extend along the longitudinal opposite sides of the rectangular-shaped third level stage as well as two dual alignments of the conductive pads which extend along the short opposite sides of the rectangular-shaped third level stage. Each of the dual alignments comprises outer and inner alignments, wherein conductive pads on the inner alignment are positioned to be displaced from the conductive pads on the outer alignment by a half pitch of the conductive pads, so that the conductive pads on the inner alignment are connected through solder balls to interconnections which extend in a straight form outwardly through individual intermediate points between the individual adjacent two of the conductive pads on the outer alignment. In correspondence with the dual alignment structure, the mounting surface of the multilayer mounting substrate is structurally changed to form dual alignments of the conductive pads on the corresponding one side. This fifth embodiment will be described in detail with reference to FIGS. 12A, 12B, 12C and 12D.

The novel surface mounting type semiconductor package 1 has an improved mounting surface with steps. The novel surface mounting type semiconductor package 1 comprises laminations of first, second and third layers 11, 12 and 13, wherein the first and second layers 11 and 12 are square-shaped whilst the third layer 13 is rectangular-shaped. The first, second and third layers 11, 12 and 13 are different in size in plane view. The first layer 11 has a largest size in plane view. The second layer 12 has a middle size in plane view. The third layer 13 has a smallest size in plane view. The size differences among the first, second and third layers 11, 12 and 13 result in formation of first level double straight-shaped steps between the first level double straight-shaped stages of the first layer 11 and second level double straight-shaped stages of the second layer 12, and second level double straight-shaped steps between the second level double straight-shaped stages of the second layer 12 and a third rectangular-shaped stage of the third layer 13 The first level double straight-shaped stages of the first layer 11 are defined by double straight-shaped peripheral opposite side regions of a top surface of the first layer 11, wherein the double straight-shaped peripheral opposite side regions are not overlaid by the second layer 12 and extend along the first opposite sides of the square-shaped semiconductor package 1. The second level double straight-shaped stages of the second layer 12 are defined by double straight-shaped peripheral opposite side regions of a top surface of the second layer 12, wherein the double straight-shaped peripheral opposite side regions are not overlaid by the third layer 13 and extend in parallel to the first opposite sides of the square-shaped semiconductor package 1 and along the insides of the first level double straight-shaped peripheral opposite side regions of the first layer 11. The third level rectangular-shaped stage of the third layer 13 is defined by a top surface of the third layer 13. The third level rectangular-shaped stage of the third layer 13 is sandwiched between the second level double straight shaped stages of the second layer 12, wherein the longitudinal opposite sides of the rectangular-shaped third level stage are adjacent to the inside edges of the second level double straight shaped stages of the second layer 12. The mounting surface of the surface mounting type semiconductor package 1 has a multi-stage structure which comprises the first level double straight-shaped stages, the second level double straight-shaped stages and the third rectangular-shaped stage, wherein the second level double straight-shaped stages are sandwiched by the first level double straight-shaped stages and also are bounded by the first double straight-shaped steps from the first level stages, whilst the third rectangular-shaped stage is sandwiched by the second level double straight-shaped stages and also is bounded by the second double straight-shaped steps from the second double straight-shaped stages.

Each of the first level double straight-shaped stages of the first layer 11 has a single alignment of conductive pads which extends along the straight band, so that the conductive pads are aligned on the first level stages of the first layer 11 to form a double straight-shape. Each of the second level double straight-shaped stages of the second layer 12 has a single alignment of conductive pads which extends along the straight band, so that the conductive pads are aligned on the second level double straight-shaped stage of the second layer 12 to form a double straight-shape. The third level stage of the third layer 13 is in the form of a rectangle. The third level stage of the third layer 13 has two single alignments of conductive pads which extend along the longitudinal opposite sides of the rectangular-shaped third level stage of the third layer 13 as well as two dual alignments of conductive pads which extend along the short opposite sides of the rectangular-shaped third level stage of the third layer 13. Each of the two dual alignments comprises an outer alignment and an inner alignment of the conductive pads, wherein the conductive pads on the inner alignment are positioned to be displaced from the conductive pads on the outer alignment by a half pitch of the conductive pads, so that the conductive pads on the inner alignment are connected through solder balls to interconnections which extend in a straight form through individual intermediate points between individual adjacent two of the conductive pads on the outer alignment. As a result, the conductive pads are aligned on the mounting surface of the semiconductor package 1 to form a single modified rectangle and two double straight-shapes sandwiching the single modified rectangle which are, however, different in level. The outer double straight-shape alignments of the conductive pads have a bottom level of the mounting surface of the semiconductor package 1. The intermediate double straight-shape alignments of the conductive pads has an intermediate level of the mounting surface of the semiconductor package 1. The inner modified rectangle of the two sets of single dual alignments of the conductive pads has a top level of the mounting surface of the semiconductor package 1. Solder balls 20 as ball bumps are provided on the individual conductive pads, whereby the alignments of the solder balls 20 form the single modified rectangle and two double straight-shapes which are, however, different in level. The outer double straight-shape alignments of the solder balls 20 have a bottom level of the mounting surface of the semiconductor package 1. The intermediate double straight-shape alignments of the solder balls 20 have an intermediate level of the mounting surface of the semiconductor package 1. The inner modified rectangle alignment of the solder balls 20 has a top level of the mounting surface of the semiconductor package 1. The difference in level of the single modified rectangle and two double straight-shapes of the conductive pads or of the solder balls 20 results in that individuals of the conductive pads and the solder balls 20 have outside free spaces which are positioned outside thereof and free of any obstacle to allow interconnections to lead out of the solder balls 20 outwardly or toward the individual sides of the square shaped semiconductor package 1 with keeping those individual levels.

The above described semiconductor package 1 is mounted onto a multilayer mounting substrate which has a mounting surface which is modified to correspond to the above modified mounting surface of the semiconductor package 1. The other structures of the mounting substrate are the same as the first embodiment.

The above described semiconductor package 1 is mounted onto the multilayer mounting substrate. The first level stage of the first layer 11 of the semiconductor package 1 corresponds in size in plane view, shape and position to the first level stage of the first mounting substrate of the multilayer mounting substrate. The first step of the semiconductor package 1 also corresponds in size in plane view, shape and position to the first step of the multilayer mounting substrate. The second level stage of the second layer 12 of the semiconductor package 1 also corresponds in size in plane view, shape and position to the second level stage of the second mounting substrate of the multilayer mounting substrate. The second step of the semiconductor package 1 also corresponds in size in plane view, shape and position to the second step of the multilayer mounting substrate. The third level stage of the third layer 13 of the semiconductor package 1 also corresponds in size in plane view, shape and position to the third level stage of the third mounting substrate of the multilayer mounting substrate.

Further, the first level conductive pads on the outer first level double straight-shaped alignments on the first level stage of the first layer 11 of the semiconductor package 1 further correspond in position to the first level conductive pads on the outer first level double straight-shaped alignments on the first level stage of the first mounting substrate of the multilayer mounting substrate. Namely, the first level solder balls 20 on the outer first level double straight-shaped alignments on the first level stage of the first layer 11 of the semiconductor package 1 further correspond in position to the first level conductive pads on the outer first level double straight-shaped alignments on the first level stage of the first mounting substrate of the multilayer mounting substrate. Further, the second level conductive pads on the intermediate second level double straight-shaped alignments on the second level stage of the second layer 12 of the semiconductor package 1 further correspond in position to the second level conductive pads on the intermediate second level double straight-shaped alignments on the second level stage of the second mounting substrate of the multilayer mounting substrate. Namely, the second level solder balls 20 on the intermediate second level double straight-shaped alignments on the second level stage of the second layer 12 of the semiconductor package 1 further correspond in position to the second level conductive pads on the intermediate second level double straight-shaped alignments on the second level stage of the second mounting substrate of the multilayer mounting substrate. Further, the third level conductive pads on the inner rectangular-formed alignments on the third level stage of the third layer 13 of the semiconductor package 1 further correspond in position to the third level conductive pads on the inner rectangular-formed alignments on the third level stage of the third mounting substrate of the multilayer mounting substrate. Namely, the third level solder balls 20 on the inner rectangle-formed alignments on the third level stage of the third layer 13 of the semiconductor package 1 further correspond in position to the third level conductive pads on the smaller rectangular-formed alignments on the third level stage of the third mounting substrate of the multilayer mounting substrate.

Consequently, if the semiconductor package 1 is mounted onto the multilayer mounting substrate, then the first level solder balls 20 of the semiconductor package 1 correspond in level and position to the first level conductive pads of the multilayer mounting substrate, whereby the first level solder balls 20 of the semiconductor package 1 are made into contact with the first level conductive pads of the multilayer mounting substrate. Simultaneously, the second level solder balls 20 of the semiconductor package 1 correspond in level and position to the second level conductive pads of the multilayer mounting substrate, whereby the second level solder balls 20 of the semiconductor package 1 are made into contact with the second level conductive pads of the multilayer mounting substrate. Further simultaneously, the third level solder balls 20 of the semiconductor package 1 correspond in level and position to the third level conductive pads of the multilayer mounting substrate, whereby the third level solder balls 20 of the semiconductor package 1 are made into contact with the third level conductive pads of the multilayer mounting substrate.

As a result, the first level conductive pads of the semiconductor package 1 are electrically connected through the first level solder bumps 20 and the first level conductive pads of the multilayer mounting substrate to the first level interconnections which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads of the multilayer mounting substrate to the second level interconnections which extend outwardly with keeping the second level and in straight lines without, however, leading through between adjacent two of the first level conductive pads which are positioned outside of the second level conductive pads and without making any detour to avoid any obstacle such as the first level conductive pads, for example, by use of any through hole. Furthermore, the third level conductive pads of the semiconductor package 1 are electrically connected through the third level solder bumps 20 and the third level conductive pads of the multilayer mounting substrate to the third level interconnections which extend outwardly with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple double straight-shapes of the alignments of the solder balls or the terminals of the semiconductor package by merely increase in the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size of the semiconductor package.

### EIGHTHTH EMBODIMENT :

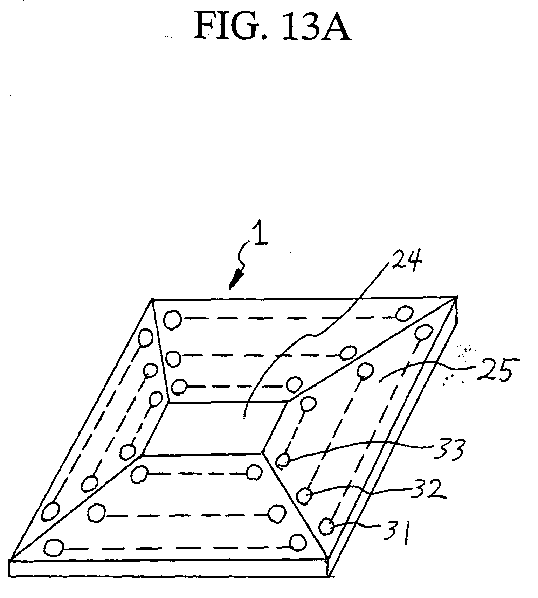

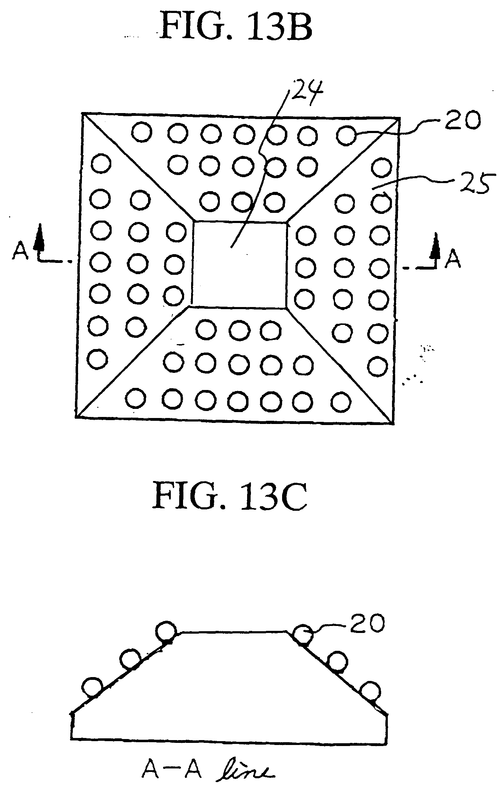

An eighth embodiment according to the present invention will be described in detail with reference to FIGS. 13A, 13B and 13C, wherein a novel surface mounting type semiconductor package with an improved mounting surface is provided. FIG. 13A is a schematic perspective view illustrative of a novel surface mounting type semiconductor package with an improved mounting surface in an eighth embodiment in accordance with the present invention. FIG. 13B is a schematic plane view illustrative of a novel surface mounting type semiconductor package with an improved mounting surface of FIG. 13A in an eighth embodiment in accordance with the present invention. FIG. 13C is a schematic cross sectional elevation view illustrative of a novel surface mounting type semiconductor package with an improved mounting surface taken along an A-A line of FIG. 13B in an eighth embodiment in accordance with the present invention.

In this eighth embodiment, the novel surface mounting type semiconductor package has an improved mounting surface comprising a square-shaped top stage and four down-slopes which extend from individual sides of the square-shaped top stage to individual sides of the square-shaped semiconductor package 1. The square-shaped top stage has no conductive pads. Each of the four down-slopes has triple alignments of conductive pads which extend in parallel to the side of the square-shaped semiconductor package 1 or in parallel to the side of the square-shaped top stage, so that an outer alignment of the conductive pads has a first level, an intermediate alignment of the conductive pads has a second level and an inner alignment of the conductive pads has a third level. As a result, the four down-slopes have triple squares of conductive pad alignments, for example, an outer square of four first level conductive pad alignments, an intermediate square of four second level conductive pad alignments, and an inner square of four third level conductive pad alignments. The above semiconductor package 1 may be mounted onto the same multilayer mounting substrate with steps as in the first embodiment because solder balls are provided on the conductive pads on the four step-free down-slopes and the height of the solder balls may avoid contact between the edges of the steps of the mounting surface of the multilayer mounting substrate and the four down-slopes of the mounting surface of the semiconductor package.

As illustrated in FIGS. 13A, 13B and 13C, a novel surface mounting type semiconductor package 1 has an improved mounting surface free of steps. The improved mounting surface comprises a square-shaped top stage 14 and four down-slopes 25 extending from top four sides of the square-shaped top stage 24 to bottom four sides of the square-shaped semiconductor package 1. The square-shaped top stage 24 is free of conductive pads. Each of the four down-slopes 25 has triple alignments of conductive pads which are different in level from each other. Namely, the each of the four down-slopes 25 has an outer alignment of the conductive pads, an intermediate alignment of the conductive pads and an inner alignment of the conductive pads. The outer alignment of the conductive pads extends in parallel to and along the side of the square-shaped semiconductor package 1 and also has a first level. The intermediate alignment of the conductive pads extends in parallel to the side of the square-shaped semiconductor package 1 and also has a second level. The inner alignment of the conductive pads extends in parallel to and along the side of the square-shaped top stage 24 and also has a third level. The four down-slopes 25 of the mounting surface of the semiconductor package 1 have triple squares, for example, outer, intermediate and inner squares of the alignments of the conductive pads. The outer square comprises four outer conductive pad alignments and has a larger size in plane view. The intermediate square comprises four intermediate conductive pad alignments and has a intermediate size in plane view. The inner square comprises four inner conductive pad alignments and has a smaller size in plane view. The outer square encompasses the intermediate square. The intermediate square encompasses the inner square. Solder balls 20 as ball bumps are provided on the individual conductive pads, whereby the alignments of the solder balls 20 form triple squares which are, however, different in level. The outer square of the four straight alignments of the solder balls 20 has a bottom level of the mounting surface of the semiconductor package 1. The intermediate square of the four straight alignments of the solder balls 20 has an intermediate level of the mounting surface of the semiconductor package 1. The inner square of the four straight alignments of the solder balls 20 has a top level of the mounting surface of the semiconductor package 1. The difference in level of the triple squares of the conductive pads or the solder balls 20 results in that individuals of the conductive pads and the solder balls 20 have outside free spaces which are positioned outside thereof and free of any obstacle to allow interconnections to lead out of the solder balls 20 outwardly or toward the individual sides of the square shaped semiconductor package 1 with keeping those individual levels.

The above described semiconductor package 1 may be mounted onto the same multilayer mounting substrate with steps as in the first embodiment. The height of the solder balls 20 on the four down-slopes 25 prevents contact between the step-free four down-slopes 25 of the mounting surface of the semiconductor package 1 and the stepped multi-stage mounting surface of the multilayer mounting substrate 1.

The above described semiconductor package 1 is mounted onto the multilayer mounting substrate.

The first level conductive pads on the larger square-formed alignments on the four down-slopes 25 of the semiconductor package 1 correspond in position to the first level conductive pads on the larger square-formed alignments on the first level stage of the first mounting substrate of the multilayer mounting substrate. Namely, the first level solder balls 20 on the larger square-formed alignments on the four down-slopes 25 of the semiconductor package 1 correspond in position to the first level conductive pads on the larger square-formed alignments on the first level stage of the first mounting substrate of the multilayer mounting substrate. Further, the second level conductive pads on the intermediate square-formed alignments on the four down-slopes 25 of the semiconductor package 1 correspond in position to the second level conductive pads on the intermediate square-formed alignments on the second level stage of the second mounting substrate of the multilayer mounting substrate. Namely, the second level solder bails 20 on the intermediate square-formed alignments on the four down-slopes 25 of the semiconductor package 1 correspond in position to the second level conductive pads on the intermediate square-formed alignments on the second level stage of the second mounting substrate of the multilayer mounting substrate. Further, the third level conductive pads on the smaller square-formed alignments on the four down-slopes 25 of the semiconductor package 1 correspond in position to the third level conductive pads on the smaller square-formed alignments on the third level stage of the third mounting substrate of the multilayer mounting substrate. Namely, the third level solder balls 20 on the smaller square-formed alignments on the four down-slopes 25 of the semiconductor package 1 correspond in position to the third level conductive pads on the smaller square-formed alignments on the third level stage of the third mounting substrate of the multilayer mounting substrate.

Consequently, if the semiconductor package 1 is mounted onto the multilayer mounting substrate, then the first level solder balls 20 of the semiconductor package 1 correspond in level and position to the first level conductive pads of the multilayer mounting substrate, whereby the first level solder balls 20 of the semiconductor package 1 are made into contact with the first level conductive pads of the multilayer mounting substrate. Simultaneously, the second level solder balls 20 of the semiconductor package 1 correspond in level and position to the second level conductive pads of the multilayer mounting substrate, whereby the second level solder balls 20 of the semiconductor package 1 are made into contact with the second level conductive pads of the multilayer mounting substrate. Further simultaneously, the third level solder balls 20 of the semiconductor package 1 correspond in level and position to the third level conductive pads of the multilayer mounting substrate, whereby the third level solder balls 20 of the semiconductor package 1 are made into contact with the third level conductive pads of the multilayer mounting substrate.

As a result, the first level conductive pads of the semiconductor package 1 are electrically connected through the first level solder bumps 20 and the first level conductive pads of the multilayer mounting substrate to the first level interconnections which extend outwardly with keeping the first level and in straight lines without, however, leading through between adjacent two of the other conductive pads and without making any detour to avoid any obstacle such as other conductive pads. Further, the second level conductive pads of the semiconductor package 1 are electrically connected through the second level solder bumps 20 and the second level conductive pads of the multilayer mounting substrate to the second level interconnections which extend outwardly with keeping the second level and in straight lines without, however, leading through between adjacent two of the first level conductive pads which are positioned outside of the second level conductive pads and without making any detour to avoid any obstacle such as the first level conductive pads, for example, by use of any through hole. Furthermore, the third level conductive pads of the semiconductor package 1 are electrically connected through the third level solder bumps 20 and the third level conductive pads of the multilayer mounting substrate to the third level interconnections which extend outwardly with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size in plane view of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase m the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size in plane view of the semiconductor package.

### NINTH EMBODIMENT :

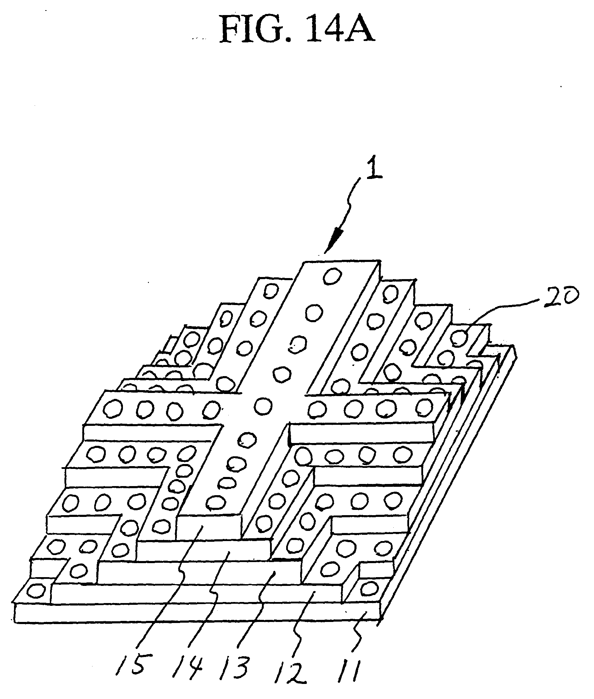

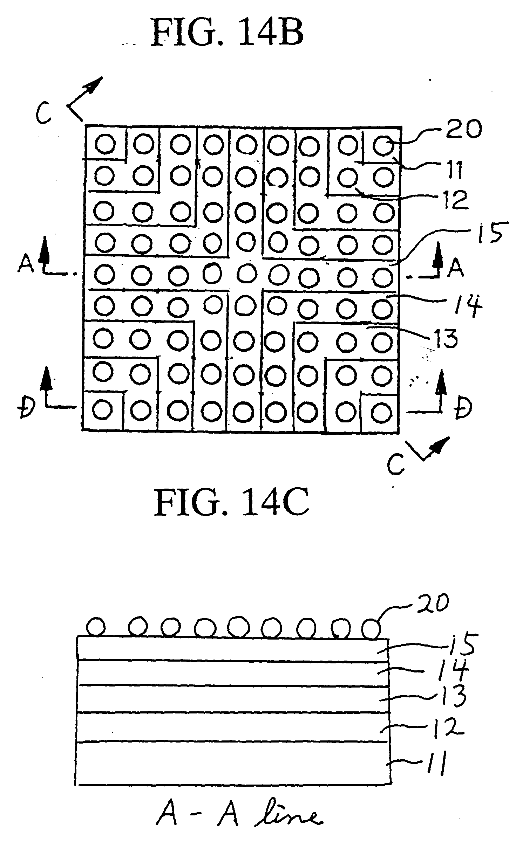

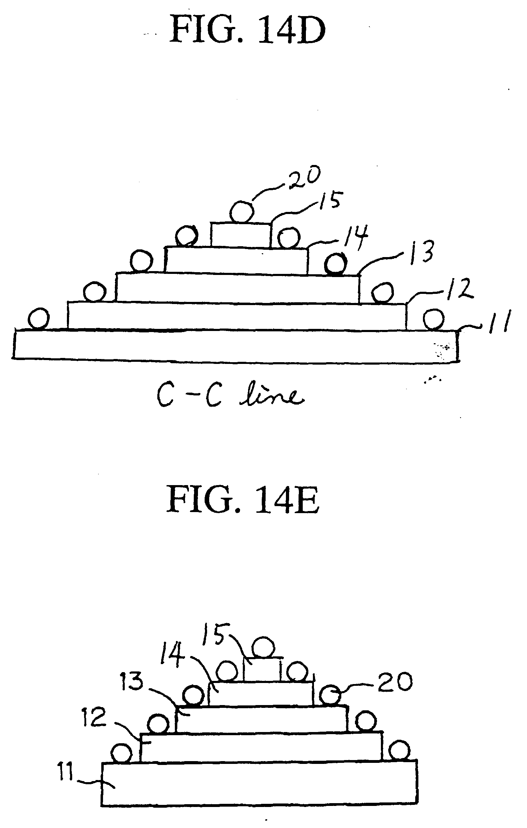

A ninth embodiment according to the present invention will be described in detail with reference to FIGS. 14A, 14B, 14C, 14D and 14E, wherein a novel surface mounting type semiconductor package with an improved mounting surface is provided. FIG. 14A is a schematic perspective view illustrative of a novel surface mounting type semiconductor package with an improved mounting surface in a ninth embodiment in accordance with the present invention. FIG. 14B is a schematic plane view illustrative of a novel surface mounting type semiconductor package with an improved mounting surface of FIG. 14A in a ninth embodiment in accordance with the present invention. FIG. 14C is a schematic cross sectional elevation view illustrative of a novel surface mounting type semiconductor package with an improved mounting surface taken along an A-A line of FIG. 14B in a ninth embodiment in accordance with the present invention. FIG. 14D is a schematic cross sectional elevation view illustrative of a novel surface mounting type semiconductor package with an improved mounting surface taken along a C-C line of FIG. 14B in a ninth embodiment in accordance with the present invention. FIG. 14E is a schematic cross sectional elevation view illustrative of a novel surface mounting type semiconductor package with an improved mounting surface taken along a D-D line of FIG. 14B in a ninth embodiment in accordance with the present invention.

In this embodiment, the novel surface mounting type semiconductor package 1 has an improved mounting surface which has a 9 × 9 full grid array structure of solder balls. The improved mounting surface of the novel surface mounting type semiconductor package 1 comprises five different level stages and four steps bounding those five different level stages. The four steps of the improved mounting surface comprise four sets of first, second, third and fourth level steps which are L-shaped with the right angle in a plane view and face toward each corner of the square-shaped semiconductor package 1. Namely, each of the first, second, third and fourth level steps of each set has two vertical walls and an included right angle corner between the two vertical walls, wherein the included right angle corner is directed toward the corresponding corner of the square-shaped semiconductor package 1, whilst the two vertical walls face toward the two adjacent sides which include that corresponding corner of the square-shaped semiconductor package 1. The first level stage has a first level and is positioned closer to the corner of the square-shaped semiconductor package 1 than the remaining second, third and four stages. This L-shaped first level stage has a smallest size in plane view. The L-shaped second level stage has a second smallest size in plane view. The L-shaped third level stage has a second largest size in plane view. The L-shaped fourth level stage has a largest size in plane view. The first level stage comprises four sets of a square-shaped corner region which are positioned at the four corners of the semiconductor package 1 respectively, so that the four square-shaped corner regions have four conductive pads positioned most closer to the four corners of the semiconductor package 1 respectively. Each of the first level conductive pads on the four square-shaped corner regions as the first level stage is connected through a solder ball to a corresponding first level interconnection which extends outwardly in a diagonal direction of the semiconductor package 1 with keeping the first level. The second level stage comprises four sets of a L-shaped smaller size region which are positioned to surround in two directions the first level square-shaped stages respectively, so that each of the four L-shaped smaller size regions has three conductive pads positioned adjacent to the each fist level conductive pad on the first level stages. Each of the conductive pads on the four L-shaped smaller size regions as the second level stage is connected through a solder ball to a corresponding second level interconnection which extends outwardly in the diagonal direction of the semiconductor package 1 with keeping the second level. The third level stage comprises four sets of a L-shaped intermediate size region which are positioned to surround in two directions the second level square-shaped smaller size stages respectively, so that each of the four L-shaped intermediate size regions has five conductive pads positioned adjacent to the second level stage. Each of the conductive pads on the four L-shaped intermediate size regions as the third level stage is connected through a solder ball to a corresponding third level interconnection which extends outwardly in the diagonal direction of the semiconductor package 1 with keeping the third level. The fourth level stage comprises four sets of a L-shaped larger size region which are positioned to surround in two directions the third level square-shaped smaller size stages respectively, so that each of the four L-shaped larger size regions has seven conductive pads positioned adjacent to the third level stage. Each of the conductive pads on the four L-shaped larger size regions as the fourth level stage is connected through a solder ball to a corresponding fourth level interconnection which extends outwardly in the diagonal direction of the semiconductor package 1 with keeping the fourth level. The fifth level stage comprises a fifth level cross-shaped region which extends on two center lines perpendicular to each other of the square-shaped semiconductor package 1, so as to divide the mounting surface of the square-shaped semiconductor package 1 into four regions, each of which has each set of the first, second, third and fourth level stages. The fifth level cross-shaped region of the fifth, level stage is adjacent to the four L-shaped larger size regions of the fourth level stages, so that the fifth level cross-shaped region has seventeen conductive pads positioned on the two center lines perpendicular to each other and adjacent to the four fourth level stages. Bach of the conductive pads on the fifth level cross-shaped region as the fifth level stage is connected through a solder ball to a corresponding fifth level interconnection which extends outwardly in the diagonal direction of the semiconductor package 1 with keeping the fifth level. This ninth embodiment will subsequently be described in more detail with reference to FIGS. 14A, 14B, 14C, 14D and 14E.

A novel surface mounting type semiconductor package 1 has an improved mounting surface with steps. The novel surface mounting type semiconductor package 1 comprises laminations of first, second, third, fourth and fifth layers 11, 12, 13, 14 and 15. The first layer 11 is square-shaped. The second layer 12 has a modified square shape with four corner smallest size square-shaped recesses. The third layer 13 has a modified square shape with four corner second smallest size square-shaped recesses. The fourth layer 14 has a wide cross-shape defined with four corner second largest size square-shaped recesses. The fifth layer 15 has a slender cross-shape defined with four corner largest size square-shaped recesses. The size differences among the first, second, third, fourth and fifth layers 11, 12, 13, 14 and 15 result in formation of first, second, third and fourth steps. The first step bounds between a first level stage of the first layer 11 and a second level stage of the second layer 12. The second step bounds between the second level stage of the second layer 12 and a third level stage of the third layer 13. The third step bounds between the third level stage of the third layer 13 and a fourth level stage of the fourth layer 14. The fourth step bounds between the fourth level stage of the fourth layer 14 and a fifth level stage of the fifth layer 15. Each of the first level, second level, third level and fourth level steps has two vertical walls and an included right angle corner between the two vertical walls, wherein the included right angle corner is directed toward the corresponding corner of the square-shaped semiconductor package 1, whilst the two vertical walls face toward the two adjacent sides which include that corresponding corner of the square-shaped semiconductor package 1.

The first level stage of the first layer 11 is defined by four sets of a square-shaped corner region which are positioned at the four corners of the semiconductor package 1 respectively, so that the four square-shaped corner regions have four conductive pads positioned most closer to the four corners of the semiconductor package 1 respectively, wherein the four corner square-shaped smallest regions are not overlaid by the second layer 12 and are adjacent to the four corners of the square-shaped semiconductor package 1. Four of the first level conductive pad on the four square-shaped corner regions of the first level stage of the first layer 11 are positioned to form four corner points. The second level stage of the second layer 12 is defined by four sets of a L-shaped smaller size region which are positioned to surround in two directions the first level square-shaped stages respectively, so that each of the four L-shaped smaller size regions has three conductive pads positioned adjacent to the each fist level conductive pad on the first level stages, wherein the four L-shaped smaller size regions of the second layer 12 are not overlaid by the third layer 13. Twelve of the second level conductive pad on the four L-shaped smaller size regions of the second level stage of the second layer 12 are aligned to form four smaller size L-shapes which face toward the four corners of the square-shaped semiconductor package 1 and surround in two directions the individual four corner points of the first level conductive pads. The third level stage of the third layer 13 is defined by four sets of a L-shaped intermediate size region which are positioned to surround in two directions the second level square-shaped smaller size stages respectively, so that each of the four L-shaped intermediate size regions has five conductive pads positioned adjacent to the second level stage, wherein the four L-shaped intermediate size regions of the third layer 13 are not overlaid by the fourth layer 14. Twenty of the third level conductive pad on the four L-shaped intermediate size regions of the third level stage of the third layer 13 are aligned to form four intermediate size L-shapes facing toward the four corners of the square-shaped semiconductor package 1 and surround in two directions the individual four smaller size L-shapes of the second level conductive pads. The fourth level stage of the fourth layer 14 is defined by four sets of a L-shaped larger size region which are positioned to surround in two directions the third level square-shaped smaller size stages respectively, so that each of the four L-shaped larger size regions has seven conductive pads positioned adjacent to the third level stage, wherein the four L-shaped larger size regions of the fourth layer 14 are not overlaid by the fifth layer 15. Twenty eight of the fourth level conductive pad on the four L-shaped lager size regions of the fourth level stage of the fourth layer 14 are aligned to form four larger size L-shapes facing toward the four corners of the square-shaped semiconductor package 1 and surround in two directions the individual four intermediate size L-shapes of the third level conductive pads. The fifth level stage of the fifth layer 15 is defined by a fifth level cross-shaped region which extends on two center lines perpendicular to each other of the square-shaped semiconductor package 1, so as to divide the mounting surface of the square-shaped semiconductor package 1 into four regions, each of which has each set of the first, second, third and fourth level stages. The fifth level cross-shaped region of the fifth level stage is adjacent to the four L-shaped larger size regions of the fourth level stage, so that the fifth level cross-shaped region has seventeen conductive pads positioned on the two center lines perpendicular to each other and adjacent to the four fourth level stages. Seventeen of the fifth level conductive pad on the cross-shaped region of the fifth level stage of the fifth layer 15 are aligned to form a single cross-shape extending on two center lines perpendicular to each other of the square-shaped semiconductor package 1.

The first level stage is most closer to the each corner of the square-shaped semiconductor package 1. The second level stage is second closer to the each corner of the square-shaped semiconductor package 1. The third level stage is third closer to the each corner of the square-shaped semiconductor package 1. The fourth level stage is fourth closer to the each corner of the square-shaped semiconductor package 1. The first level conductive pad alignments of the first level stage are most closer to the each corner of the square-shaped semiconductor package 1. The second level conductive pad alignments of second level stage are second closer to the each corner of the square-shaped semiconductor package 1. The third level conductive pad alignments of third level stage are third closer to the each corner of the square-shaped semiconductor package 1. The fourth level conductive pad alignments of fourth level stage are fourth closer to the each corner of the square-shaped semiconductor package 1.

The first level, second level, third level, fourth level and fifth level stages form 9 × 9 full-grid arrays of the conductive pads. Solder balls 20 are further provided on the 9 × 9 full-grid arrays of the conductive pads. Each of the first level conductive pads on the four square-shaped corner regions as the first level stage of the first layer 11 is connected through the solder ball 20 to a corresponding first level interconnection which extends outwardly in a diagonal direction of the semiconductor package 1 with keeping the first level. Each of the conductive pads on the four L-shaped smaller size regions as the second level stage of the second layer 12 is connected through the solder ball 20 to a corresponding second level interconnection which extends outwardly in the diagonal direction of the semiconductor package 1 with keeping the second level. Each of the conductive pads on the four L-shaped intermediate size regions as the third level stage of the third layer 13 is connected through the solder ball 20 to a corresponding third level interconnection which extends outwardly in the diagonal direction of the semiconductor package 1 with keeping the third level. Each of the conductive pads on the four L-shaped larger size regions as the fourth level stage of the fourth layer 14 is connected through the solder ball 20 to a corresponding fourth level interconnection which extends outwardly in the diagonal direction of the semiconductor package 1 with keeping the fourth level. Each of the conductive pads on the fifth level cross-shaped region as the fifth level stage of the fifth layer 15 is connected through the solder ball 20 to a corresponding fifth level interconnection which extends outwardly in the diagonal direction of the semiconductor package 1 with keeping the fifth level.

The above described semiconductor package 1 is mounted onto a multilayer mounting substrate having a modified mounting surface which was modified in correspondence with the above mounting surface of the semiconductor package 1. The first level conductive pads on the first level stage of the first layer 11 of the semiconductor package 1 are electrically connected through the first level solder bumps 20 and the first level conductive pads of the multilayer mounting substrate to the first level interconnections which extend outwardly in the diagonal directions with keeping the first level and in straight lines without, however, leading through between adjacent two of the other conductive pads and without making any detour to avoid any obstacle such as other conductive pads. Further, the second level conductive pads on the second level stage of the second layer 12 of the semiconductor package 1 are electrically connected through the second level solder bumps 20 and the second level conductive pads of the multilayer mounting substrate to the second level interconnections which extend outwardly in the diagonal directions with keeping the second level and in straight lines without, however, leading through between adjacent two of the first level conductive pads which are positioned outside of the second level conductive pads and without making any detour to avoid any obstacle such as the first level conductive pads 44, for example, by use of any through hole. Furthermore, the third level conductive pads on the third level stage of the third layer 13 of the semiconductor package 1 are electrically connected through the third level solder bumps 20 and the third level conductive pads of the multilayer mounting substrate to the third level interconnections which extend outwardly in the diagonal directions with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole. Still more, the fourth level conductive pads on the fourth level stage of the fourth layer 14 of the semiconductor package 1 are electrically connected through the fourth level solder bumps 20 and the fourth level conductive pads of the multilayer mounting substrate to the fourth level interconnections which extend outwardly in the diagonal directions with keeping the fourth level and in straight lines without, however, leading through between adjacent two of the first level or second level or third level conductive pads which are positioned outside of the fourth level conductive pads and without making any detour to avoid any obstacle such as the first level or second level or third level conductive pads, for example, by use of any through hole. Moreover, the fifth level conductive pads on the fifth level stage of the fifth layer 15 of the semiconductor package 1 are electrically connected through the fifth level solder bumps 20 and the fifth level conductive pads of the multilayer mounting substrate to the fifth level interconnections which extend outwardly in the diagonal directions with keeping the fifth level and in straight lines without, however, leading through between adjacent two of the first level or second level or third level or fourth level conductive pads which are positioned outside of the fifth level conductive pads and without making any detour to avoid any obstacle such as the first level or second level or third level or fourth level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size in plane view of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase in the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size in plane view of the semiconductor package.

### TENTH EMBODIMENT :

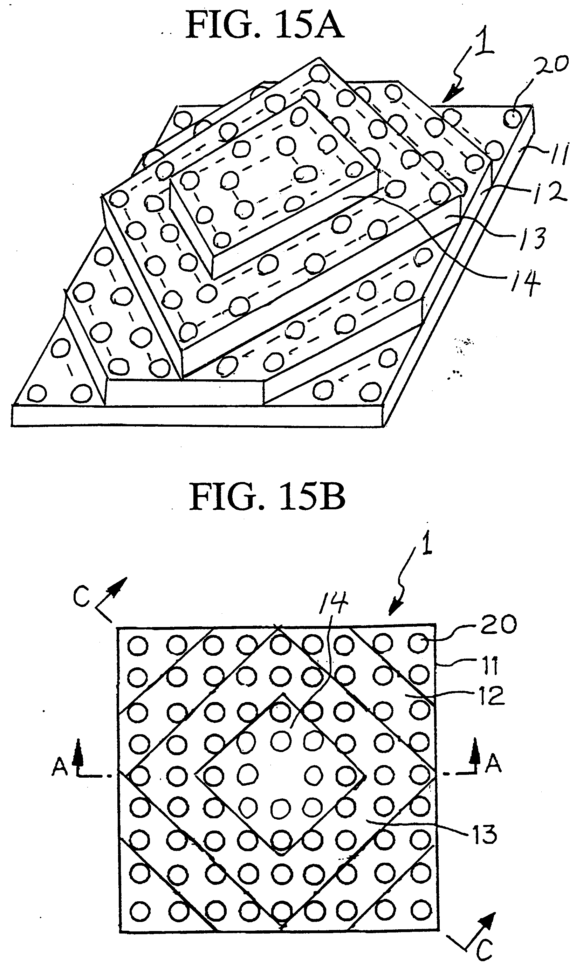

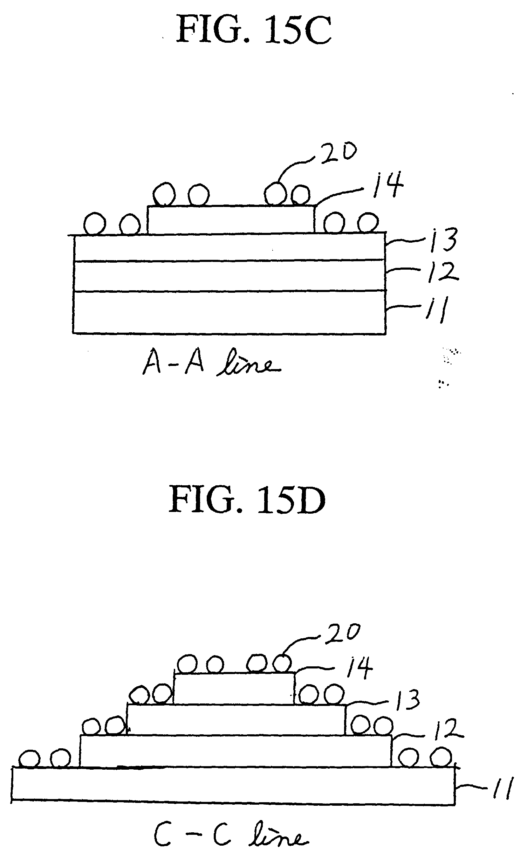

A tenth embodiment according to the present invention will be described in detail with reference to FIGS. 15A, 15B, 15C and 15D, wherein a novel surface mounting type semiconductor package with an improved mounting surface is provided. FIG. 15A is a schematic perspective view illustrative of a novel surface mounting type semiconductor package with an improved mounting surface in a tenth embodiment in accordance with the present invention. FIG. 15B is a schematic plane view illustrative of a novel surface mounting type semiconductor package with an improved mounting surface of FIG. 15A in a tenth embodiment in accordance with the present invention. FIG. 15C is a schematic cross sectional elevation view illustrative of a novel surface mounting type semiconductor package with an improved mounting surface taken along an A-A line of FIG. 15B in a tenth embodiment in accordance with the present invention. FIG. 15D is a schematic cross sectional elevation view illustrative of a novel surface mounting type semiconductor package with an improved mounting surface taken along a C-C line of FIG. 15B in a tenth embodiment in accordance with the present invention.

In this embodiment, the novel surface mounting type semiconductor package 1 has an improved mounting surface which has a 9 × 9 full grid array structure of solder balls. The improved mounting surface of the novel surface mounting type semiconductor package 1 comprises four different level stages and three steps bounding those four different level stages. The three steps of the improved mounting surface comprise four sets of first level steps in the form of a straight in plane view and second and third level steps which are square-shaped in larger and smaller sizes in a plane view. Four of the first level step extend between adjacent two sides of the square-shaped semiconductor package 1 in a straight form and in diagonal directions but perpendicular to the diagonal direction toward the individually closer comers of the square-shaped semiconductor package 1, so that the four first level steps define small right-angled isosceles triangle four-corner regions as a rust level stage. Each of the four straight-shaped first level steps has a single vertical wall which faces toward the closer one of the four comers of the square-shaped semiconductor package 1. The first level stage, therefore, comprises four sets of a small right-angled isosceles triangle four-corner region positioned at the four corners of the square-shaped semiconductor package 1, so that each of the four small right-angled isosceles triangle four-corner regions has three conductive pads closer to the corner of the square-shaped semiconductor package 1, for example, a corner-positioned conductive pad positioned at the corner of the square-shaped semiconductor package 1 and two secondly closer conductive pads which are second closer to the corner of the square-shaped semiconductor package 1 and also are adjacent to the corner-positioned conductive pad along the adjacent two sides including that corresponding corner of the square-shaped semiconductor package 1. The two secondly closer conductive pads on each of the small right-angled isosceles triangle four-corner regions of the first level stage are aligned in parallel to the each straight line of the first level step and in the diagonal direction but perpendicular to the remaining diagonal direction toward the closer corner of the square-shaped semiconductor package 1. The three conductive pads on each of the small right-angled isosceles triangle four-corner regions of the first level stage are connected through solder balls to first level interconnections which extend with keeping the first level in a straight form in the diagonal direction perpendicular to the straight line of the first step defining and bounding the each small right-angled isosceles triangle four-corner region. The two secondly closer conductive pads on each of the small right-angled isosceles triangle four-corner regions of the first level stage are aligned to be displaced from the corner-positioned conductive pad positioned outside of the two secondly closer conductive pads by a half pitch in the diagonal direction in parallel to the straight line of the first step, whereby the first level interconnections connected to the two secondly closer conductive pads on each of the small right-angled isosceles triangle four-corner regions of the first level stage extend through opposite sides of the corner-positioned conductive pad with keeping the first level.

The second level step comprises a single larger square which has the same center point as the square-shaped semiconductor package 1 but is rotated around the center point by 45 degrees, so that the four corners of the larger square of the second level step are positioned at individual intermediate points of the four sides of the square-shaped semiconductor package 1, whilst the four sides of the larger square of the second level step extend parallel to but inside of the straight lines of the first level steps. Each of the four sides of the larger square of the second level step extends between the intermediate points of the adjacent two sides of the square-shaped semiconductor package 1, wherein the adjacent two sides of the square-shaped semiconductor package 1 include the corner toward which a vertical wall of each of the four sides of the larger square of the second level step faces. The large square-shaped second level step defines four truncated triangle band regions as the second level stage. Each of the truncated triangle band regions of the second level stage extends between the adjacent two sides of the square-shaped semiconductor package 1 and also is defined between the straight line of the first level step and the one side of the larger square of the second level step. Each of the truncated triangle band regions of the second level stage has two alignments of conductive pads extending in the diagonal direction in parallel to the straight line of the first level step bounding the truncated triangle band region of the second level stage and also parallel to the one side of the larger square of the second level step bounding the truncated triangle band region of the second level stage. The two alignments of the conductive pads on each of the truncated triangle band regions of the second level stage comprise an outer alignment of three conductive pads extending along the straight line of the first level step and an inner alignment of four conductive pads extending along the one side of the larger square shaped second level step. The four conductive pads on the inner alignment of each of the truncated triangle band regions of the second level stage are aligned to be displaced from the three conductive pads on the outer alignment by a half pitch in the diagonal direction in parallel to the straight line of the first step and also in parallel to the defining side of the larger square shaped second level step, whereby second level interconnections connected to outside two of the four conductive pads on the inner alignment of each of the truncated triangle band regions of the second level stage extend through opposite outsides of the inner alignment of the three conductive pads with keeping the second level, whilst other second level interconnections connected to inside two of the four conductive pads on the inner alignment of each of the truncated triangle band regions of the second level stage extend through intermediate points between individual adjacent two of the three conductive pads on the inner alignment with keeping the second level.

The third level step comprises a single smaller square which has the same center point as the square-shaped semiconductor package 1 but is rotated around the center point by 45 degrees, so that the four corners of the smaller square of the third level step are directed toward individual intermediate points of the four sides of the square-shaped semiconductor package 1 but are positioned inside of the larger square of the second level step, whilst the four sides of the smaller square of the third level step extend parallel to but inside of the four sides of the larger square of the second level step. The smaller square of the third level step is encompassed by the larger square of the second level step. Each of the four sides of the smaller square of the third level step has the same length as the straight lines of the first level step. The smaller square-shaped third level step defines both a square-shaped frame band region as the third level stage comprising four straight bands extending in the diagonal directions of the square-shaped semiconductor package 1 and a square-shaped center region as the fourth level stage. The square-shaped frame band region as the third level stage is defined between the larger square shaped second level step and the smaller square shaped third level step. The square-shaped center region as the fourth level stage is surrounded by the square-shaped frame band region as the third level stage. The square-shaped frame band region of the third level stage has two square shaped alignments of conductive pads extending along the larger square shaped second level step and the smaller square shaped third level step. The dual square shaped alignments of conductive pads on the square-shaped frame band region of the third level stage comprise a large outer square of four alignments of sixteen conductive pads extending along the larger square shaped second level step and a small inner square of four alignments of twelve conductive pads extending along the smaller square shaped third level step. Namely, each side of the square-shaped frame band region of the third level stage has dual alignments of the conductive pads. The dual alignments of the conductive pads comprise an outer alignment of five conductive pads and an inner alignment of four conductive pads. The four conductive pads on the inner alignment of each side of the square-shaped frame band region of the third level stage are aligned to be displaced from the five conductive pads on the outer alignment by a half pitch in the diagonal direction in parallel to the defining sides of the larger square shaped second level step and the smaller square shaped third level step, whereby third level interconnections connected to the four conductive pads on the inner alignment extend through intermediate points between individual adjacent two of the five conductive pads on the outer alignment with keeping the third level. The square-shaped center region as the fourth level stage is defined by the smaller square shaped third level step. The square-shaped center region as the fourth level stage has two square shaped alignments of conductive pads extending along the smaller square shaped third level step. The dual square shaped alignments of conductive pads on the square-shaped center region of the fourth level stage comprise a large outer square of four alignments of eighth conductive pads extending along the smaller square shaped second level step and a small inner square cornered by four conductive pads. Namely, each side of the square-shaped center region of the fourth level stage has dual alignments of the conductive pads. The dual alignments of the conductive pads comprise an outer alignment of three conductive pads and an inner alignment of two conductive pads. The two conductive pads on the inner alignment of each side of the square-shaped center region of the fourth level stage are aligned to be displaced from the three conductive pads on the outer alignment by a half pitch in the diagonal direction in parallel to the defining sides of the smaller square shaped third level step, whereby fourth level interconnections connected to the two conductive pads on the inner alignment extend through intermediate points between individual adjacent two of the three conductive pads on the outer alignment with keeping the fourth level.

The above novel surface mounting type semiconductor package 1 may comprise laminations of first, second, third and fourth layers 11, 12, 13 and 14. The first layer 11 has a large size square shape. The second layer 12 has a four corner truncated large size square shape with four corner triangle-shaped recesses. The third layer 13 has an intermediate size square shape. The fourth layer 14 has a small size square shape. The size differences among the first, second, third and fourth layers 11, 12, 13 and 14 result in formation of the above first, second, third and fourth steps.

The first level, second level, third level, fourth level and fifth level stages form 9 × 9 full-grid arrays of the conductive pads, providing that no conductive pad is provided at the center point of the semiconductor package 1. Solder balls 20 are further provided on the 9 × 9 full-grid arrays of the conductive pads. Each of the first level conductive pads on the four small right-angled isosceles triangle four-corner regions as the first level stage of the first layer 11 is connected through the solder ball 20 to a corresponding first level interconnection which extends outwardly in a diagonal direction of the semiconductor package 1 with keeping the first level. Each of the conductive pads on the four truncated triangle band regions as the second level stage of the second layer 12 is connected through the solder ball 20 to a corresponding second level interconnection which extends outwardly in the diagonal direction of the semiconductor package 1 with keeping the second level. Each of the conductive pads on the square-shaped frame band region as the third level stage of the third layer 13 is connected through the solder ball 20 to a corresponding third level interconnection which extends outwardly in the diagonal direction of the semiconductor package 1 with keeping the third level. Each of the conductive pads on the square-shaped center region of the fourth level stage of the fourth layer 14 is connected through the solder ball 20 to a corresponding fourth level interconnection which extends outwardly in the diagonal direction of the semiconductor package 1 with keeping the fourth level.

The above described semiconductor package 1 is mounted onto a multilayer mounting substrate having a modified mounting surface which was modified in correspondence with the above mounting surface of the semiconductor package 1. The first level conductive pads on the first level stage of the first layer 11 of the semiconductor package 1 are electrically connected through the first level solder bumps 20 and the first level conductive pads of the multilayer mounting substrate to the first level interconnections which extend outwardly in the diagonal directions with keeping the first level and in straight lines without, however, leading through between adjacent two of the other conductive pads and without making any detour to avoid any obstacle such as other conductive pads. Further, the second level conductive pads on the second level stage of the second layer 12 of the semiconductor package 1 are electrically connected through the second level solder bumps 20 and the second level conductive pads of the multilayer mounting substrate to the second level interconnections which extend outwardly in the diagonal directions with keeping the second level and in straight lines without, however, leading through between adjacent two of the first level conductive pads which are positioned outside of the second level conductive pads and without making any detour to avoid any obstacle such as the first level conductive pads 44, for example, by use of any through hole. Furthermore, the third level conductive pads on the third level stage of the third layer 13 of the semiconductor package 1 are electrically connected through the third level solder bumps 20 and the third level conductive pads of the multilayer mounting substrate to the third level interconnections which extend outwardly in the diagonal directions with keeping the third level and in straight lines without, however, leading through between adjacent two of the first level or second level conductive pads which are positioned outside of the third level conductive pads and without making any detour to avoid any obstacle such as the first level or second level conductive pads, for example, by use of any through hole. Still more, the fourth level conductive pads on the fourth level stage of the fourth layer 14 of the semiconductor package 1 are electrically connected through the fourth level solder bumps 20 and the fourth level conductive pads of the multilayer mounting substrate to the fourth level interconnections which extend outwardly in the diagonal directions with keeping the fourth level and in straight lines without, however, leading through between adjacent two of the first level or second level or third level conductive pads which are positioned outside of the fourth level conductive pads and without making any detour to avoid any obstacle such as the first level or second level or third level conductive pads, for example, by use of any through hole.

The above improved level-varying mounting surface of the semiconductor package 1 allows the multi-level interconnections to lead of the mounting area of the multilayer mounting substrate in outward directions with keeping the individual levels. Namely, the above improved level-varying mounting surface of the semiconductor package 1 requires no vertical detour of the interconnections by providing the through holes nor horizontal detour thereof. This allows a further remarkable narrowing of the pitch or distance between the adjacent two of the interconnections. This allowance of the further remarkable narrowing of the pitch or distance between the adjacent two of the interconnections means it possible to further reduce remarkably the pitch or distance between the adjacent two of the conductive pads of the multi-layer mounting substrate. This further makes it possible to remarkably reduce the pitch or distance between the adjacent two of the solder balls of the semiconductor package 1. This means it possible to remarkably reduce the pitch or distance between the adjacent two of the conductive pads and the terminals of the semiconductor package 1. Therefore, the above improved mounting surface of the semiconductor package increases a freedom of allowing the multi-level interconnections to lead out of the mounting area of the multilayer mounting substrate to the outside region thereof. Namely, the above novel surface mounting type semiconductor package is free from a substantive limitation to the multi-level interconnections to lead out of the mounting area of the multilayer mounting substrate to the outside region thereof even the pitch between adjacent two of the terminals of the surface mounting type semiconductor package is reduced to the minimum pitch on design rule, thereby to increase the number of the terminals and also thereby to reduce the area of the mounting surface of the semiconductor package as well as to reduce the size in plane view of the semiconductor package.

In addition, without raising any problem with limitation to have the interconnections to lead out of the mounting area of the multilayer mounting substrate, the above improved level-varying mounting surface of the semiconductor package allows a possible increase in the number of the multiple squares of the alignments of the solder balls or the terminals of the semiconductor package by merely increase in the numbers of the steps and the different level stages of the mounting surface of the semiconductor package. For example, full grid arrays of the solder balls or the terminals of the semiconductor package can be realized without raising any problem with limitation to have the interconnections to lead out of the mounting area of the multilayer mounting substrate, thereby to furthermore reduce the area of the mounting surface of the semiconductor package as well as to furthermore reduce the size in plane view of the semiconductor package.

Whereas modifications of the present invention will be apparent to a person having ordinary skill in the art, to which the invention pertains, it is to be understood that embodiments as shown and described by way of illustrations are by no means intended to be considered in a limiting sense. Accordingly, it is to be intended to cover by claims all modifications which fall within the spirit and scope of the present invention.

## Claims

1. A semiconductor package including a semiconductor chip and having a mounting surface which is to be mounted onto a multilayer mounting substrate having multilevel interconnections,
characterized in that said mounting surface has at least a level-varying region which varies in level so that said level-varying region decreases in level toward an interconnection leading-out edge of said semiconductor package, where at least a part of said multilevel interconnections of said mounting substrate extends from a mounting region of said multilayer mounting substrate to an outside region bounded from said mounting region through said interconnection leading-out edge of said semiconductor package, and
characterized in that said level-varying region has a plurality of conductive pads to be connected to said at least a part of said multilevel interconnections so as to allow said at least a part of said multilevel interconnections to lead out of said mounting region to said outside region with keeping those individual levels respectively.

2. The semiconductor package as claimed in claim 1, characterized in that said level-varying region discontinuously varies in level so that said mounting surface includes at least a higher level region and at least a lower level region, and so that said at least a lower level region is positioned closer to an interconnection leading-out side of said semiconductor package than said higher level region, where said at least a part of said multilevel interconnections of said mounting substrate extends from said mounting region of said multilayer mounting substrate to said outside region through said interconnection leading-out-side of said semiconductor package, and
characterized in that said higher level region has a plurality of first conductive pads to be connected to first level interconnections of said multilevel interconnections and said lower region has a plurality of second conductive pads to be connected to second level interconnections of said multilevel interconnections so as to allow said first level and second level interconnections to lead out of said mounting region to said outside region with keeping those first and second levels respectively.

3. The semiconductor package as claimed in claim 2, characterized in that said level-varying region has at least a step which provides a boundary line bounding said higher level region and said lower level region, and said step has substantially vertical walls which face toward said interconnection leading-out-side of said semiconductor package.

4. The semiconductor package as claimed in claim 3, characterized in that said at least a step provides a boundary line surrounding an inner region so that said higher level region is positioned on an inner region of said semiconductor package whilst said lower level region is positioned on a peripheral region whereby said lower level region surrounds said higher level region.

5. The semiconductor package as claimed in claim 4, characterized in that each of said higher level and lower level regions has at least a single alignment of said conductive pads to surround said inner region.

6. The semiconductor package as claimed in claim 5, characterized in that each of said higher level and lower level regions has a set of inner and outer alignments of said conductive pads to surround said inner region, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

7. The semiconductor package as claimed in claim 4, characterized in that a plurality of said steps extend to provide multiple boundary lines co-surrounding said inner region so that a highest level region is positioned on said inner region of said semiconductor package whilst at least a intermediate level region is positioned to surround said highest level region and a lowest level region is positioned on a peripheral region to surround said at least an intermediate level region, and characterized in that each of said highest level, intermediate level and lowest level regions has at least a single alignment of said conductive pads to surround said inner region.

8. The semiconductor package as claimed in claim 7, characterized in that each of said higher level, intermediate level and lower level regions has a set of inner and outer alignments of said conductive pads to surround said inner region, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

9. The semiconductor package as claimed in claim 4, characterized in that said inner region surrounded by said boundary line provided by said at least a step is centrically positioned to a center of said semiconductor package.

10. The semiconductor package as claimed in claim 4, characterized in that said inner region surrounded by said boundary line provided by said at least a step is eccentrically positioned from a center of said semiconductor package.

11. The semiconductor package as claimed in claim 4, characterized in that said inner region surrounded by said boundary line provided by said at least a step is square-shaped.

12. The semiconductor package as claimed in claim 11, characterized in that said boundary line provided by said at least a step surrounds said inner region omnidirectionally so that said higher level region is positioned on said inner region of said semiconductor package whilst said lower level region is positioned on a peripheral region whereby said lower level region surrounds said higher level region omnidirectionally.

13. The semiconductor package as claimed in claim 11, characterized in that said boundary line provided by said at least a step surrounds said inner region three-directionally so that said higher level region is positioned on said inner region of said semiconductor package whilst said lower level region is positioned on a peripheral region except along one side of said semiconductor package whereby said lower level region surrounds said higher level region three-directionally

14. The semiconductor package as claimed in claim 2, characterized in that said mounting surface has at least two steps which provide at least two straight boundary lines bounding at least one of said higher level region and at least two of said lower level region, and each of said two step has a substantially vertical wall which faces toward opposite two sides of said semiconductor package, so that said at least two of said lower level region are respectively adjacent to said opposite two sides of said semiconductor package and said at least one of said higher level region is sandwiched between said at least two of said lower level region.

15. The semiconductor package as claimed in claim 2, characterized in that said mounting surface has at least a slope which provides a boundary region between said higher level region and said lower level region, and said slope has a substantially vertical wall which face toward said interconnection leading-out-side of said semiconductor package.

16. The semiconductor package as claimed in claim 15, characterized in that said at least a slope provides a boundary region surrounding an inner region so that said higher level region is positioned on an inner region of said semiconductor package whilst said lower level region is positioned on a peripheral region whereby said lower level region surrounds said higher level region.

17. The semiconductor package as claimed in claim 16, characterized in that each of said higher level and lower level regions has at least a single alignment of said conductive pads to surround said inner region.

18. The semiconductor package as claimed in claim 17, characterized in that each of said higher level and lower level regions has a set of inner and outer alignments of said conductive pads to surround said inner region, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

19. The semiconductor package as claimed in claim 16, characterized in that a plurality of said slopes extend to provide multiple boundary regions co-surrounding said inner region so that a highest level region is positioned on said inner region of said semiconductor package whilst at least an intermediate level region is positioned to surround said highest level region and a lowest level region is positioned on a peripheral region to surround said at least an intermediate level region, and characterized in that each of said highest level, intermediate level and lowest level regions has at least a single alignment of said conductive pads to surround said inner region.

20. The semiconductor package as claimed in claim 19, characterized in that each of said higher level, intermediate level and lower level regions has a set of inner and outer alignments of said conductive pads to surround said inner region, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

21. The semiconductor package as claimed in claim 16, characterized in that said inner region surrounded by said boundary region provided by said at least a slope is centrically positioned to a center of said semiconductor package.

22. The semiconductor package as claimed in claim 16, characterized in that said inner region surrounded by said boundary region provided by said at least a slope is eccentrically positioned from a center of said semiconductor package.

23. The semiconductor package as claimed in claim 16, characterized in that said inner region surrounded by said boundary region provided by said at least a slope is square-shaped.

24. The semiconductor package as claimed in claim 23, characterized in that said boundary region provided by said at least a slope surrounds said inner region omnidirectionally so that said higher level region is positioned on said inner region of said semiconductor package whilst said lower level region is positioned on a peripheral region whereby said lower level region surrounds said higher level region omnidirectionally.

25. The semiconductor package as claimed in claim 24, characterized in that said boundary region provided by said at least a slope surrounds said inner region three-directionally so that said higher level region is positioned on said inner region of said semiconductor package whilst said lower level region is positioned on a peripheral region except along one side of said semiconductor package whereby said lower level region surrounds said higher level region three-directionally.

26. The semiconductor package as claimed in claim 15, characterized in that said mounting surface has at least two slopes which provide at least two straight boundary regions bounding at least one of said higher level region and at least two of said lower level region, and each of said two slope has a substantially vertical wall which faces toward opposite two sides of said semiconductor package, so that said at least two of said lower level region are respectively adjacent to said opposite two sides of said semiconductor package and said at least one of said higher level region is sandwiched between said at least two of said lower level region.

27. The semiconductor package as claimed in claim 1, characterized in that said level-varying region discontinuously varies in level so that said mounting surface includes at least a higher level region and at least a lower level region, and so that said at least a lower level region is positioned closer to a corner of said semiconductor package than said higher level region, where said at least a part of said multilevel interconnections of said mounting substrate extends from said mounting region of said multilayer mounting substrate to said outside region through a region in the vicinity of said corner of said semiconductor package, and
characterized in that said higher level region has a plurality of first conductive pads to be connected to first level interconnections of said multilevel interconnections and said lower region has a plurality of second conductive pads to be connected to second level interconnections of said multilevel interconnections so as to allow said first level and second level interconnections to lead out of said mounting region to said outside region with keeping those first and second levels respectively.

28. The semiconductor package as claimed in claim 27, characterized in that said level-varying region has at least a step which provides a L-shaped boundary line bounding said higher level region and said lower level region, and characterized in that said L-shaped boundary line surrounds a corner region adjacent to said corner so that said lower level region is positioned on said corner region, and said step has substantially vertical walls which face toward adjacent two sides sandwiching said corner of said semiconductor package.

29. The semiconductor package as claimed in claim 28, characterized in that said level-varying region has four sets of at least a step which provide four sets of at least a L-shaped boundary line bounding said higher level region and four lower level regions, and characterized in that said four L-shaped boundary lines surround four corner regions adjacent to four corners respectively so that said four lower level regions are positioned on said four corner regions respectively, and each of said four steps has substantially vertical walls which face toward adjacent two sides sandwiching corresponding one of said four corners of said semiconductor package.

30. The semiconductor package as claimed in claim 29, characterized in that said level-varying region has four sets of plural steps which provide four sets of multiple L-shaped boundary lines bounding a highest level region, four sets of at least an intermediate level region and four sets of a lowest level region respectively, and characterized in that each set of said multiple L-shaped boundary lines co-surround each of said four corner regions so that said four lowest level regions are positioned on said four corner regions respectively, and each of said at least an intermediate level region surrounds corresponding one of said four lowest level regions in two directions perpendicular to each other, and said highest level region surround each of said four sets of said at least an intermediate level region in said two directions, and characterized in that each of said steps has substantially vertical walls which face toward adjacent two sides sandwiching corresponding one of said four corners of said semiconductor package.

31. The semiconductor package as claimed in claim 30, characterized in that each of said at least an intermediate level region has at least a single alignment of said conductive pads to surround said lowest level region in said two directions perpendicular to each other.

32. The semiconductor package as claimed in claim 31, characterized in that each of said at least an intermediate level region has a set of inner and outer alignments of said conductive pads to co-surround said lowest level region in said two directions perpendicular to each other, where said outer alignment is positioned closer to said lowest level region than said inner alignment, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

33. The semiconductor package as claimed in claim 27, characterized in that said level-varying region has at least a step which provides a straight boundary line bounding said higher level region and said lower level region, and characterized in that said straight boundary line extends between two sides sandwiching said corner, and said straight boundary line bounds a corner region adjacent to said corner in a diagonal direction of said semiconductor package so that said lower level region is positioned on said corner region, and said step has a substantially vertical wall which faces toward said corner of said semiconductor package.

34. The semiconductor package as claimed in claim 33, characterized in that said level-varying region has four sets of at least a step which provide four sets of at least a straight boundary line bounding said higher level region and four lower level regions, and characterized in that said four straight boundary lines bound in said diagonal directions four corner regions adjacent to four corners respectively, so that said four lower level regions are positioned on said four corner regions respectively, and each of said four steps has a substantially vertical wall which faces toward corresponding one of said four corners of said semiconductor package.

35. The semiconductor package as claimed in claim 34, characterized in that said level-varying region has four sets of plural steps which provide four sets of multiple straight boundary lines bounding a highest level region, four sets of at least an intermediate level region and four sets of a lowest level region respectively, and characterized in that each set of said multiple straight boundary lines multiple-bound each of said four corner regions, so that said four lowest level regions are positioned on said four corner regions respectively, and each of said at least an intermediate level region bounds said highest level region and each of said four lowest level regions in said diagonal directions of said semiconductor package, and characterized in that each of said steps has a substantially vertical wall which faces toward corresponding one of said four corners of said semiconductor package.

36. The semiconductor package as claimed in claim 35, characterized in that each of said at least an intermediate level region has at least a single alignment of said conductive pads to bound said lowest level region in said diagonal direction.

37. The semiconductor package as claimed in claim 36, characterized in that each of said at least an intermediate level region has a set of inner and outer alignments of said conductive pads to co-bound said lowest level region in said diagonal direction, where said outer alignment is positioned closer to said lowest level region than said inner alignment, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

38. The semiconductor package as claimed in claim 27, characterized in that said level-varying region has at least a slope which provides a L-shaped boundary region bounding said higher level region and said lower level region, and characterized in that said L-shaped boundary region surrounds a corner region adjacent to said corner so that said lower level region is positioned on said corner region, and said slope faces toward adjacent two sides sandwiching said corner of said semiconductor package.

39. The semiconductor package as claimed in claim 38, characterized in that said level-varying region has four sets of at least a slope which provide four sets of at least a L-shaped boundary region bounding said higher level region and four lower level regions, and characterized in that said four L-shaped boundary regions surround four corner regions adjacent to four corners respectively so that said four lower level regions are positioned on said four corner regions respectively, and each of said four slopes has substantially vertical walls which face toward adjacent two sides sandwiching corresponding one of said four corners of said semiconductor package.

40. The semiconductor package as claimed in claim 39, characterized in that said level-varying region has four sets of plural slopes which provide four sets of multiple L-shaped boundary regions bounding a highest level region, four sets of at least an intermediate level region and four sets of a lowest level region respectively, and characterized in that each set of said multiple L-shaped boundary regions co-surround each of said four corner regions so that said four lowest level regions are positioned on said four corner regions respectively, and each of said at least an intermediate level region surrounds corresponding one of said four lowest level regions in two directions perpendicular to each other, and said highest level region surround each of said four sets of said at least an intermediate level region in said two directions, and characterized in that said slopes has substantially vertical walls which face toward adjacent two sides sandwiching corresponding one of said four corners of said semiconductor package.

41. The semiconductor package as claimed in claim 40, characterized in that each of said at least an intermediate level region has at least a single alignment of said conductive pads to surround said lowest level region in said two directions perpendicular to each other.

42. The semiconductor package as claimed in claim 41, characterized in that each of said at least an intermediate level region has a set of inner and outer alignments of said conductive pads to co-surround said lowest level region in said two directions perpendicular to each other, where said outer alignment is positioned closer to said lowest level region than said inner alignment, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

43. The semiconductor package as claimed in claim 27, characterized in that said level-varying region has at least a slope which provides a straight boundary region bounding said higher level region and said lower level region, and characterized in that said straight boundary region extends between two sides sandwiching said corner, and said straight boundary region bounds a corner region adjacent to said corner in a diagonal direction of said semiconductor package so that said lower level region is positioned on said corner region, and said slope faces toward said corner of said semiconductor package.

44. The semiconductor package as claimed in claim 43, characterized in that said level-varying region has four sets of at least a slope which provide four sets of at least a straight boundary region bounding said higher level region and four lower level regions, and characterized in that said four straight boundary regions bound in said diagonal directions four corner regions adjacent to four corners respectively, so that said four lower level regions are positioned on said four corner regions respectively, and each of said four slopes has a substantially vertical wall which faces toward corresponding one of said four corners of said semiconductor package.

45. The semiconductor package as claimed in claim 44, characterized in that said level-varying region has four sets of plural slopes which provide four sets of multiple straight boundary regions bounding a highest level region, four sets of at least an intermediate level region and four sets of a lowest level region respectively, and characterized in that each set of said multiple straight boundary regions multiple-bound each of said four corner regions, so that said four lowest level regions are positioned on said four corner regions respectively, and each of said at least an intermediate level region bounds said highest level region and each of said four lowest level regions in said diagonal directions of said semiconductor package, and characterized in that each of said slopes has a substantially vertical wall which faces toward corresponding one of said four corners of said semiconductor package.

46. The semiconductor package as claimed in claim 45, characterized in that each of said at least an intermediate level region has at least a single alignment of said conductive pads to bound said lowest level region in said diagonal direction.

47. The semiconductor package as claimed in claim 46, characterized in that each of said at least an intermediate level region has a set of inner and outer alignments of said conductive pads to co-bound said lowest level region in said diagonal direction, where said outer alignment is positioned closer to said lowest level region than said inner alignment, provided that said conductive pads on said inner alignment are positioned to be displaced from said conductive pads on said outer alignment so that each of said interconnections connected to said conductive pads on said inner alignment is permitted to lead through between adjacent two of said conductive pads on said outer alignment.

48. The semiconductor package as claimed in claim 1, characterized in that said level-varying region continuously varies in level so that said level-varying region comprises a sloped region decreasing in level toward an interconnection leading-out side of said semiconductor package, where at least a part of said multilevel interconnections of said mounting substrate extends from a mounting region of said multilayer mounting substrate to an outside region bounded from said mounting region through said interconnection leading-out side of said semiconductor package, and
characterized in that said sloped region has a plurality of conductive pads at plural different levels on said sloped region, and said conductive pads are to be connected to said at least a part of said multilevel interconnections, so as to allow said at least a part of said multilevel interconnections to lead out of said mounting region to said outside region with keeping those individual levels respectively.

49. The semiconductor package as claimed in claim 48, characterized in that said level-varying region comprises four sloped regions decreasing in level toward four sides of said semiconductor package, where said multilevel interconnections of said mounting substrate extend from said mounting region of said multilayer mounting substrate to said outside region surrounding said mounting region through said four sides of said semiconductor package.

50. The semiconductor package as claimed in claim 49, characterized in that each of said four sloped regions has a plurality of alignments of said conductive pads which extend in parallel to each of said four sides of said semiconductor package so that said plurality of alignments are different in level from each other, as to allow said at least a part of said multilevel interconnections to lead out of said mounting region to said outside region with keeping those individual levels respectively.

51. The semiconductor package as claimed in claim 1, characterized in that said level-varying region continuously varies in level so that said level-varying region comprises a sloped region decreasing in level toward an interconnection leading-out corner of said semiconductor package, where at least a part of said multilevel interconnections of said mounting substrate extends from a mounting region of said multilayer mounting substrate to an outside region bounded from said mounting region through a region in the vicinity of said interconnection leading-out corner of said semiconductor package, and
characterized in that said sloped region has a plurality of conductive pads at plural different levels on said sloped region, and said conductive pads are to be connected to said at least a part of said multilevel interconnections, so as to allow said at least a part of said multilevel interconnections to lead out of said mounting region to said outside region with keeping those individual levels respectively.

52. The semiconductor package as claimed in claim 51, characterized in that said level-varying region comprises four sloped regions decreasing in level toward four corners of said semiconductor package, where said multilevel interconnections of said mounting substrate extend from said mounting region of said multilayer mounting substrate to said outside region surrounding said mounting region through said four corners of said semiconductor package.

53. The semiconductor package as claimed in claim 52, characterized in that each of said four sloped regions has a plurality of alignments of said conductive pads which extend in parallel to diagonal directions of said semiconductor package so that said plurality of alignments are different in level from each other, as to allow said multilevel interconnections to lead out of said mounting region to said outside region with keeping those individual levels respectively.
